# EUROPEAN PATENT APPLICATION

(11) **EP 4 404 275 A1**
(43) Date of publication of application: **24.07.2024**
(21) Application number: 22869491.5
(22) Date of filing: 02.09.2022
(51) Int. Cl.: H01L 29/786, H10B 12/00

(54) **SEMICONDUCTOR DEVICE AND STORAGE DEVICE**

(30) Priority: 17.09.2021 JP 2021151971
(71) Applicant: Semiconductor Energy Laboratory Co., Ltd., Atsugi-shi, Kanagawa 243-0036 (JP)
(72) Inventor: MIYAIRI, Hidekazu, Atsugi-shi, Kanagawa 243-0036 (JP); NAKASHIMA, Motoki, Atsugi-shi, Kanagawa 243-0036 (JP)
(74) Representative: Grünecker Patent- und Rechtsanwälte PartG mbB
(86) International application number: PCT/IB2022/058239
(87) International publication number: WO 2023/042022

(57) **Abstract**

A semiconductor device that can be miniaturized or highly integrated is provided. The semiconductor device includes a first conductor, a metal oxide over the first conductor, a second conductor over the metal oxide, a first insulator, a second insulator over the first insulator, and a third conductor over the second insulator. The first conductor includes a region overlapping with the metal oxide. The metal oxide has a first opening. The second conductor has a second opening. The first opening and the second opening overlap with each other. The first insulator is placed on the inner side of each of the first opening and the second opening. The second insulator is placed in a depressed portion of the first insulator. The third conductor is placed in a depressed portion of the second insulator.

## Description

### Technical Field

One embodiment of the present invention relates to a transistor, a semiconductor device, a storage device, and an electronic device. Another embodiment of the present invention relates to a method for manufacturing a transistor and a method for manufacturing a semiconductor device. Another embodiment of the present invention relates to a semiconductor wafer and a module.

In this specification and the like, a semiconductor device generally means a device that can function by utilizing semiconductor characteristics. A semiconductor element such as a transistor, a semiconductor circuit, an arithmetic device, and a storage device are each an embodiment of a semiconductor device. It can be sometimes said that a display device (a liquid crystal display device, a light-emitting display device, and the like), a projection device, a lighting device, an electro-optical device, a power storage device, a storage device, a semiconductor circuit, an imaging device, an electronic device, and the like include a semiconductor device.

Note that one embodiment of the present invention is not limited to the above technical field. One embodiment of the invention disclosed in this specification and the like relates to an object, a method, or a manufacturing method. One embodiment of the present invention relates to a process, a machine, manufacture, or a composition of matter.

### Background Art

A typical example of a widely used memory device is DRAM (dynamic random access memory), which is composed of one capacitor and one transistor (also referred to as a cell transistor).

Along with the progress of higher integration of memory devices, a reduction in the area occupied by memory has been required. However, miniaturization of memory devices using Si transistors has been becoming difficult in terms of techniques and costs.

In recent years, oxide semiconductors have been attracting attention as a semiconductor material that enables the manufacture of transistors in a BEOL (Back end of line) process for forming wirings in a semiconductor device. A technique for forming an OS transistor (transistor including a metal oxide in a channel formation region) directly above a conventional Si transistor (transistor including silicon in a channel formation region) (this technique is also referred to as a BEOL-Tr technology) enables construction of a 3D functional circuit without deviation from a design rule. Thus, this technique is expected as a technique achieving a high-performance memory device with low power consumption and low cost.

Moreover, if vertical OS transistors can be formed, the minimum design rule can be reduced from 6F² (F is a minimum feature size) to 4F². For example, Patent Document 1 discloses a vertical transistor in which a side surface of an oxide semiconductor is covered with a word line with a gate insulating layer therebetween.

### [Reference]

### [Patent Document]

[Patent Document 1] Japanese Published Patent Application No. 2021-108331

### Summary of the Invention

### Problems to be Solved by the Invention

An object of one embodiment of the present invention is to provide a transistor that can be miniaturized or highly integrated. Another object is to provide a transistor with favorable electrical characteristics. Another object is to provide a transistor with a small variation in electrical characteristics. Another object is to provide a transistor with high on-state current. Another object is to provide a transistor with high reliability. Another object is to provide a novel transistor. Another object is to provide a semiconductor device including the transistor. Another object is to provide a semiconductor device with low power consumption.

Note that the description of these objects does not preclude the existence of other objects. Note that one embodiment of the present invention does not have to achieve all the obj ects. Other objects will be apparent from the description of the specification, the drawings, the claims, and the like, and other objects can be derived from the description of the specification, the drawings, the claims, and the like.

### Means for Solving the Problems

One embodiment of the present invention is a transistor including a first conductor, a metal oxide over the first conductor, a second conductor over the metal oxide, a first insulator, a second insulator over the first insulator, and a third conductor over the second insulator. The first conductor includes a region overlapping with the metal oxide. The metal oxide has a first opening. The second conductor has a second opening. The first opening and the second opening overlap with each other. The first insulator is placed on an inner side of each of the first opening and the second opening. The second insulator is placed in a depressed portion of the first insulator. The third conductor is placed in a depressed portion of the second insulator.

In the above transistor, the metal oxide and the second conductor each preferably have a hollow cylindrical shape.

In a top view of the transistor, it is preferable that a center of the first conductor not be aligned with a center of the hollow cylindrical shape of the metal oxide.

In a cross-sectional view of the transistor, a side surface on the first opening side and a side surface on the second opening side each preferably have a tapered shape.

In the transistor, an uppermost portion of the second insulator is preferably level or substantially level with an uppermost portion of the first insulator.

In the transistor, the first insulator preferably includes a region having a smaller thickness than the second insulator.

Another embodiment of the present invention is a storage device including the transistor and a capacitor. The transistor is provided above the capacitor.

Another embodiment of the present invention is a semiconductor device including a first insulator, a first conductor placed to be embedded in the first insulator, a metal oxide over the first conductor, a second conductor over the metal oxide, a third conductor over the second conductor, a second insulator, a third insulator over the second insulator, a fourth conductor over the third insulator, and a fifth conductor over the fourth conductor. The first conductor includes a region overlapping with the metal oxide. The metal oxide has a first opening. The second conductor has a second opening. The first opening and the second opening overlap with each other. The second insulator is placed on an inner side of each of the first opening and the second opening. The third insulator is placed in a depressed portion of the second insulator. The fourth conductor is placed in a depressed portion of the third insulator. The third conductor is placed in contact with at least part of a top surface of the second conductor. The fifth conductor is placed in contact with a top surface of the fourth conductor. In a top view of the semiconductor device, the third conductor and the fifth conductor do not overlap with each other.

In the semiconductor device, it is preferable that a fourth insulator be provided between the second insulator and the third insulator and the fifth conductor, the fourth insulator include a region in contact with a bottom surface of the fifth conductor, and a top surface of the third conductor be placed between a bottom surface and a top surface of the fourth insulator.

In the semiconductor device, the metal oxide and the second conductor each preferably have a hollow cylindrical shape.

In a top view of the semiconductor device, it is preferable that a center of the first conductor not be aligned with a center of the hollow cylindrical shape of the metal oxide.

In a cross-sectional view of the semiconductor device, a side surface on the first opening side and a side surface on the second opening side each preferably have a tapered shape.

In the semiconductor device, an uppermost portion of the third insulator is preferably level or substantially level with an uppermost portion of the second insulator.

In the semiconductor device, the second insulator preferably includes a region having a smaller thickness than the third insulator.

In the semiconductor device, a direction in which the fifth conductor extends is preferably orthogonal to a direction in which the third conductor extends.

Another embodiment of the present invention is a storage device including the above semiconductor device and a capacitor. The semiconductor device is provided above the capacitor.

### Effect of the Invention

According to one embodiment of the present invention, a transistor that can be miniaturized or highly integrated can be provided. Alternatively, a transistor having favorable electrical characteristics can be provided. Alternatively, a transistor with a small variation in electrical characteristics can be manufactured. Alternatively, a transistor with high on-state current can be provided. Alternatively, a transistor with high reliability can be provided. Alternatively, a novel transistor can be provided. Alternatively, a semiconductor device including the transistor can be provided. Alternatively, a semiconductor device with low power consumption can be provided.

Note that the description of these effects does not preclude the existence of other effects. One embodiment of the present invention does not have to have all these effects. Other effects will be apparent from the description of the specification, the drawings, the claims, and the like, and other effects can be derived from the description of the specification, the drawings, the claims, and the like.

### Brief Description of the Drawings

FIG. 1A is a schematic top view illustrating a structure example of a semiconductor device. FIG. 1B and FIG. 1C are cross-sectional perspective views illustrating a structure example of a transistor.
FIG. 2A and FIG. 2B are cross-sectional perspective views each illustrating a structure example of a transistor;
FIG. 3A to FIG. 3E are schematic top views each illustrating a structure example of a semiconductor device.
FIG. 4A to FIG. 4C are cross-sectional perspective views each illustrating a structure example of a transistor.
FIG. 5A and FIG. 5D are top views illustrating structure examples of a semiconductor device.
FIG. 5B, FIG. 5C, and FIG. 5E are cross-sectional views illustrating structure examples of a semiconductor device.
FIG. 6A to FIG. 6C are cross-sectional views illustrating structure examples of a semiconductor device.
FIG. 7A and FIG. 7B are cross-sectional views each illustrating a structure example of a semiconductor device.
FIG. 8A and FIG. 8C are top views illustrating an example of a method for manufacturing a semiconductor device. FIG. 8B and FIG. 8D are cross-sectional views illustrating an example of a method for manufacturing a semiconductor device.
FIG. 9A and FIG. 9C are top views illustrating an example of a method for manufacturing a semiconductor device. FIG. 9B and FIG. 9D are cross-sectional views illustrating an example of a method for manufacturing a semiconductor device.
FIG. 10A and FIG. 10C are top views illustrating an example of a method for manufacturing a semiconductor device. FIG. 10B and FIG. 10D are cross-sectional views illustrating an example of a method for manufacturing a semiconductor device.
FIG. 11A and FIG. 11C are top views illustrating an example of a method for manufacturing a semiconductor device. FIG. 11B and FIG. 11D are cross-sectional views illustrating an example of a method for manufacturing a semiconductor device.
FIG. 12A is a top view illustrating an example of a method for manufacturing a semiconductor device. FIG. 12B1 and FIG. 12B2 are cross-sectional views illustrating an example of a method for manufacturing a semiconductor device.
FIG. 13A and FIG. 13C are top views illustrating an example of a method for manufacturing a semiconductor device. FIG. 13B and FIG. 13D are cross-sectional views illustrating an example of a method for manufacturing a semiconductor device.
FIG. 14A and FIG. 14C are top views illustrating an example of a method for manufacturing a semiconductor device. FIG. 14B and FIG. 14D are cross-sectional views illustrating an example of a method for manufacturing a semiconductor device.
FIG. 15A and FIG. 15C are top views illustrating an example of a method for manufacturing a semiconductor device. FIG. 15B and FIG. 15D are cross-sectional views illustrating an example of a method for manufacturing a semiconductor device.
FIG. 16A is a top view illustrating an example of a method for manufacturing a semiconductor device. FIG. 16B is a cross-sectional view illustrating an example of a method for manufacturing a semiconductor device.
FIG. 17A is a cross-sectional view illustrating a structure example of a storage device. FIG. 17B to FIG. 17D are cross-sectional views each illustrating a structure example of a capacitor.
FIG. 18A to FIG. 18E are cross-sectional views each illustrating a structure example of a capacitor.
FIG. 19A is a block diagram illustrating a structure example of a storage device. FIG. 19B is a perspective view illustrating a structure example of a storage device.
FIG. 20A is a circuit diagram illustrating a structure example of a memory cell. FIG. 20B and
FIG. 20C are perspective views illustrating a structure example of a storage device.
FIG. 21 is a cross-sectional view illustrating a structure example of a storage device.
FIG. 22A is a circuit diagram illustrating a configuration example of a semiconductor device.
FIG. 22B is a perspective view illustrating a structure example of a semiconductor device.
FIG. 23A to FIG. 23E are diagrams illustrating examples of storage devices.
FIG. 24A to FIG. 24G are diagrams illustrating examples of electronic devices.
FIG. 25 is a cross-sectional view illustrating a structure example of a storage device.

### Mode for Carrying Out the Invention

Embodiments are described below with reference to the drawings. Note that the embodiments can be implemented with many different modes, and it is readily understood by those skilled in the art that modes and details thereof can be changed in various ways without departing from the spirit and scope thereof. Thus, the present invention should not be interpreted as being limited to the description of the embodiments below.

In addition, in the drawings, the size, the layer thickness, or the region is exaggerated for clarity in some cases. Therefore, the size, the layer thickness, or the region is not limited to the illustrated scale. Note that the drawings schematically illustrate ideal examples, and embodiments of the present invention are not limited to shapes, values, and the like shown in the drawings. For example, in the actual manufacturing process, a layer, a resist mask, or the like might be unintentionally reduced in size by treatment such as etching, which might not be reflected in the drawings for easy understanding. Furthermore, in the drawings, the same reference numerals are used in common for the same portions or portions having similar functions in different drawings, and repeated description thereof is omitted in some cases. The same hatching pattern is applied to portions having similar functions, and the portions are not especially denoted by reference numerals in some cases.

Furthermore, especially in a top view (also referred to as a "plan view"), a perspective view, or the like, the description of some components might be omitted for easy understanding of the invention. In addition, some hidden lines and the like might not be illustrated.

The ordinal numbers such as "first" and "second" in this specification and the like are used for convenience and do not denote the order of steps or the stacking order of layers. Therefore, for example, the term "first" can be replaced with the term "second", "third", or the like as appropriate. In addition, the ordinal numbers in this specification and the like do not sometimes correspond to the ordinal numbers that are used to specify one embodiment of the present invention.

Moreover, in this specification and the like, terms for describing arrangement, such as "over" and "under", are used for convenience for describing the positional relationship between components with reference to drawings. The positional relation between components is changed as appropriate in accordance with the direction in which the components are described. Thus, without limitation to terms described in this specification, the description can be changed appropriately depending on the situation.

When this specification and the like explicitly state that *X* and *Y* are connected, for example, the case where *X* and *Y* are electrically connected, the case where *X* and *Y* are functionally connected, and the case where *X* and *Y* are directly connected are regarded as being disclosed in this specification and the like. Accordingly, without being limited to a predetermined connection relationship, for example, a connection relationship shown in drawings or texts, a connection relationship other than one shown in drawings or texts is regarded as being disclosed in the drawings or the texts. Here, *X* and *Y* each denote an object (e.g., a device, an element, a circuit, a wiring, an electrode, a terminal, a conductive film, or a layer).

In this specification and the like, a transistor is an element having at least three terminals including a gate, a drain, and a source. In addition, the transistor includes a region where a channel is formed (hereinafter, also referred to as a channel formation region) between the drain (a drain terminal, a drain region, or a drain electrode) and the source (a source terminal, a source region, or a source electrode), and current can flow between the source and the drain through the channel formation region. Note that in this specification and the like, a channel formation region refers to a region through which a current mainly flows.

Furthermore, functions of a source and a drain are sometimes interchanged with each other when transistors having different polarities are used or when the direction of current is changed in circuit operation, for example. Therefore, the terms "source" and "drain" can sometimes be interchanged with each other in this specification and the like.

An impurity in a semiconductor refers to, for example, an element other than the main components of a semiconductor layer. For example, an element with a concentration lower than 0.1 atomic% can be regarded as an impurity. When an impurity is contained, for example, the density of defect states in a semiconductor increases and the crystallinity decreases in some cases. In the case where the semiconductor is an oxide semiconductor, examples of an impurity which changes the characteristics of the semiconductor include Group 1 elements, Group 2 elements, Group 13 elements, Group 14 elements, Group 15 elements, and transition metals other than the main components of the oxide semiconductor; hydrogen, lithium, sodium, silicon, boron, phosphorus, carbon, and nitrogen are given as examples. Note that water also serves as an impurity in some cases. In addition, oxygen vacancies (also referred to as V_{O}) are formed in an oxide semiconductor in some cases by entry of impurities, for example.

Note that in this specification and the like, silicon oxynitride is a material that contains more oxygen than nitrogen in its composition. Moreover, silicon nitride oxide is a material that contains more nitrogen than oxygen in its composition. Similarly, aluminum oxynitride refers to a material that contains more oxygen than nitrogen in its composition. Moreover, aluminum nitride oxide refers to a material that contains more nitrogen than oxygen in its composition. Similarly, hafnium oxynitride refers to a material that contains more oxygen than nitrogen in its composition. Moreover, a hafnium nitride oxide is a material that contains more nitrogen than oxygen in its composition.

In this specification and the like, the term "insulator" can be replaced with an insulating film or an insulating layer. Furthermore, the term "conductor" can be replaced with a conductive film or a conductive layer. Moreover, the term "semiconductor" can be replaced with a semiconductor film or a semiconductor layer.

In this specification and the like, "parallel" indicates a state where two straight lines are placed at an angle greater than or equal to -10° and less than or equal to 10°. Accordingly, the case where the angle is greater than or equal to -5° and less than or equal to 5° is also included. Furthermore, "substantially parallel" indicates a state where two straight lines are placed at an angle greater than or equal to -30° and less than or equal to 30°. Moreover, "perpendicular" indicates a state where two straight lines are placed at an angle greater than or equal to 80° and less than or equal to 100°. Accordingly, the case where the angle is greater than or equal to 85° and less than or equal to 95° is also included. Furthermore, "substantially perpendicular" indicates a state where two straight lines are placed at an angle greater than or equal to 60° and less than or equal to 120°.

In this specification and the like, a metal oxide is an oxide of metal in a broad sense. Metal oxides are classified into an oxide insulator, an oxide conductor (including a transparent oxide conductor), an oxide semiconductor (also simply referred to as an OS), and the like. For example, in the case where a metal oxide is used in a semiconductor layer of a transistor, the metal oxide is referred to as an oxide semiconductor in some cases. That is, an OS transistor can also be referred to as a transistor including a metal oxide or an oxide semiconductor.

In this specification and the like, "normally off" means that a drain current per micrometer of channel width flowing through a transistor when no potential is applied to a gate or the gate is supplied with a ground potential is 1 × 10⁻²⁰ A or lower at room temperature, 1 × 10⁻¹⁸ A or lower at 85 °C, or 1 × 10⁻¹⁶ A or lower at 125 °C.

In this specification and the like, "voltage" and "potential" can be replaced with each other as appropriate. "Voltage" refers to a potential difference from a reference potential, and when the reference potential is a ground potential, for example, "voltage" can be replaced with "potential". Note that the ground potential does not necessarily mean 0 V. Moreover, potentials are relative values, and a potential supplied to a wiring, a potential applied to a circuit or the like, and a potential output from a circuit or the like, for example, change with a change of the reference potential.

In this specification and the like, when a plurality of components are denoted with the same reference numerals, and in particular need to be distinguished from each other, an identification sign such as "_1", "[*n*]", or "[*m,n*]" is sometimes added to the reference numerals.

Note that in this specification and the like, the expression "level or substantially level" indicates a structure having the same level from a reference surface (e.g., a flat surface such as a substrate surface) in a cross-sectional view. For example, in a manufacturing process of the semiconductor device, planarization treatment (typically, CMP treatment) is performed, whereby the surface(s) of a single layer or a plurality of layers are exposed in some cases. In this case, the surfaces on which the planarization treatment is performed is at the same level from a reference surface. Note that a plurality of layers are not level with each other in some cases, depending on a treatment apparatus, a treatment method, or a material of the treated surfaces on which the planarization treatment is performed. This case is also regarded as being "level or substantially level" in this specification and the like. For example, the expression "level or substantially level" also includes the case where two layers (here, given as a first layer and a second layer) whose levels with respect to the reference surface are different from each other are provided to have a difference between the top-surface level of the first layer and the top-surface level of the second layer, which is less than or equal to 20 nm.

Note that in this specification and the like, the expression "end portions are aligned or substantially aligned" means that at least outlines of stacked layers partly overlap with each other. For example, the case of processing the upper layer and the lower layer with use of the same mask pattern or mask patterns that are partly the same in a manufacturing process of a semiconductor device is included. However, in some cases, the outlines do not exactly overlap with each other and the outline of the upper layer is located inward from the outline of the lower layer or the outline of the upper layer is located outward from the outline of the lower layer; such a case is also represented by the expression "end portions are aligned or substantially aligned".

### (Embodiment 1)

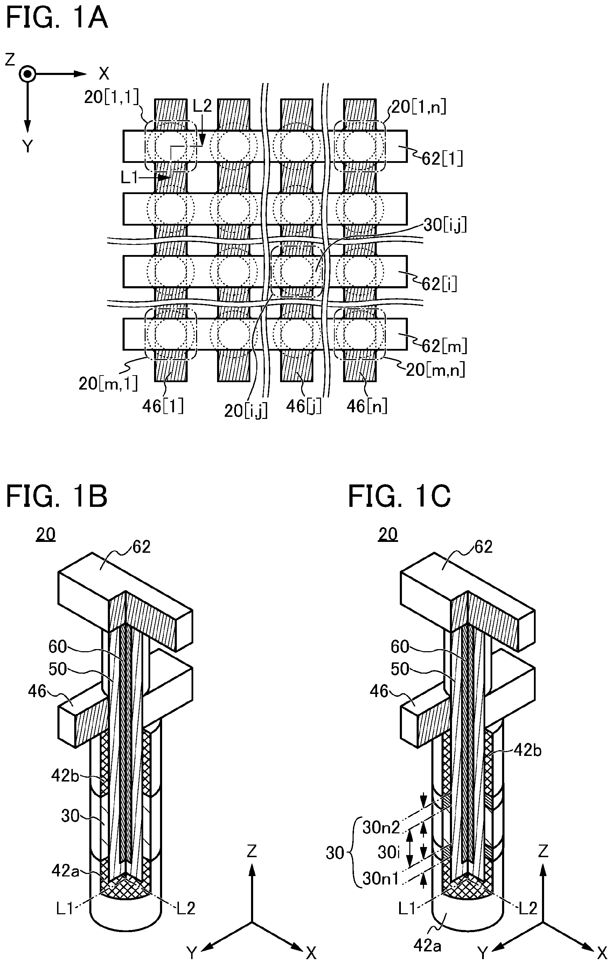

In this embodiment, a structure example of a semiconductor device of one embodiment of the present invention and a structure example of a transistor included in the semiconductor device of one embodiment of the present invention will be described with reference to FIG. 1A to FIG. 4C.

### <Structure example of semiconductor device>

A structure of a semiconductor device including a plurality of transistors is described with reference to FIG. 1A. FIG. 1A is a top view of the semiconductor device including a plurality of transistors 20. Note that for clarity of the drawing, some components are omitted in the top view of FIG. 1A.

Note that in the drawings, arrows indicating an X direction, a Y direction, and a Z direction are illustrated in some cases. In this specification and the like, the "X direction" is a direction along the X-axis, and the forward direction and the reverse direction are not distinguished in some cases. The same applies to "Y direction" and "Z direction". The X direction, the Y direction, and the Z direction are directions intersecting with each other. More specifically, the X direction, the Y direction, and the Z direction are directions orthogonal to each other. In this specification and the like, one of the X direction, the Y direction, and the Z direction is referred to as a "first direction" in some cases. Another one of the directions is referred to as a "second direction" in some cases. The remaining one of the directions is referred to as a "third direction" in some cases.

The semiconductor device of one embodiment of the present invention includes the plurality of transistors 20. FIG. 1A illustrates an example of the semiconductor device where the plurality of transistors 20 are arranged in a matrix of *m* rows and *n* columns (*m* and *n* are each an integer greater than or equal to 2).

Note that the rows and the columns extend in directions orthogonal to each other. In this embodiment, the X direction represents "row" and the Y direction represents "column". Note that the X direction may represent "column" and the Y direction may represent "row".

In FIG. 1A, the transistor 20 in the first row and the first column is denoted as a transistor 20[1,1]; the transistor 20 in the *m*-th row and the first column is denoted as a transistor 20[*m*,1]; the transistor 20 in the first row and the *n*-th column is denoted as a transistor 20[1,*n*]; and the transistor 20 in the *m*-th row and the *n*-th column is denoted as a transistor 20[*m,n*].

In this embodiment and the like, a given row is denoted as an *i*-th row in some cases. A given column is denoted as a *j*-th column in some cases. Thus, *i* is an integer greater than or equal to 1 and less than or equal to *m,* and *j* is an integer greater than or equal to 1 and less than or equal to *n.* In this embodiment and the like, the transistor 20 in the *i*-th row and the *j*-th column is denoted by a transistor 20[*i,j*]. Note that in this embodiment and the like, "*i* + *α*" (*α* is a positive or negative integer) is not below 1 and does not exceed *m.* Similarly, "j + *α"* is not below 1 and does not exceed *n*.

The semiconductor device of one embodiment of the present invention includes *m* conductors 62 extending in the row direction and *n* conductors 46 extending in the column direction. In this embodiment and the like, the first conductor 62 (in the first row) is denoted as the conductor 62[1], and the *m*-th conductor 62 (in the *m*-th row) is denoted as a conductor 62[*m*]. Similarly, the first conductor 46 (in the first column) is denoted as a conductor 46[1], and the *n*-th conductor 46 (in the *n*-th column) is denoted as the conductor 46[*n*].

The transistor 20[*i,j*] is positioned below a region where the conductor 62 in the *i*-th row (the conductor 62[*i*]) and the conductor 46 in the *j*-th column (the conductor 46[*j*]) intersect with each other. The transistor 20[*i,j*] is electrically connected to the conductor 62[*i*] and the conductor 46[*j*]. Furthermore, the transistor 20[*i,j*] includes an oxide 30[*i,j*] where a channel is formed.

The conductor 62 described below refers to one or more of the conductor 62[1] to the conductor 62[*m*]*.* Similarly, the conductor 46 described below refers to one or more of the conductor 46[1] to the conductor 46[*n*]. Similarly, the transistor 20 described below refers to one or more of the transistor 20[1,1] to the transistor 20[*m,n*]*.*

In FIG. 1A, the conductor 46 is provided above the transistor 20, and the conductor 62 is provided above the conductor 46. Since the conductor 62 extends in the row direction and the conductor 46 extends in the column direction, the conductor 62 and the conductor 46 are orthogonal to each other. The conductor 62 and the conductor 46 function as wirings.

### <Transistor 20>

A structure example of the transistor 20 included in the semiconductor device of one embodiment of the present invention is described with reference to FIG. 1B. FIG. 1B is a perspective view of the transistor 20, including a cross section corresponding to a portion indicated by a dashed-dotted line L1-L2 in FIG. 1A. Note that for simplification of the drawing, a hatching pattern is only applied to the cross section in the perspective view, as in FIG. 1B. In addition, the perspective view including a cross section like FIG. 1B is sometimes referred to as a cross-sectional perspective view.

Since the transistor 20[1,1] to the transistor 20[*m,n*] have the same structure, they are denoted as the transistor 20 in FIG. 1B and the like, and identification signs are not added thereto.

The transistor 20 illustrated in FIG. 1B includes a conductor 42a, the oxide 30 over the conductor 42a, a conductor 42b over the oxide 30, an insulator 50, and a conductor 60. The conductor 42a, the oxide 30, and the conductor 42b each have a circular shape in a top view. The conductor 42a, the oxide 30, and the conductor 42b extend in the Z direction. Thus, as illustrated in FIG. 1B, the conductor 42a, the oxide 30, and the conductor 42b each have a cylindrical shape (also referred to as a columnar shape). Note that the cylindrical shapes of the conductor 42a, the oxide 30, and the conductor 42b extend in the Z direction. The conductor 42a has a depressed portion. The oxide 30 and the conductor 42b each have an opening in a region overlapping with the depressed portion of the conductor 42a in the top view. Thus, as illustrated in FIG. 1A, the top surfaces of the oxide 30 and the conductor 42b have a hollow circular shape. In other words, the oxide 30 and the conductor 42b each have a cylindrical shape provided with a hollow portion. Note that the openings of the oxide 30 and the conductor 42b are sometimes referred to as opening portions, hollows, hollow portions, or the like. In addition, a cylindrical shape provided with a hollow portion is referred to as a hollow cylindrical shape in some cases.

Although the top surface of the oxide 30 in FIG. 1A has a hollow circular shape, the present invention is not limited thereto. For example, the top surface of the oxide 30 may have a hollow elliptical shape, a hollow polygonal shape, or a hollow polygonal shape with rounded corners. The polygonal shape here means a triangle, a quadrangle, a pentagon, a hexagon, and the like.

Furthermore, the state where the conductor 42a has a depressed portion and the oxide 30 and the conductor 42b have openings is expressed in such a sentence that a stack of the conductor 42a, the oxide 30, and the conductor 42b has a depressed portion, in some cases. Note that the conductor 42a may have an opening. In this case, the expression "a stack of the conductor 42a, the oxide 30, and the conductor 42b has an opening" is given in some cases.

The insulator 50 and the conductor 60 are positioned on the inner side of the depressed portion of the conductor 42a and on the inner sides of the openings of the oxide 30 and the conductor 42b. The insulator 50 includes a region in contact with the side surface of the conductor 60 and a region in contact with the bottom surface of the conductor 60.

The conductor 60 functions as a gate electrode. The insulator 50 functions as a gate insulator. Note that the gate insulator is also referred to as a gate insulating layer or a gate insulating film in some cases. The conductor 42a functions as one of a source electrode and a drain electrode, and the conductor 42b functions as the other of the source electrode and the drain electrode. At least part of a region of the oxide 30 overlapping with the conductor 60 functions as a channel formation region. Note that the region of the oxide 30 overlapping with the conductor 60 can be rephrased as a region where the oxide 30 faces the conductor 60 with the insulator 50 therebetween.

The transistor 20 is what is called a vertical transistor in which one of a source electrode and a drain electrode is positioned below a channel formation region and the other of the source electrode and the drain electrode is positioned above the channel formation region, whereby current flows in the vertical direction. The vertical transistor can be formed at a cross point where wirings with the minimum pitch intersect with each other. Specifically, the transistor 20 is formed below a region where the conductor 62 and the conductor 46 intersect with each other. Thus, miniaturization and high integration of the semiconductor device can be achieved. Specifically, the minimum design rule can be changed from 6F² to 4F².

Note that the channel length of the transistor 20 refers to, for example, a distance between a source (a source region or a source electrode) and a drain (a drain region or a drain electrode) in a region where a semiconductor (or a portion in a semiconductor where a current flows when a transistor is in an on state) and a gate electrode overlap with each other or a channel formation region in the cross-sectional view. That is, the channel length of the transistor 20 corresponds to the thickness of the oxide 30. Thus, the channel length of the transistor 20 can be adjusted by the thickness of the oxide 30, which makes it possible to form the transistor 20 with a short channel length when the thickness of the oxide 30 is made thin. When the oxide 30 is deposited using a film-formation method enabling thin film formation, the channel length of the transistor 20 can be, for example, less than or equal to 30 nm, less than or equal to 20 nm, less than or equal to 15 nm, less than or equal to 10 nm, less than or equal to 8 nm, or less than or equal to 5 nm. In other words, the oxide 30 is preferably formed to have a thickness greater than or equal to 3 nm and less than or equal to 30 nm, for example. Since the OS transistor has an extremely low off-state current, the transistor 20 even with the above channel length can have the off-state current reduced.

Meanwhile, in the case where a transistor operates in a saturation region, for example, the channel length of the transistor is sometimes lengthened so that its electrical characteristics in the saturation region can be improved. Since the transistor 20 is a vertical transistor, the area occupied by the transistor 20 in the top view does not depend on the thickness of the oxide 30. Thus, the thickness of the oxide 30 corresponding to the channel length may be made large. For example, the thickness of the oxide 30 may be greater than 30 nm and less than or equal to 100 nm.

From the above, the thickness of the oxide 30 is greater than or equal to 3 nm and less than or equal to 100 nm, preferably greater than or equal to 3 nm and less than or equal to 30 nm, further preferably greater than or equal to 5 nm and less than or equal to 30 nm, still further preferably greater than or equal to 5 nm and less than or equal to 15 nm.

The channel width of the transistor 20 refers to the length of a channel formation region in a direction perpendicular to a channel length direction in a region where a semiconductor (or a portion where a current in a semiconductor flows when a transistor is in an on state) and a gate electrode overlap with each other, or a channel formation region in the top view. That is, the channel width of the transistor 20 corresponds to a circumference of the hollow of the oxide 30. Note that in one transistor, channel widths in all regions do not necessarily have the same value. In other words, the channel width of one transistor is not fixed to one value in some cases. Thus, in this specification, the channel width is any one of the values, the maximum value, the minimum value, or the average value in a channel formation region.

Note that the channel length and the channel width can be determined by analyzing a cross-sectional TEM image, for example.

In the transistor 20, a metal oxide functioning as a semiconductor (hereinafter, also referred to as oxide semiconductor) is preferably used in the oxide 30 including the channel formation region.

The metal oxide functioning as a semiconductor preferably has a band gap of 2 eV or higher, further preferably 2.5 eV or higher. With use of a metal oxide having a wide bandgap, the off-state current of the transistor can be reduced.

The oxide 30 preferably contains at least indium or zinc. In particular, indium and zinc are preferably contained. In addition to these, one or more selected from aluminum, gallium, yttrium, and tin are preferably contained. Furthermore, one or more kinds selected from boron, silicon, titanium, iron, nickel, germanium, zirconium, molybdenum, lanthanum, cerium, neodymium, hafnium, tantalum, tungsten, magnesium, cobalt, and the like may be contained.

Here, the case where use of an In-*M*-Zn oxide that contains indium, an element *M,* and zinc as the oxide 30 is considered. The element *M* is aluminum, gallium, yttrium, or tin. Examples of other elements that can be used as the element *M* include boron, silicon, titanium, iron, nickel, germanium, zirconium, molybdenum, lanthanum, cerium, neodymium, hafnium, tantalum, tungsten, magnesium, and cobalt. Note that a combination of two or more of the above elements may be used as the element *M.* In particular, the element *M* is preferably one or more kinds selected from gallium, aluminum, yttrium, and tin. Alternatively, an In-Ga oxide, an In-Zn oxide, or an indium oxide may be used as the oxide 30.

Specifically, as the oxide 30, a metal oxide having a composition where In: *M*: Zn = 4:2:3 [atomic ratio] or a neighborhood thereof, a metal oxide having a composition where In: *M*: Zn = 1:1:1 [atomic ratio] or a neighborhood thereof, a metal oxide having a composition where In: *M*: Zn = 1:1:1.2 [atomic ratio] or a neighborhood thereof, or a metal oxide having a composition where In: *M*: Zn = 1: 1:2 [atomic ratio] or a neighborhood thereof can be used. Note that a composition in the neighborhood includes the range of ±30 % of an intended atomic ratio.

It is particularly preferable to use an oxide containing indium (In), gallium (Ga), and zinc (Zn) (also referred to as IGZO) for the oxide 30. Alternatively, an oxide containing indium (In), aluminum (Al), and zinc (Zn) (also referred to as IAZO) may be used for the oxide 30. Alternatively, an oxide containing indium (In), aluminum (Al), gallium (Ga), and zinc (Zn) (also referred to as IAGZO, IGAZO, or AGIZO) may be used for the oxide 30.

Note that in this specification and the like, a metal oxide containing nitrogen is also collectively referred to as a metal oxide in some cases. A metal oxide containing nitrogen may be called a metal oxynitride.

When the substrate floating effect is caused by use of silicon for the channel formation region of the vertical transistor, whereby the electrical characteristics of the vertical transistor are unstable. By contrast, metal oxides such as IGZO, IAZO, and IAGZO have a high hole effective mass. Accordingly, when any of the above metal oxides is used for a channel formation region, hole accumulation in the channel formation region can be inhibited, so that a vertical transistor suffering from little impact or substantially no impact of the substrate floating effect can be fabricated. That is, when any of the metal oxides is used as the oxide 30, the transistor 20 can have stable electrical characteristics. Accordingly, a transistor having favorable electrical characteristics can be provided. Furthermore, a transistor with a small variation in electrical characteristics can be provided.

The oxide 30 preferably has crystallinity. It is particularly preferable to use a CAAC-OS (c-axis aligned crystalline oxide semiconductor) as the oxide 30.

The CAAC-OS is a metal oxide having a dense structure with high crystallinity and a small amount of impurities and defects (for example, oxygen vacancies). In particular, after the formation of a metal oxide, heat treatment is performed at a temperature at which the metal oxide does not become a polycrystal (e.g., higher than or equal to 400 °C and lower than or equal to 600 °C), whereby a CAAC-OS having a dense structure with higher crystallinity can be obtained. When the density of the CAAC-OS is increased in such a manner, diffusion of impurities or oxygen in the CAAC-OS can be further reduced.

A clear crystal grain boundary is difficult to observe in the CAAC-OS; thus, it can be said that a reduction in electron mobility due to the crystal grain boundary is less likely to occur. Thus, a metal oxide including a CAAC-OS is physically stable. Therefore, the metal oxide including a CAAC-OS is resistant to heat and has high reliability.

When a metal oxide having crystallinity, such as CAAC-OS, is used as the oxide 30, oxygen extraction from the oxide 30 by the source electrode or the drain electrode can be inhibited. This can reduce oxygen extraction from the oxide 30 even when heat treatment is performed; thus, the transistor 20 is stable with respect to high temperatures in a manufacturing process (what is called thermal budget).

In the case where the CAAC-OS is used as the oxide 30, the c-axis of the crystal included in the CAAC-OS is aligned in a direction perpendicular or substantially perpendicular to a formation surface or the top surface of a metal oxide film to be the oxide 30. In other words, the crystal included in the CAAC-OS has c-axis alignment with respect to the formation surface or the top surface of the metal oxide film to be the oxide 30. That is, the crystal included in the oxide 30 has c-axis alignment with respect to a substrate surface.

In the case where an In-*M*-Zn oxide such as IGZO or IAZO is used as the oxide 30, examples of the crystal structure of the oxide 30 include a YbFe₂O₄ type structure, a Yb₂Fe₃O₇ type structure, and a variation structure thereof.

The oxide 30 can be formed by a sputtering method, a chemical vapor deposition (CVD) method, a molecular beam epitaxy (MBE) method, a pulsed laser deposition (PLD) method, an atomic layer deposition (ALD) method, or the like. It is particularly preferable to employ a sputtering method for formation of the oxide 30. With use of a sputtering method, a metal oxide having crystallinity can be formed. The sputtering method is a film deposition method enabling thin film formation and accordingly can be suitably used for formation of the oxide 30.

In the case of a transistor in which the side surface of a metal oxide functioning as a semiconductor is covered with a word line with a gate insulating layer therebetween, i.e., what is called a gate all around transistor, the metal oxide is formed on the inner side of an opening portion formed in the word line or the gate insulating layer. To miniaturize the transistor, an inner wall of the opening portion needs to be perpendicular as possible to the substrate surface. In this case, the formation of the metal oxide with high step coverage is required, which restricts the degree of freedom of a method for forming the metal oxide.

Meanwhile, the transistor 20 is fabricated in the following manner: a depressed portion or an opening is formed in a stack of the conductor 42a, the oxide 30, and the conductor 42b and the insulator 50 and the conductor 60 are formed on the inner side of the depressed portion or the opening. In this structure, the oxide 30 may be formed over the conductor 42a, and the oxide 30 does not need to have high step coverage at the time of being formed. Thus, a film-formation method of the oxide 30 can be freely selected. For example, a sputtering method can be used for the formation of the oxide 30, which enables a metal oxide having crystallinity to be formed.

Note that for formation of the depressed portion or the opening, it is preferable to use a multi-patterning technique including double patterning such as LELE (Litho-Etch-Litho-Etch) and SADP (Self-Aligned Double Patterning), quadruple patterning such as SAQP (Self-Aligned Quadruple Patterning), and octuple patterning. With use of a multi-patterning technique, a fine depressed portion or a fine opening can be formed.

In addition, a shrink agent may be used for a resist pattern so that an opening portion in the resist pattern is downsized. For example, the shrink agent is applied on a resist surface, and then heat treatment is performed. Thus, the resist reacts with the shrink agent, so that a reaction layer is formed on the resist surface. At this time, the reaction layer is also formed on the side surface of the opening portion in the resist pattern; thus, the opening portion can be downsized. With use of a resist pattern with a downsized opening portion, a fine depressed portion or a fine opening can be formed. Note that the shrink agent is referred to as a pattern shrinking agent or a hole shrinking agent in some cases.

A fine pattern may be directly formed by light exposure using EUV (Extreme Ultraviolet) light or the like.

Furthermore, patterning may be performed by a combination of the above methods.

As described above, after the oxide semiconductor, which allows little impact or substantially no impact of the substrate floating effect, is deposited by a sputtering method, a channel having a cylindrical shape with a hollow portion is formed using a multi-patterning technique such as SAQP. With a vertical transistor structure in which a gate electrode is provided in the hollow portion, a transistor that can be miniaturized can be provided. With use of the transistor, a memory cell with a minimum feature size (F) less than or equal to 15 nm, for example, can be obtained. Here, the minimum feature size (F) is, for example, the width of the conductor 46 in the X direction or the width of the conductor 62 in the Y direction.

The conductor 42a is provided in contact with the bottom surface of the oxide 30 and the conductor 42b is provided in contact with the top surface of the oxide 30. Hereinafter, the conductor 42a and the conductor 42b might be collectively referred to as a conductor 42.

For the conductor 42, for example, a nitride containing tantalum, a nitride containing titanium, a nitride containing molybdenum, a nitride containing tungsten, a nitride containing tantalum and aluminum, a nitride containing titanium and aluminum, or the like is preferably used. In one embodiment of the present invention, a nitride containing tantalum is particularly preferable. As another example, ruthenium oxide, ruthenium nitride, an oxide containing strontium and ruthenium, or an oxide containing lanthanum and nickel may be used. These materials are preferable because they are each a conductive material that is not easily oxidized or a material that maintains the conductivity even after absorbing oxygen.

Note that a conductive film to be the conductor 42a and a conductive film to be the conductor 42b are formed in different steps. Thus, the conductor 42a and the conductor 42b may be formed using different materials or may be formed using the same material.

Note that hydrogen contained in the oxide 30 or the like diffuses into the conductor 42a in some cases. In particular, when a nitride containing tantalum is used for the conductor 42a, hydrogen contained in the oxide 30b or the like is likely to diffuse into the conductor 42a, and the diffusing hydrogen is bonded to nitrogen contained in the conductor 42a in some cases. That is, hydrogen contained in the oxide 30 or the like is sometimes absorbed by the conductor 42a. Similarly, hydrogen contained in the oxide 30 or the like diffuses into the conductor 42b in some cases. In particular, when a nitride containing tantalum is used for the conductor 42b, hydrogen contained in the oxide 30 or the like is likely to diffuse into the conductor 42b, and the diffusing hydrogen is bonded to nitrogen contained in the conductor 42b in some cases. That is, hydrogen contained in the oxide 30 or the like is sometimes absorbed by the conductor 42b.

In the case where heat treatment is performed in a state where the conductor 42a and the oxide 30 are in contact with each other, the sheet resistance of the oxide 30 in the vicinity of the conductor 42a may decrease. Furthermore, the carrier concentration sometimes increases. Thus, the resistance of the oxide 30 in the vicinity of the conductor 42a can be decreased in a self-aligned manner. Similarly, in the case where heat treatment is performed in a state where the conductor 42b and the oxide 30 are in contact with each other, the sheet resistance of the oxide 30 in the vicinity of the conductor 42b may decrease. Furthermore, the carrier concentration sometimes increases. Thus, the resistance of the oxide 30 in the vicinity of the conductor 42b can be decreased in a self-aligned manner.

In the above case, for example, a region 30n1 and a region 30n2 are formed in the oxide 30 as illustrated in FIG. 1C. Here, FIG. 1C is a cross-sectional perspective view of the transistor 20.

The region 30n1 is a region in the oxide 30 which is in the vicinity of the conductor 42a and has reduced resistance, and the region 30n2 is a region in the oxide 30, which is in the vicinity of the conductor 42b and has reduced resistance. The region 30n1 and the region 30n2 serve as a source region or a drain region. A region in the oxide 30 which functions as a channel formation region is referred to as a region 30i. In the oxide 30, the boundaries between the regions are difficult to detect clearly in some cases.

Note that the region 30n1 is not formed depending on a material used for the conductor 42a, in some cases. In this case, the oxide 30 includes the region 30i and the region 30n2. Similarly, the region 30n2 is not formed depending on a material used for the conductor 42b, in some cases. In this case, the oxide 30 includes the region 30n1 and the region 30i.

The insulator 50 is preferably formed using an insulator having a function of inhibiting diffusion of oxygen. With this structure, oxygen contained in the oxide 30 can be inhibited from diffusing into the conductor 60. Thus, generation of oxygen vacancies in the oxide 30 can be inhibited. In addition, oxidation of the conductor 60 due to oxygen contained in the oxide 30 can be inhibited. Thus, the transistor 20 can have favorable electrical characteristics and higher reliability.

As the insulator 50, an insulator containing an oxide of one or both of aluminum and hafnium is preferably used. As the insulator, aluminum oxide, hafnium oxide, an oxide containing aluminum and hafnium (hafnium aluminate), an oxide containing hafnium and silicon (hafnium silicate), or the like can be used.

A high dielectric constant (high-k) material may be used for the insulator 50. When a high dielectric constant material is used for the insulator 50, the equivalent oxide thickness (EOT) of the insulator functioning as the gate insulator can be reduced. Therefore, the breakdown voltage of the insulator 50 can be increased.

In addition, examples of high dielectric constant materials include gallium oxide, hafnium oxide, zirconium oxide, an oxide containing aluminum and hafnium, an oxynitride containing aluminum and hafnium, an oxide containing silicon and hafnium, an oxynitride containing silicon and hafnium, and a nitride containing silicon and hafnium.

The insulator 50 extends in the Z direction so that the top surface of the insulator 50 is positioned above the conductor 42b. Thus, the conductor 42b and the conductor 62 can be prevented from being in contact with each other, and leakage current and a short circuit between the conductor 42b and the conductor 62 can be prevented. Similarly, the conductor 46 and the conductor 62 can be prevented from being in contact with each other, and leakage current and short circuit between the conductor 46 and the conductor 62 can be prevented.

Although FIG. 1B illustrates a single-layer structure of the insulator 50, the present invention is not limited to this structure, and a stacked-layer structure of two or more layers may be employed. For example, in the case where the insulator 50 has a stacked-layer structure of two layers, an insulator provided on the oxide 30 side may be formed using an insulator having a function of inhibiting diffusion of oxygen and an insulator provided on the conductor 60 side may be formed using a high dielectric constant material.

For the conductor 60, a conductive material having a function of inhibiting diffusion of impurities such as a hydrogen atom, a hydrogen molecule, a water molecule, a nitrogen atom, a nitrogen molecule, a nitrogen oxide molecule, and a copper atom is preferably used. Alternatively, it is preferable to use a conductive material having a function of inhibiting diffusion of oxygen (e.g., at least one of an oxygen atom, an oxygen molecule, and the like).

In addition, when the conductor 60 has a function of inhibiting diffusion of oxygen, a reduction in conductivity of the conductor 60, which is caused by oxidation due to oxygen contained in the insulator 50, can be inhibited. As the conductive material having a function of inhibiting diffusion of oxygen, for example, titanium, titanium nitride, tantalum, tantalum nitride, ruthenium, or ruthenium oxide is preferably used.

The conductor 46 includes a region in contact with the conductor 42b, and the conductor 62 includes a region in contact with the conductor 60. The conductor 46 and the conductor 62 function as wirings.

The conductor 46 has an opening. The insulator 50 and the conductor 60 are provided in the opening. When the width of the conductor 46 in the X direction is larger than the diameter of the outer periphery of the insulator 50 in the top view, the conductor 46 extends in the Y direction as a continuous conductor. By contrast, when the width of the conductor 46 in the X direction is equal to or smaller than the diameter of the outer periphery of the insulator 50 in the top view, the conductor 46 is divided by the insulator 50. Note that the divided conductors 46 are electrically connected to each other through the conductor 42b. That is, the conductor 46 extends in the Y direction through the conductor 42b and can be regarded as extending in the Y direction.

The conductor 46 may include a region overlapping with the conductor 62 or does not necessarily include the region.

For the conductor 46 and the conductor 62, a conductive material containing tungsten, copper, or aluminum as its main component is preferably used. One or both of the conductor 46 and the conductor 62 may have a stacked-layer structure, for example, may be stacked layers of titanium or titanium nitride and the above conductive material.

### <Variation example of transistor 20>

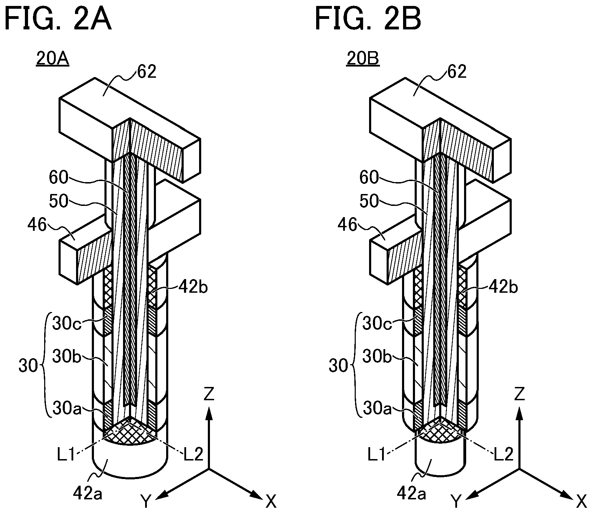

A structure example different from that of the above-described transistor 20 is described below with reference to FIG. 2A to FIG. 4C.

Although the structure illustrated in FIG. 1B includes a single layer of the oxide 30, the present invention is not limited to this. For example, the oxide 30 may have a stacked-layer structure of two or more layers.

### [Transistor 20A]

FIG. 2A is a cross-sectional perspective view of a transistor 20A. The transistor 20A illustrated in FIG. 2A is a variation example of the transistor 20 illustrated in FIG. 1B.

The transistor 20A illustrated in FIG. 2A is different from the transistor 20 illustrated in FIG. 1B in that the oxide 30 has a stacked-layer structure of three layers of an oxide 30a, an oxide 30b, and an oxide 30c.

The oxide 30b functions as a channel formation region of the transistor 20A, the oxide 30a functions as one of a source region and a drain region of the transistor 20A, and the oxide 30c functions as the other of the source region and the drain region of the transistor 20A.

A metal oxide that can be used as the above-described oxide 30 may be used for the oxide 30b.

A material whose conductivity is higher than that of the oxide 30b is preferably used for the metal oxide 30a and the metal oxide 30c. A degenerated oxide semiconductor is preferably used for the oxide 30a and the oxide 30c.

For example, for the oxide 30a and the oxide 30c, a material obtained by adding nitrogen to a metal oxide that can be used for the oxide 30b can be used. Specifically, a metal oxide containing indium, the above element *M*, zinc, and nitrogen (also referred to as a metal oxynitride) is preferably used. More specifically, an oxide containing indium (In), gallium (Ga), zinc (Zn), and nitrogen (also referred to as an oxynitride containing In, Ga, and Zn or IGZO to which nitrogen is added), an oxide containing indium (In), aluminum (Al), zinc (Zn), and nitrogen (also referred to as an oxynitride containing In, Al, and Zn or IAZO to which nitrogen is added), an oxide containing indium (In), aluminum (Al), gallium (Ga), zinc (Zn), and nitrogen (also referred to as an oxynitride containing In, Al, Ga, and Zn, IAGZO to which nitrogen is added, IGAZO to which nitrogen is added, or AGIZO to which nitrogen is added), or the like can be used.

For example, IGZO to which nitrogen is added tends to have a wurtzite crystal structure. A wurtzite crystal structure and a crystal structure of a crystal of an In-*M*-Zn oxide have lattices matching well each other. Thus, use of a metal oxynitride having a wurtzite crystal structure for the oxide 30a enables the crystallinity of the oxide 30b to be increased. Accordingly, a metal oxide having a CAAC structure is likely to be formed as the oxide 30b.

In the case where the CAAC-OS is used as the oxide 30b as described above, the crystal in the oxide 30b has c-axis alignment with respect to the substrate surface. Note that impurities in the CAAC-OS are less likely to diffuse in the c-axis direction. Thus, use of the CAAC-OS for the oxide 30b can inhibit entry of impurities into the oxide 30b. For example, entry of nitrogen into the oxide 30b can be inhibited. Hence, an increase in the conductivity of the oxide 30b can be inhibited.

Note that although a material obtained by adding nitrogen to a metal oxide that can be used for the oxide 30b is described above, the element added to a metal oxide that can be used for the oxide 30b can be any of the elements increasing the conductivity of the metal oxide. As such an element, for example, one or more selected from the following can be used: hydrogen, Group 15 elements (typically, nitrogen (N), phosphorus (P), arsenic (As), and antimony (Sb)), boron (B), aluminum (Al), argon (Ar), helium (He), neon (Ne), indium (In), fluorine (F), chlorine (Cl), titanium (Ti), and zinc (Zn).

Note that it is preferable that the conductivity of the metal oxide used for the oxide 30a and the oxide 30c be higher than that of the oxide 30b. For example, for the oxide 30a and the oxide 30c, a metal oxide containing the same element, besides oxygen, as the oxide 30b as a main component and having different chemical compositions from the oxide 30b may be used.

In the case where the oxide 30a and the oxide 30c contain the same element, besides oxygen, as the oxide 30b as a main component, the oxide 30 preferably has a stacked-layer structure of a plurality of oxide layers with different chemical compositions. For example, in the case where an In-*M*-Zn oxide is used as the oxide 30b, the atomic ratio of indium to a metal element that is a main component in the metal oxide used for the oxide 30a or the oxide 30c is preferably greater than that in the metal oxide used for the oxide 30b. Moreover, the atomic ratio of the indium to the element *M* in the metal oxide used for the oxide 30a or the oxide 30c is preferably greater than that in the metal oxide used as the oxide 30b.

When the oxide 30a and the oxide 30c contain the same element, besides oxygen, as the oxide 30b as a main component, the density of defect states at an interface between the oxide 30a or the oxide 30c and the oxide 30b can be made low. Since the density of defect states at the interface between the oxide 30a or the oxide 30c and the oxide 30b can be made low, the influence of interface scattering on carrier conduction is small, and a high on-state current can be obtained.

Alternatively, for the oxide 30a and the oxide 30c, titanium oxide, molybdenum oxide, zinc oxide, indium oxide, tungsten oxide, magnesium oxide, calcium oxide, tin oxide, indium zinc oxide, indium tin oxide, indium tin oxide containing silicon, or the like may be used.

Although a structure illustrated in FIG. 2A is such that the outline of the conductor 42a is aligned or substantially aligned with the outer contour of the oxide 30 in a top view, the present invention is not limited thereto. In the case where the conductor 42a includes a region in contact with the oxide 30, the outline of the conductor 42a is not necessarily aligned with the outer contour of the oxide 30 in a top view.

### [Transistor 20B]

FIG. 2B is a cross-sectional perspective view of a transistor 20B. Note that the transistor 20B illustrated in FIG. 2B is a variation example of the transistor 20A illustrated in FIG. 2A.

The transistor 20B illustrated in FIG. 2B is different from the transistor 20A illustrated in FIG. 2A in that the center of the conductor 42a is not aligned with the center of the hollow cylindrical shape of the oxide 30 in the top view.

To miniaturize the semiconductor device, the diameter of the conductor 42a and the diameter of the hollow portion in the oxide 30 have to be made small in the top view. When processing is performed so that the diameter of the conductor 42a and the diameter of the hollow portion in the oxide 30 are minimized, the diameter of the conductor 42a and the diameter of the hollow portion in the oxide 30 are equal or substantially equal to each other. In that case, in the top view, there is a possibility that the conductor 42a and the oxide 30 do not overlap with each other and the conductor 42a and the oxide 30 are not in contact with each other.

As illustrated in FIG. 2B, it is preferable that the conductor 42a be placed at a position off from the centers of the hollow portions in the oxide 30 and the conductor 42b and include a region overlapping with the oxide 30 and the conductor 42b in the top view. With this structure, the conductor 42a can include a region in contact with the oxide 30a. The conductor 42a can be formed separately from the oxide 30 and the conductor 42b. Accordingly, the layout flexibility of the semiconductor device can be increased.

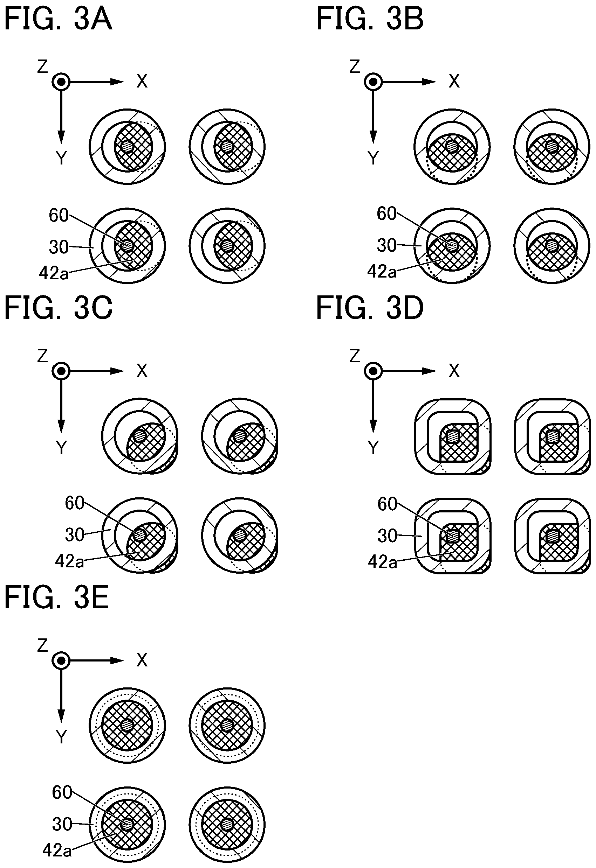

Here, the position of the conductors 42a with respect to the oxide 30 in the top view is described with reference to FIG. 3A to FIG. 3E. FIG. 3A to FIG. 3E are top views of the transistor 20B. Note that for clarity of the drawing, the top views of FIG. 3A to FIG. 3E show the conductor 60, the oxide 30, and the conductor 42a and do not illustrate some components.

As illustrated in FIG. 3A, the conductor 42a may include a region overlapping with the oxide 30 and be placed at a position shifted in the X direction from the center of the hollow cylindrical shape of the oxide 30. The outline of the conductor 42a is positioned more inwardly than the outer periphery of the hollow cylindrical shape of the oxide 30.

As illustrated in FIG. 3B, the conductor 42a may include a region overlapping with the oxide 30 and be placed at a position shifted in the Y direction from the center of the hollow cylindrical shape of the oxide 30. The outline of the conductor 42a is positioned more inwardly than the outer periphery of the hollow cylindrical shape of the oxide 30.

Note that in each of the structures illustrated in FIG. 3A and FIG. 3B, part of the outline of the conductor 42a may be positioned more outwardly than the outer periphery of the hollow cylindrical shape of the oxide 30 as long as the conductor 42a includes a region overlapping with the oxide 30.

As illustrated in FIG. 3C, the conductor 42a may include a region overlapping with the oxide 30 and be placed at a position shifted in the X direction and the Y direction from the center of the hollow cylindrical shape of the oxide 30. Note that as illustrated in FIG. 3C, part of the outline of the conductor 42a may be positioned more outwardly than the outer periphery of the hollow cylindrical shape of the oxide 30.

Although the top surface of the oxide 30 has a hollow circular shape in each of FIG. 3A to FIG. 3C, the present invention is not limited thereto. For example, the top surface of the oxide 30 may have a hollow elliptical shape, a hollow polygonal shape, or a hollow polygonal shape with rounded corners.

For example, in FIG. 3D, the top surface of the oxide 30 has a hollow quadrangular shape with rounded corners, and the top surfaces of the conductor 42a and the conductor 60 have a quadrangular shape with rounded corners. In FIG. 3D, the conductor 42a includes a region overlapping with the oxide 30 and is placed at a position shifted in the X direction and Y the direction from the center of the hollow cylindrical shape of the oxide 30. Note that as illustrated in FIG. 3D, part of the outline of the conductor 42a may be positioned more outwardly than the outer periphery of the hollow cylindrical shape of the oxide 30.

The structures illustrated in FIG. 3A to FIG. 3D are the case where the diameter of the conductor 42a and the diameter of the hollow portion in the oxide 30 are equal to each other. The same structure can be employed even when the diameter of the conductor 42a is smaller than the diameter of the hollow portion in the oxide 30.

Note that since the conductor 42a and the oxide 30 can be formed separately in the transistor 20B, the top surface shape of the conductor 42a may be different from the top surface shape of the hollow portion in the oxide 30. For example, the top surface of the oxide 30 may have a hollow circular shape, and the top surface of the conductor 42a may have a polygonal shape with rounded corners (referred to as a substantially polygonal shape in some cases).

When the conductor 42a is larger than the hollow portion in the hollow cylindrical shape of the oxide 30 in the top view, the center of the conductor 42a may be positioned to be aligned with the center of the hollow cylindrical shape of the oxide 30. For example, as illustrated in FIG. 3E, the conductor 42a includes a region overlapping with the oxide 30, and the outline of the conductor 42a is positioned more inwardly than the outer periphery of the hollow cylindrical shape of the oxide 30. Note that the outline of the conductor 42a is positioned more inwardly than the outer periphery of the hollow cylindrical shape of the oxide 30, and the conductor 42a may be placed at a position shifted in one or both of the X direction and the Y direction from the center of the hollow cylindrical shape of the oxide 30.

### [Transistor 20C]

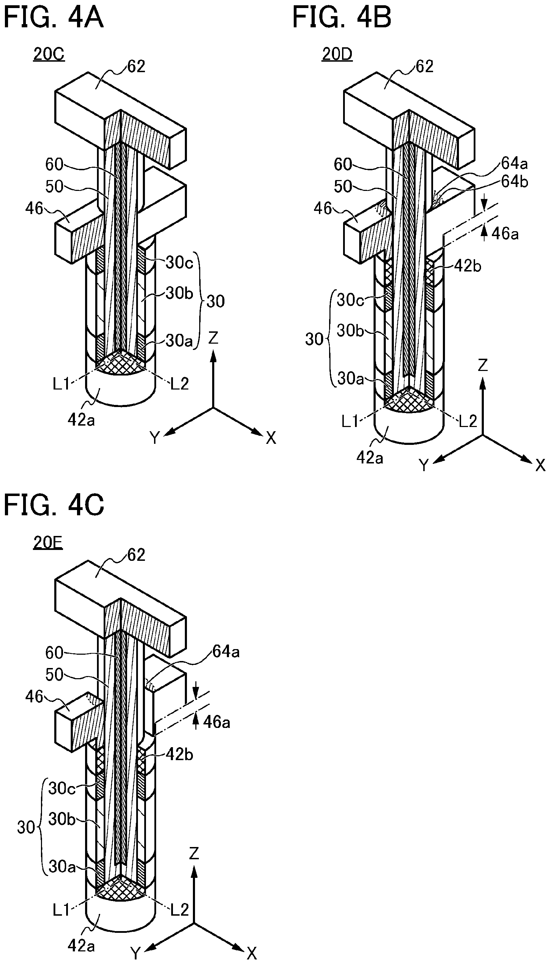

FIG. 4A illustrates a structure example different from that of the above-described transistor 20A. FIG. 4A is a cross-sectional perspective view of a transistor 20C. The transistor 20C illustrated in FIG. 4A is a variation example of the transistor 20A illustrated in FIG. 2A.

The transistor 20C illustrated in FIG. 4A is different from the transistor 20A illustrated in FIG. 2A in not including the conductor 42b.

In the transistor 20C, the conductor 46 also serves as the conductor 42b. In other words, the conductor 46 has a function of a wiring and a function of the other of the source electrode and the drain electrode. When the conductor 42b is not provided, the manufacturing process of the transistor can be simplified and the productivity can be improved.

### [Transistor 20D]

FIG. 4B illustrates a structure example different from that of the above-described transistor 20A. FIG. 4B is a cross-sectional perspective view of a transistor 20D. The transistor 20D illustrated in FIG. 4B is a variation example of the transistor 20A illustrated in FIG. 2A.

The transistor 20D illustrated in FIG. 4B is different from the transistor 20A illustrated in FIG. 2A in the shape of the conductor 46.

A region 64a illustrated in FIG. 4B is a region where the conductor 46 and the conductor 42b overlap with each other in the top view. Note that the region 64a does not overlap with the conductor 62. A region 64b illustrated in FIG. 4B is a region where the conductor 46, the conductor 42b, and the conductor 62 overlap with each other in the top view.

The conductor 46 includes a projecting portion 46a in a region overlapping with the region 64a and the region 64b. The conductor 46 is in contact with the conductor 42b with the projecting portion 46a.

The projecting portion 46a is formed at the time of forming the conductor 46 over an insulator (not illustrated in FIG. 4B) having an opening in a region overlapping with the conductor 42b. Note that a method for forming the conductor 46 having a projecting portion will be described in Embodiment 2.

Although FIG. 4B illustrates the structure in which the conductor 46 includes the projecting portion 46a in a region overlapping with the region 64a and the region 64b, the present invention is not limited thereto. The projecting portion 46a is preferably in contact with at least part of the top surface of the conductor 42b.

### [Transistor 20E]

FIG. 4C is a cross-sectional perspective view of a transistor 20E. The transistor 20E illustrated in FIG. 4C is a variation example of the transistor 20D illustrated in FIG. 4B.

The transistor 20E illustrated in FIG. 4C is different from the transistor 20D illustrated in FIG. 4B in the shape of the conductor 46.

The conductor 46 in the transistor 20E does not overlap with the conductor 62 in the top view. The conductor 46 includes the projecting portion 46a in a region overlapping with the region 64a. In other words, the projecting portion 46a does not overlap with the region 64b illustrated in FIG. 4B. Note that as long as the conductor 46 is in contact with part of the top surface of the conductor 42b, the conductor 46 may include a region in contact with the insulator 50 or is not necessarily in contact with the insulator 50.

With the above structure, the distance between the conductor 62 and the conductor 46 can be increased. Thus, leakage current and a short circuit between the conductor 62 and the conductor 46 can be prevented. Note that as long as leakage current and a short circuit between the conductor 62 and the conductor 46 can be prevented, a region where the conductor 62 and the conductor 46 overlap with each other may be provided as illustrated in FIG. 1B, FIG. 4B, and the like.

According to one embodiment of the present invention, a semiconductor device that can be miniaturized or highly integrated can be provided. Alternatively, a semiconductor device with high reliability can be provided. Alternatively, a semiconductor device having favorable electrical characteristics can be provided. A semiconductor device with a high on-state current can be provided.

This embodiment can be combined with the other embodiments as appropriate. In this specification, in the case where a plurality of structure examples are described in one embodiment, the structure examples can be combined as appropriate.

### (Embodiment 2)

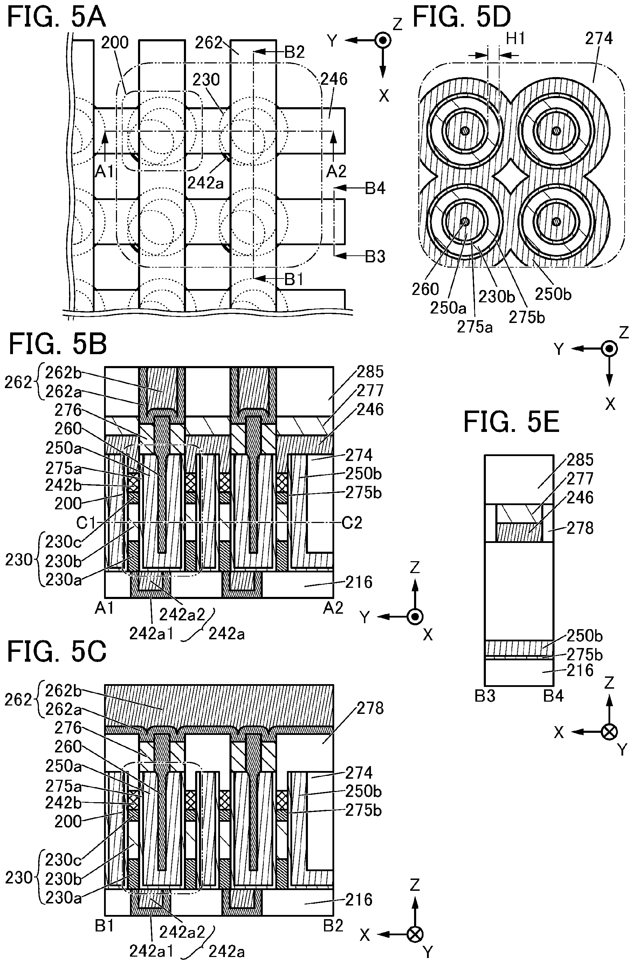

In this embodiment, a structure example of a semiconductor device of one embodiment of the present invention, a structure example of a transistor included in the semiconductor device of one embodiment of the present invention, a method for manufacturing the transistor, and a method for manufacturing the semiconductor device will be described with reference to FIG. 5A to FIG. 16B.

### <Structure example of semiconductor device>

A structure example of the semiconductor device of one embodiment of the present invention is described with reference to FIG. 5A to FIG. 5E. The semiconductor device of one embodiment of the present invention includes a plurality of transistors.

FIG. 5A to FIG. 5E are top views and cross-sectional views of the semiconductor device of one embodiment of the present invention. FIG. 5A and FIG. 5D are top views of the semiconductor device. FIG. 5B, FIG. 5C, and FIG. 5E are cross-sectional views of the semiconductor device. Here, FIG. 5B is a cross-sectional view of a portion indicated by the dashed-dotted line A1-A2 in FIG. 5A. FIG. 5C is a cross-sectional view of a portion indicated by the dashed-dotted line B 1-B2 in FIG. 5A. FIG. 5D is a top view of a region that includes a cross section of a portion indicated by a dashed-dotted line C1-C2 in FIG. 5B and a region surrounded by the dashed double-dotted line in FIG. 5A. FIG. 5E is a cross-sectional view of a portion indicated by the dashed-dotted line B3-B4 in FIG. 5A. Note that for clarity of the drawing, some components are not illustrated in the top views of FIG. 5A and FIG. 5D.

A semiconductor device illustrated in FIG. 5A to FIG. 5E includes a plurality of transistors 200. FIG. 5A illustrates an example in which the semiconductor device includes a plurality of transistors 200 arranged in a matrix. Note that four transistors 200 are illustrated in a region surrounded by the dashed double-dotted line in FIG. 5A.

The semiconductor device illustrated in FIG. 5A to FIG. 5E includes an insulator 216 over a substrate (not illustrated); the transistor 200, an insulator 275b, an insulator 250b, and an insulator 274 over the substrate and the insulator 216; an insulator 277 and an insulator 278 over the transistor 200, the insulator 275b, the insulator 250b, and the insulator 274; and an insulator 285 over the insulator 277 and the insulator 278. The insulator 216, the insulator 274, the insulator 277, the insulator 278, and the insulator 285 function as interlayer films. The semiconductor device also includes a conductor 246 and a conductor 262.

Over the transistor 200, the insulator 275b, the insulator 250b, and the insulator 274, the conductor 246 that is electrically connected to the transistor 200 and functions as a wiring is provided. Furthermore, the conductor 262 (a conductor 262a and a conductor 262b) that is electrically connected to the transistor 200 and functions as a wiring is provided over an insulator 276, the insulator 278, and the transistor 200.

The conductor 262 extends in the X direction. The conductor 246 extends in the Y direction. Thus, it can be said that the direction in which the conductor 262 extends is orthogonal to the direction in which the conductor 246 extends.

In the top view of the semiconductor device illustrated in FIG. 5A to FIG. 5E, the conductor 246 and the conductor 262 do not overlap with each other.

The transistor 200 is positioned below a region where the conductor 262 intersects with regions between adjacent conductors 246 extending in the Y direction.

Note that the transistor 200 corresponds to the transistor 20 or the variation example thereof described in Embodiment 1. Thus, the structures of the transistor 20 and the variation example thereof described in Embodiment 1 can be referred to for the structure of the transistor 200. The transistor 200 illustrated in FIG. 5B to FIG. 5E employs the structure of the transistor 20E.

### <Transistor 200>

As illustrated in FIG. 5B and FIG. 5C, the transistor 200 includes a conductor 242a (a conductor 242a1 and a conductor 242a2) placed so as to be embedded in the insulator 216, an oxide 230a over the insulator 216 and the conductor 242a, an oxide 230b over the oxide 230a, an oxide 230c over the oxide 230b, a conductor 242b over the oxide 230c, an insulator 275a, an insulator 250a over the insulator 275a, and a conductor 260 over the insulator 250a.

Hereinafter, the oxide 230a, the oxide 230b, and the oxide 230c are sometimes collectively referred to as an oxide 230.

The oxide 230 and the conductor 242b each have a cylindrical shape extending in the Z direction and have an opening. That is, the oxide 230 and the conductor 242b each have a cylindrical shape provided with a hollow portion (also referred to as a hollow cylindrical shape). In other words, the top surfaces of the oxide 230 and the conductor 242b each have a hollow circular shape. The opening in the oxide 230 and the opening in the conductor 242b overlap with each other.

The insulator 275a, the insulator 250a, and the conductor 260 are placed on the inner side of the openings provided in the oxide 230 and the conductor 242b. The insulator 250 includes a region in contact with the side surface of the conductor 260 and a region in contact with the bottom surface of the conductor 260. The insulator 275a includes a region in contact with the side surface of the insulator 250a, a region in contact with the bottom surface of the insulator 250a, a region in contact with the side surface of the opening in the oxide 230, and a region in contact with the side surface of the opening in the conductor 242b. In such a structure, each of the insulator 275a and the insulator 250a can be regarded as having a depressed portion.

FIG. 5D corresponds to the X-Y plane taken at the center of the oxide 230b or in the vicinity of the center. In the case where the cross-sectional shape of the conductor 260 in FIG. 5D is a circle, the insulator 250a is provided on the outer side of the conductor 260 to make a concentric circle shape, the insulator 275a is provided on the outer side of the insulator 250a to make a concentric circle shape, the oxide 230b is provided on the outer side of the insulator 275a to make a concentric circle shape, and the insulator 275b is provided on the outer side of the oxide 230b to make a concentric circle shape.

Here, the width of the oxide 230b in the direction from the center of the hollow portion of the oxide 230b toward the outer periphery of the cylindrical shape is denoted by a width H1. In other words, the width H1 is half a difference between the outer diameter and the inner diameter of the hollow cylindrical shape.

In order to prevent the adjacent oxides 230b from being in contact with each other, the width H1 needs to be made smaller than half the minimum feature size (F). Meanwhile, in order to form the oxide 230b with a hollow cylindrical shape, it is necessary to secure the width H1 having a certain value. When the minimum feature size (F) is 15 nm, for example, the width H1 is preferably greater than or equal to 1 nm and less than or equal to 7 nm, further preferably greater than or equal to 1.5 nm and less than or equal to 6 nm, still further preferably greater than or equal to 2 nm and less than or equal to 5 nm. With such a structure, the adjacent oxides 230b are not in contact with each other and at least the insulator 275b can be provided between the adjacent oxides 230b. Note that the preferable range of the width H1 is not limited to the above. The width H1 is set as appropriate in consideration of the minimum feature size, the thickness of the insulator 275b, and the like.

Although the top surfaces of the oxide 230 and the conductor 242b in FIG. 5D have a hollow circular shape, the present invention is not limited thereto. For example, the top surfaces of the oxide 230 and the conductor 242b may have a hollow elliptical shape, a hollow polygonal shape, or a hollow polygonal shape with rounded corners.

The oxide 230 includes a region overlapping with the conductor 242a. Specifically, the oxide 230a includes a region in contact with the top surface of the conductor 242a. The oxide 230 overlaps with the conductor 242b. Specifically, the oxide 230c is in contact with the bottom surface of the conductor 242b. The conductor 242b includes a region in contact with the conductor 246. In other words, the conductor 260 includes a region in contact with the conductor 262.

The uppermost portion of the insulator 250a is level or substantially level with the uppermost portion of the insulator 275a, the uppermost portion of the insulator 275b, and the uppermost portion of the insulator 250b.

The insulator 276 is provided over the insulator 275a and the insulator 250a. The conductor 262 is placed over the insulator 276. Thus, the insulator 276 is provided between the conductor 262 and the insulator 275a or the insulator 250a. The insulator 276 includes a region overlapping with the insulator 275a and the insulator 250a. The insulator 276 includes a region in contact with the bottom surface of the conductor 262. In other words, at least part of the bottom surface of the conductor 262 is in contact with the top surface of the insulator 276.

The insulator 276 functions as an interlayer film. The insulator 276 has a cylindrical shape and has an opening. Thus, the insulator 276 has a cylindrical shape provided with a hollow portion. In other words, the top surface of the insulator 276 has a hollow circular shape. The conductor 260 is provided in the hollow portion of the insulator 276. When the cross-sectional shape of the conductor 260 is a circular shape, the insulator 276 is provided on the outer side of the conductor 260 to make a concentric circle shape.

In the top view, the outer periphery of the hollow portion of the insulator 276 is preferably the same as or larger than the outer periphery of the region of the conductor 260 that overlaps with the oxide 230b. With such a structure, the conductor 260 can be surely embedded in a depressed portion of the insulator 250a.

The outline of the cylindrical shape of the insulator 276 is preferably aligned or substantially aligned with the outline of the insulator 275a. With such a structure, the area where the conductor 242b and the conductor 246 are in contact with each other can be made larger than that in a structure where the outline of the cylindrical shape of the insulator 276 is larger than the outline of the insulator 275a. Furthermore, with such a structure, the distance between the conductor 262 and the conductor 246 can be made larger than that in a structure where the outline of the cylindrical shape of the insulator 276 is smaller than that of the insulator 275a. Thus, leakage current and a short circuit between the conductor 262 and the conductor 246 can be prevented.

The insulator 276 preferably extends in the Z direction so that the top surface of the conductor 246 is positioned between the bottom surface and the top surface of the insulator 276. In other words, the insulator 276 preferably extends in the Z direction so that the top surface of the conductor 246 is positioned above the bottom surface of the insulator 276 and positioned below the top surface of the insulator 276. With such a structure, the conductor 262 and the conductor 246 can be prevented from being in contact with each other, whereby leakage current and a short circuit between the conductor 262 and the conductor 246 can be prevented.

The insulator 277 is provided over the conductor 246. As illustrated in FIG. 5E, the end portions of the insulator 277 and the conductor 246 are aligned or substantially aligned with each other.

The conductor 260 functions as a gate electrode. The insulator 275a and the insulator 250a function as a gate insulator. The conductor 242a functions as one of a source electrode and a drain electrode, and the conductor 242b functions as the other of the source electrode and the drain electrode. At least part of a region of the oxide 230 that overlaps with the conductor 260 functions as a channel formation region. Note that a region of the oxide 230 that overlaps with the conductor 260 can be rephrased as a region of the oxide 230 that faces the conductor 260 with the insulator 275a and the insulator 250a therebetween. For example, the oxide 230b functions as a channel formation region, the oxide 230a functions as one of a source region and a drain region, and the oxide 230c functions as the other of the source region and the drain region.

In the transistor 200, a metal oxide functioning as a semiconductor is preferably used as the oxide 230b including a channel formation region. Note that part of a region of the oxide 230a or the oxide 230c that overlaps with the conductor 260 functions as a channel formation region in some cases.

Although in the transistor 200 in FIG. 5B, the oxide 230 has a stacked-layer structure of the oxide 230a, the oxide 230b, and the oxide 230c, the present invention is not limited thereto. For example, the oxide 230 may have a single-layer structure or a stacked-layer structure of two or four or more layers.

Here, the oxide 230 corresponds to the oxide 30 described in Embodiment 1. Specifically, the oxide 230a corresponds to the oxide 30a described in Embodiment 1, the oxide 230b corresponds to the oxide 30b described in Embodiment 1, and the oxide 230c corresponds to the oxide 30c described in Embodiment 1. Thus, for the materials, structures, and the like of the oxide 230 (the oxide 230a, the oxide 230b, and the oxide 230c), those of the oxide 30 (the oxide 30a, the oxide 30b, and the oxide 30c) described in Embodiment 1 can be referred to.

The insulator 216, the insulator 274, the insulator 276, the insulator 277, the insulator 278, and the insulator 285 preferably have low dielectric constants. When a material with a low dielectric constant is used for an interlayer film, parasitic capacitance generated between wirings can be reduced. For example, for the insulator 216, the insulator 274, the insulator 276, the insulator 277, the insulator 278, and the insulator 285, silicon oxide, silicon oxynitride, silicon nitride oxide, silicon nitride, silicon oxide to which fluorine is added, silicon oxide to which carbon is added, silicon oxide to which carbon and nitrogen are added, porous silicon oxide, a resin, or the like is used as appropriate. Examples of the resin include polyester, polyolefin, polyamide (e.g., nylon and aramid), polyimide, polycarbonate, and acrylic.

The conductor 242a includes a region overlapping with the oxide 230. More specifically, the conductor 242a is placed to be in contact with at least part of the oxide 230a. Here, the conductor 242a is preferably provided to be embedded in an opening in the insulator 216. As illustrated in FIG. 5A, the center of the conductor 242a is not aligned with the center of the hollow cylindrical shape of the oxide 230 in the top view. Note that the center of the conductor 242a may be aligned with the center of the hollow cylindrical shape of the oxide 230.

The conductor 242a includes the conductor 242a1 and the conductor 242a2. The conductor 242a1 is provided in contact with the bottom surface and the side wall of the opening provided in the insulator 216. The conductor 242a2 is provided to be embedded in a depressed portion formed in the conductor 242a1. Here, the top surface of the conductor 242a2 is level or substantially level with the top surface of the conductor 242a1 and the top surface of the insulator 216.

Here, it is preferable for the conductor 242a1 to use a conductive material having a function of inhibiting diffusion of oxygen (e.g., at least one of an oxygen atom, an oxygen molecule, and the like). For the conductor 242a1, it is preferable to use a conductive material having a function of inhibiting diffusion of impurities such as a hydrogen atom, a hydrogen molecule, a water molecule, a nitrogen atom, a nitrogen molecule, a nitrogen oxide molecule (e.g., N₂O, NO, NO₂), and a copper atom.

When the conductor 242a1 is formed using a conductive material having a function of inhibiting diffusion of oxygen, the conductivity of the conductor 242a2 can be inhibited from being lowered because of oxidation. As the conductive material having a function of inhibiting diffusion of oxygen, for example, titanium, titanium nitride, tantalum, tantalum nitride, ruthenium, or ruthenium oxide is preferably used. Thus, the conductor 242a1 is a single layer or stacked layers of the above conductive materials. For example, titanium nitride is used for the conductor 242a1.

Moreover, a conductive material containing tungsten, copper, or aluminum as its main component is preferably used for the conductor 242a2. For example, tungsten is used for the conductor 242a2.

The electric resistivity of the conductor 242a is designed in consideration of the potential applied to the conductor 242a, and the thickness of the conductor 242a is determined in accordance with the electric resistivity. The thickness of the insulator 216 is substantially equal to that of the conductor 242a. The conductor 242a and the insulator 216 are preferably as thin as possible in the allowable range of the design of the conductor 242a. When the thickness of the insulator 216 is reduced, the absolute amount of impurities such as hydrogen contained in the insulator 216 can be reduced, inhibiting the diffusion of the impurity into the oxide 230.

Although the conductor 242a in FIG. 5B has a structure where the conductor 242a1 and the conductor 242a2 are stacked, the present invention is not limited to this structure. For example, the conductor 242a may have a single-layer structure or a stacked-layer structure of three or more layers.

Note that the conductor 242a corresponds to the conductor 42a described in Embodiment 1. Thus, for the material, structure, and the like of the conductor 242a, those of the conductor 42a described in Embodiment 1 can be referred to.

The conductor 242b overlaps with the oxide 230. More specifically, the conductor 242b is provided in contact with the top surface of the oxide 230c.

For the conductor 242b, for example, a nitride containing tantalum, a nitride containing titanium, a nitride containing molybdenum, a nitride containing tungsten, a nitride containing tantalum and aluminum, a nitride containing titanium and aluminum, or the like is preferably used. In one embodiment of the present invention, a nitride containing tantalum is particularly preferable. As another example, ruthenium oxide, ruthenium nitride, an oxide containing strontium and ruthenium, or an oxide containing lanthanum and nickel may be used. These materials are preferable because they are each a conductive material that is not easily oxidized or a material that maintains the conductivity even after absorbing oxygen.

Although the conductor 242b in FIG. 5B has a single layer, the present invention is not limited to this structure. The conductor 242b may have a stacked-layer structure of two or more layers. For example, the conductor 242b may have a stacked-layer structure of two layers including a lower layer over the oxide 230c and an upper layer.

The lower layer of the conductor 242b is preferably formed using a conductive material that is less likely to be oxidized. Accordingly, it is possible to inhibit the oxidation of the lower layer of the conductor 242b and a reduction in the conductivity of the conductor 242b. Note that the lower layer of the conductor 242b may have such a property that is likely to absorb hydrogen (likely to extract hydrogen). Accordingly, hydrogen in the oxide 230 can be diffused into the lower layer of the conductor 242b, so that the hydrogen concentration in the oxide 230 can be reduced. As a result, the transistor 200 can have stable electric characteristics.

The upper layer of the conductor 242b is preferably formed using a conductive material with higher conductivity than that of the lower layer of the conductor 242b. In that case, at least part of the upper layer of the conductor 242b includes a region having higher conductivity than the lower layer of the conductor 242b. Furthermore, the upper layer of the conductor 242b is preferably formed using a conductive material with lower resistivity than that of the lower layer of the conductor 242b. As a result, a semiconductor device with reduced wiring delay can be fabricated.

Note that the upper layer of the conductor 242b may have such a property that is likely to absorb hydrogen. Accordingly, hydrogen absorbed by the lower layer of the conductor 242b is also diffused into the upper layer of the conductor 242b, so that the hydrogen concentration in the oxide 230 can be further reduced. As a result, the transistor 200 can have stable electric characteristics.

Here, for the lower layer of the conductor 242b and the upper layer of the conductor 242b, it is preferable to use conductive materials with the same constituent element and different chemical compositions. In this case, the lower layer of the conductor 242b and the upper layer of the conductor 242b can be deposited successively without being exposed to an atmospheric environment. By the deposition without exposure to the atmosphere, impurities or moisture from the atmospheric environment can be prevented from being attached onto the surface of the lower layer of the conductor 242b, so that the vicinity of the interface between the lower layer of the conductor 242b and the upper layer of the conductor 242b can be kept clean.

For example, a nitride containing tantalum with a high atomic ratio of nitrogen to tantalum is preferably used for the lower layer of the conductor 242b, and a nitride containing tantalum with a low atomic ratio of nitrogen to tantalum is preferably used for the upper layer of the conductor 242b. For example, the lower layer of the conductor 242b is formed using a nitride containing tantalum with an atomic ratio of nitrogen to tantalum being greater than or equal to 1.0 and less than or equal to 2.0, preferably greater than or equal to 1.1 and less than or equal to 1.8, further preferably greater than or equal to 1.2 and less than or equal to 1.5. For example, the upper layer of the conductor 242b is formed using a nitride containing tantalum with an atomic ratio of nitrogen to tantalum being greater than or equal to 0.3 and less than or equal to 1.5, preferably greater than or equal to 0.5 and less than or equal to 1.3, further preferably greater than or equal to 0.6 and less than or equal to 1.0.

The high atomic ratio of nitrogen to tantalum in a nitride containing tantalum can inhibit oxidation of the nitride containing tantalum. In addition, the oxidation resistance of the nitride containing tantalum can be improved. Moreover, the diffusion of oxygen into the nitride containing tantalum can be inhibited. Hence, the nitride containing tantalum with a high atomic ratio of nitrogen to tantalum is preferably used for the lower layer of the conductor 242b. It is thus possible to prevent an oxide layer from being formed between the lower layer of the conductor 242b and the oxide 230 or reduce the thickness of the oxide layer.

The low atomic ratio of nitrogen to tantalum in a nitride containing tantalum can reduce the resistivity of the nitride. Hence, the nitride containing tantalum with a low atomic ratio of nitrogen to tantalum is preferably used for the upper layer of the conductor 242b. As a result, a semiconductor device with reduced wiring delay can be fabricated.

Note that the boundary between the upper layer and the lower layer of the conductor 242b is difficult to clearly detect in some cases. In the case where a nitride containing tantalum is used for the conductor 242b, the tantalum concentration and the nitrogen concentration detected in each layer may gradually change within each layer and may also change continuously (or in a gradation manner) in a region between the upper layer and the lower layer. That is, the atomic ratio of nitrogen to tantalum is preferably higher in the region of the conductor 242b that is closer to the oxide 230. Thus, the atomic ratio of nitrogen to tantalum in a region positioned below the conductor 242b is preferably higher than the atomic ratio of nitrogen to tantalum in a region positioned above the conductor 242b.

The thickness of the lower layer of the conductor 242b is greater than or equal to 0.1 nm and less than or equal to 5.0 nm, preferably greater than or equal to 0.5 nm and less than or equal to 3.0 nm, further preferably greater than or equal to 1.0 nm and less than or equal to 3.0 nm. In this case, at least part of the lower layer of the conductor 242b preferably includes a region having the above-described thickness. Furthermore, the thickness of the lower layer of the conductor 242b is preferably smaller than the thickness of the upper layer of the conductor 242b. In that case, at least part of the lower layer of the conductor 242b includes a region having a smaller thickness than the upper layer of the conductor 242b.

In the above, conductive materials having the same constituent element and having different chemical compositions are used for the lower layer of the conductor 242b and the upper layer of the conductor 242b; however, the present invention is not limited thereto, and the lower layer of the conductor 242b and the upper layer of the conductor 242b may be formed using different conductive materials. For example, a nitride containing tantalum may be used for the lower layer of the conductor 242b, and a nitride containing titanium may be used for the upper layer of the conductor 242b.

Note that the conductor 242b corresponds to the conductor 42b described in Embodiment 1. Thus, for the material, structure, and the like of the conductor 242b, those of the conductor 42b described in Embodiment 1 can be referred to for.

The insulator 275a is positioned on inner sides of the opening in the oxide 230 and the opening in the conductor 242b (in the hollow portions of the oxide 230 and the conductor 242b) in the top view. The insulator 275a functions as part of the gate insulator.

The insulator 275b is placed outside the cylindrical shapes of the oxide 230 and the conductor 242b in the top view.

The insulator 275a and the insulator 275b are formed through the same step, which will be described in detail. Thus, the insulator 275a and the insulator 275b contain the same material.

For the insulator 275a and the insulator 275b, a barrier insulating film against oxygen is preferably used. An insulator containing an oxide of one or both of aluminum and hafnium is preferably used for the insulator 275a and the insulator 275b, for example. As the insulator, aluminum oxide, hafnium oxide, an oxide containing aluminum and hafnium (hafnium aluminate), an oxide containing hafnium and silicon (hafnium silicate), or the like can be used. In this embodiment, aluminum oxide is used for the insulator 275a and the insulator 275b. In this case, the insulator 275a and the insulator 275b each contain at least oxygen and aluminum.

As illustrated in FIG. 5D, the insulator 275a is provided in contact with the side surface of the opening of the oxide 230. The insulator 275b is provided in contact with the outer side surface of the oxide 230. That is, the oxide 230 is covered with the insulator 275a and the insulator 275b. With this structure, the insulator 275a and the insulator 275b each having a barrier property against oxygen can prevent release of oxygen from the oxide 230 at the time of heat treatment or the like. This can inhibit formation of oxygen vacancies in the oxide 230. Thus, the amount of oxygen vacancies and VoH formed in the oxide 230 can be reduced. Thus, the transistor 200 can have favorable electrical characteristics and higher reliability.

Even when an excess amount of oxygen is contained in the insulator 274, the insulator 250a, and the like, oxygen can be inhibited from being excessively supplied to the oxide 230. Thus, the oxide 230a and the oxide 230c are inhibited from being excessively oxidized; a reduction in on-state current or field-effect mobility of the transistor 200 can be inhibited.

As illustrated in FIG. 5B, the insulator 275a is provided in contact with the side surface of the conductor 242b in the opening, and the insulator 275b is provided in contact with the outer side surface of the conductor 242b. That is, the conductor 242b is covered with the insulator 275a and the insulator 275b. This can inhibit formation of an oxide film on the side surfaces of the conductor 242b by oxidization of the side surfaces. Accordingly, a reduction in on-state current or field-effect mobility of the transistor 200 can be inhibited.

In the case where aluminum oxide is used for the insulator 275a and the insulator 275b, aluminum is added to the region of the oxide 230b in contact with the insulator 275a and the vicinity thereof, and the region of the oxide 230b in contact with the insulator 275b and the vicinity thereof, in some cases. For example, in the case where IGZO is used as the oxide 230b, the region of the oxide 230b in contact with the insulator 275a and the vicinity thereof, and the region in contact with the insulator 275b and the vicinity thereof contain indium, gallium, aluminum, and zinc in some.

As illustrated in FIG. 5B or the like, the insulator 275a formed using aluminum oxide or the like is provided in contact with the side surface of the oxide 230b in the opening portion, whereby indium contained in the oxide 230b is unevenly distributed, in some cases, at the interface between the oxide 230b and the insulator 275a and in its vicinity. Accordingly, the vicinity of the surface of the oxide 230 on the opening side comes to have an atomic ratio close to that of an indium oxide or that of an In-Zn oxide. Such an increase in the atomic ratio of indium in the vicinity of the surface of the oxide 230b on the opening side can increase the field-effect mobility of the transistor 200.

The insulator 275a needs to be provided in the openings formed in the conductor 242b and the oxide 230, together with the insulator 250a and the conductor 260. The thickness of the insulator 275a is preferably thin for miniaturization of the transistor 200. The thickness of the insulator 275a is greater than or equal to 0.1 nm and less than or equal to 5.0 nm, preferably greater than or equal to 0.5 nm and less than or equal to 3.0 nm, further preferably greater than or equal to 1.0 nm and less than or equal to 3.0 nm. In this case, at least part of the insulator 275a preferably includes a region having the above-described thickness. The thickness of the insulator 275a is preferably smaller than that of the insulator 250a. In this case, at least part of the insulator 275a preferably includes a region having a thickness smaller than that of the insulator 250a.

To form the insulator 275a having a small thickness like the above-described thickness, an ALD method is preferably used for deposition of the insulator 275a. Examples of an ALD method include a thermal ALD method, in which a precursor and a reactant react with each other only by a thermal energy, and a PEALD (Plasma Enhanced ALD) method, in which a reactant excited by plasma is used. The use of plasma in a PEALD method is sometimes preferable because deposition at a lower temperature is possible.

An ALD method, which enables an atomic layer to be deposited one by one using self-limiting characteristics by atoms, has advantages such as deposition of an extremely thin film, deposition on a component with a high aspect ratio, deposition of a film with a small number of defects such as pinholes, deposition with excellent coverage, and low-temperature deposition. Therefore, the insulator 275a can be deposited on the side surfaces of the openings formed in the conductor 242b and the oxide 230 to have a small thickness like the above-described thickness and to have favorable coverage.

Note that some of precursors usable in an ALD method contain carbon or the like. For that reason, in some cases, a film provided by the ALD method contains impurities such as carbon in a larger amount than a film provided by another deposition method. Note that impurities can be quantified by secondary ion mass spectrometry (SIMS), X-ray photoelectron spectroscopy (XPS), or auger electron spectroscopy (AES).

As described above, the insulator 275a and the insulator 275b are formed through the same step. Thus, the thickness of the insulator 275b is equal to that of the insulator 275a.

The insulator 250a is placed in a depressed portion of the insulator 275a. The insulator 250a functions as part of the gate insulator.

The insulator 250b is placed in contact with the top surface of the insulator 275b.

The insulator 250a and the insulator 250b are formed through the same step, which will be described later in detail. Thus, the insulator 250a and the insulator 250b contain the same material.

The insulator 250a and the insulator 250b are preferably formed using an insulator having a function of inhibiting diffusion of oxygen. Such a structure can inhibit oxidation of the conductor 260 due to oxygen contained in the oxide 230. For example, an insulator containing an oxide of one or both of aluminum and hafnium is preferably used as the insulator 250a and the insulator 250b. As the insulator, aluminum oxide, hafnium oxide, an oxide containing aluminum and hafnium (hafnium aluminate), an oxide containing hafnium and silicon (hafnium silicate), or the like can be used.

The insulator 250a and the insulator 250b may be formed using a high dielectric constant (high-k) material. In this case, the equivalent oxide thickness (EOT) of the insulator functioning as the gate insulator can be reduced. Therefore, the breakdown voltage of the gate insulator can be increased.

As the insulator 250a and the insulator 250b, silicon oxide, silicon oxynitride, silicon nitride oxide, silicon nitride, silicon oxide to which fluorine is added, silicon oxide to which carbon is added, silicon oxide to which carbon and nitrogen are added, porous silicon oxide, or the like is used as appropriate, for example.

In this embodiment, hafnium oxide is used for the insulator 250a and the insulator 250b. In this case, the insulator 250a and the insulator 250b contains at least oxygen and hafnium.

As described above, the insulator 250a and the insulator 250b are formed through the same step. Thus, the thickness of the insulator 250b is equal to that of the insulator 250a.

The insulator 250a and the insulator 275a correspond to the insulator 50 having a stacked-layer structure of two layers, which is described in Embodiment 1. Thus, for the materials, structures, and the like of the insulator 250a and the insulator 275a, those of the insulator 50 described in Embodiment 1 can be referred to.

The conductor 260 is placed in a depressed portion of the insulator 250a. The conductor 260 functions as the gate electrode of the transistor 200.

For the conductor 260, for example, a nitride containing tantalum, a nitride containing titanium, a nitride containing molybdenum, a nitride containing tungsten, a nitride containing tantalum and aluminum, a nitride containing titanium and aluminum, ruthenium nitride, or the like is preferably used. As another example, ruthenium oxide, an oxide containing strontium and ruthenium, or an oxide containing lanthanum and nickel may be used. These materials are each a conductive material that is not easily oxidized or a material that maintains the conductivity even after absorbing oxygen; accordingly they are preferable in which case an insulating material containing oxygen is used for the insulator 250a in contact with the conductor 260.

For the conductor 260, a conductive material having a function of inhibiting diffusion of impurities such as a hydrogen atom, a hydrogen molecule, a water molecule, a nitrogen atom, a nitrogen molecule, a nitrogen oxide molecule, and a copper atom is preferably used. Alternatively, it is preferable to use a conductive material having a function of inhibiting diffusion of oxygen (e.g., at least one of an oxygen atom, an oxygen molecule, and the like). As the conductive material having a function of inhibiting diffusion of oxygen, for example, titanium, titanium nitride, tantalum, tantalum nitride, ruthenium, ruthenium oxide, or the like can be given.

In the transistor 200, the conductor 260 is formed in a self-aligned manner to fill the openings in the oxide 230 and the conductor 242b.

Although the conductor 260 in FIG. 5B is a single layer, the present invention is not limited to this. For example, the conductor 260 may have a stacked-layer structure of two or more layers.

Note that the conductor 260 corresponds to the conductor 60 described in Embodiment 1. Thus, for the material, structure, and the like of the conductor 260, those of the conductor 60 described in Embodiment 1 can be referred to.

The conductor 246 is placed over the conductor 242b. The conductor 246 is placed in contact with at least part of the top surface of the conductor 242b. The conductor 246 has a projecting portion in a region overlapping with the conductor 242b. The conductor 246 functions as a wiring.

The conductor 246 is preferably formed using a conductive material containing tungsten, copper, or aluminum as its main component. The conductor 246 may have a stacked-layer structure; for example, stacked layers of titanium or titanium nitride and the above-described conductive material may be employed.

Note that the conductor 246 corresponds to the conductor 46 described in Embodiment 1. Thus, for the material, structure, and the like of the conductor 246, those of the conductor 46 described in Embodiment 1 can be referred to.

The conductor 262 is placed over the conductor 260. The conductor 262 is placed in contact with the top surface of the conductor 260. The conductor 262 functions as a wiring.

The conductor 262 preferably includes the conductor 262a and the conductor 262b placed over the conductor 262a. For example, the conductor 262a is preferably placed to cover the bottom surface and the side surface of the conductor 262b. Moreover, as illustrated in FIG. 5B, the top surface of the conductor 262 is substantially level with the top surface of the insulator 285. Note that although the conductor 262 in FIG. 5B has a two-layer structure of the conductor 262a and the conductor 262b, the conductor 262 can have a single-layer structure or a stacked-layer structure of three or more layers.

For the conductor 262a, a conductive material having a function of inhibiting diffusion of impurities such as a hydrogen atom, a hydrogen molecule, a water molecule, a nitrogen atom, a nitrogen molecule, a nitrogen oxide molecule, and a copper atom is preferably used. Alternatively, it is preferable to use a conductive material having a function of inhibiting diffusion of oxygen (e.g., at least one of an oxygen atom, an oxygen molecule, and the like).

In addition, when the conductor 262a has a function of inhibiting diffusion of oxygen, the conductivity of the conductor 262b can be inhibited from being lowered because of oxidation due to oxygen contained in the insulator 285. As the conductive material having a function of inhibiting diffusion of oxygen, for example, titanium, titanium nitride, tantalum, tantalum nitride, ruthenium, or ruthenium oxide is preferably used.

The conductor 262 functions as a wiring and thus is preferably formed using a conductor having high conductivity. For example, a conductive material containing tungsten, copper, or aluminum as its main component can be used for the conductor 262b. The conductor 262b may have a stacked-layer structure; for example, a stacked-layer structure of the above conductive material and titanium or titanium nitride may be employed.

Note that the conductor 262 corresponds to the conductor 62 described in Embodiment 1. Thus, for the material, the structure, and the like of the conductor 262, those of the conductor 62 described in Embodiment 1 can be referred to.

### <Materials for semiconductor device>

Component materials that can be used for the semiconductor device are described below.

### [Substrate]

As a substrate where the transistor 200 is formed, an insulator substrate, a semiconductor substrate, or a conductor substrate may be used, for example. Examples of the insulator substrate include a glass substrate, a quartz substrate, a sapphire substrate, a stabilized zirconia substrate (e.g., an yttria-stabilized zirconia substrate), and a resin substrate. Examples of the semiconductor substrate include a semiconductor substrate using silicon or germanium as a material and a compound semiconductor substrate including silicon carbide, silicon germanium, gallium arsenide, indium phosphide, zinc oxide, or gallium oxide. Another example is a semiconductor substrate having an insulator region in the semiconductor substrate described above, e.g., an SOI (Silicon On Insulator) substrate. Examples of the conductor substrate include a graphite substrate, a metal substrate, an alloy substrate, and a conductive resin substrate. Other examples include a substrate including a metal nitride and a substrate including a metal oxide. Other examples include an insulator substrate provided with a conductor or a semiconductor, a semiconductor substrate provided with a conductor or an insulator, and a conductor substrate provided with a semiconductor or an insulator. Alternatively, these substrates provided with elements may be used. Examples of the element provided for the substrate include a capacitor element, a resistor, a switching element, a light-emitting element, and a storage element.

### [Insulator]

Examples of the insulator include an insulating oxide, an insulating nitride, an insulating oxynitride, an insulating nitride oxide, an insulating metal oxide, an insulating metal oxynitride, and an insulating metal nitride oxide.

As miniaturization and high integration of transistors progress, for example, a problem such as a leakage current may arise because of a thinner gate insulator. When a high-k material is used for the insulator functioning as a gate insulator, the voltage at the time of the operation of the transistor can be reduced while the physical thickness is maintained. In contrast, when a material with a low dielectric constant is used for the insulator functioning as an interlayer film, parasitic capacitance generated between wirings can be reduced. Thus, a material is preferably selected depending on the function of an insulator.

Examples of the insulator with a high dielectric constant include gallium oxide, hafnium oxide, zirconium oxide, an oxide containing aluminum and hafnium, an oxynitride containing aluminum and hafnium, an oxide containing silicon and hafnium, an oxynitride containing silicon and hafnium, and a nitride containing silicon and hafnium.

Examples of the insulator with a low dielectric constant include silicon oxide, silicon oxynitride, silicon nitride oxide, silicon nitride, silicon oxide to which fluorine is added, silicon oxide to which carbon is added, silicon oxide to which carbon and nitrogen are added, porous silicon oxide, and a resin.

When a transistor including a metal oxide is surrounded by an insulator having a function of inhibiting passage of oxygen and impurities such as hydrogen, the transistor can have stable electrical characteristics. As the insulator having a function of inhibiting passage of oxygen and impurities such as hydrogen, a single layer or stacked layers of an insulator containing, for example, boron, carbon, nitrogen, oxygen, fluorine, magnesium, aluminum, silicon, phosphorus, chlorine, argon, gallium, germanium, yttrium, zirconium, lanthanum, neodymium, hafnium, or tantalum are used. Specifically, as the insulator having a function of inhibiting passage of oxygen and impurities such as hydrogen, a metal oxide such as aluminum oxide, magnesium oxide, gallium oxide, germanium oxide, yttrium oxide, zirconium oxide, lanthanum oxide, neodymium oxide, hafnium oxide, or tantalum oxide; or a metal nitride such as aluminum nitride, silicon nitride oxide, or silicon nitride can be used.

The insulator functioning as the gate insulator is preferably an insulator including a region containing oxygen to be released by heating. For example, when a structure is employed in which silicon oxide or silicon oxynitride including a region containing oxygen to be released by heating is in contact with the oxide 230, oxygen vacancies included in the oxide 230 can be compensated for.

### [Conductor]

As a conductor, it is preferable to use a metal element selected from aluminum, chromium, copper, silver, gold, platinum, tantalum, nickel, titanium, molybdenum, tungsten, hafnium, vanadium, niobium, manganese, magnesium, zirconium, beryllium, indium, ruthenium, iridium, strontium, lanthanum, and the like; an alloy containing any of the above metal elements; an alloy containing a combination of the above metal elements; or the like. For example, it is preferable to use tantalum nitride, titanium nitride, tungsten, a nitride containing titanium and aluminum, a nitride containing tantalum and aluminum, ruthenium oxide, ruthenium nitride, an oxide containing strontium and ruthenium, an oxide containing lanthanum and nickel, or the like. Tantalum nitride, titanium nitride, a nitride containing titanium and aluminum, a nitride containing tantalum and aluminum, ruthenium oxide, ruthenium nitride, an oxide containing strontium and ruthenium, and an oxide containing lanthanum and nickel are preferable because they are oxidation-resistant conductive materials or materials that maintain their conductivity even after absorbing oxygen. Alternatively, a semiconductor having high electrical conductivity, typified by polycrystalline silicon containing an impurity element such as phosphorus, or silicide such as nickel silicide may be used.

A stack of a plurality of conductive layers formed of the above materials may be used. For example, a stacked-layer structure combining a material containing the above metal element and a conductive material containing oxygen may be employed. In addition, a stacked-layer structure combining a material containing the above metal element and a conductive material containing nitrogen may be employed. Furthermore, a stacked-layer structure combining a material containing the above metal element, a conductive material containing oxygen, and a conductive material containing nitrogen may be employed.

In the case where an oxide is used for the channel formation region of the transistor, the conductor functioning as the gate electrode preferably employs a stacked-layer structure combining a material containing the above metal element and a conductive material containing oxygen. In that case, the conductive material containing oxygen is preferably provided on the channel formation region side. When the conductive material containing oxygen is provided on the channel formation region side, oxygen released from the conductive material is easily supplied to the channel formation region.

It is particularly preferable to use, for the conductor functioning as the gate electrode, a conductive material containing oxygen and a metal element contained in the metal oxide where the channel is formed. A conductive material containing the above metal element and nitrogen may be used. For example, a conductive material containing nitrogen, such as titanium nitride or tantalum nitride, may be used. Indium tin oxide, indium oxide containing tungsten oxide, indium zinc oxide containing tungsten oxide, indium oxide containing titanium oxide, indium tin oxide containing titanium oxide, indium zinc oxide, or indium tin oxide to which silicon is added may be used. Indium gallium zinc oxide containing nitrogen may be used. With use of such a material, hydrogen contained in the metal oxide where the channel is formed can be captured in some cases. Alternatively, hydrogen entering from an external insulator or the like can be captured in some cases.

### [Metal oxide]

The oxide 230 is preferably formed using a metal oxide functioning as a semiconductor (an oxide semiconductor). A metal oxide that can be used as the oxide 230 of the present invention is described below.

Amorphous (including a completely amorphous structure), CAAC (c-axis-aligned crystalline), nc (nanocrystalline), single crystal, and polycrystalline (poly crystal) structures can be given as examples of a crystal structure of an oxide semiconductor.

Note that a crystal structure of a film or a substrate can be evaluated with an X-ray diffraction (XRD) spectrum. For example, evaluation is possible using an XRD spectrum which is obtained by GIXD (Grazing-Incidence XRD) measurement. Note that a GIXD method is also referred to as a thin film method or a Seemann-Bohlin method. Hereinafter, an XRD spectrum obtained from GIXD measurement is simply referred to as an XRD spectrum in some cases.

For example, the XRD spectrum of a quartz glass substrate shows a peak with a substantially bilaterally symmetrical shape. On the other hand, the peak of the XRD spectrum of the In-Ga-Zn oxide film having a crystal structure has a bilaterally asymmetrical shape. The asymmetrical peak of the XRD spectrum clearly shows the existence of crystal in the film or the substrate. In other words, the crystal structure of the film or the substrate cannot be regarded as "amorphous" unless it has a bilaterally symmetrical peak in the XRD spectrum.

A crystal structure of a film or a substrate can also be evaluated with a diffraction pattern obtained by a nanobeam electron diffraction (NBED) method (such a pattern is also referred to as a nanobeam electron diffraction pattern). For example, a halo pattern is observed in the diffraction pattern of the quartz glass substrate, which indicates that the quartz glass substrate is in an amorphous state. Furthermore, not a halo pattern but a spot-like pattern is observed in the diffraction pattern of the In-Ga-Zn oxide film formed at room temperature. Thus, it is suggested that the In-Ga-Zn oxide film deposited at room temperature is in an intermediate state, which is neither a single crystal nor polycrystal nor an amorphous state, and it cannot be concluded that In-Ga-Zn oxide film is in an amorphous state.

Oxide semiconductors might be classified in a manner different from the one described above when classified in terms of the structure. Oxide semiconductors are classified into a single crystal oxide semiconductor and a non-single-crystal oxide semiconductor, for example. Examples of the non-single-crystal oxide semiconductor include the above-described CAAC-OS and nc-OS. Other examples of the non-single-crystal oxide semiconductor include a polycrystalline oxide semiconductor, an amorphous-like oxide semiconductor (a-like OS), and an amorphous oxide semiconductor.

Here, the above-described CAAC-OS, nc-OS, and a-like OS are described in detail.

### «CAAC-OS»

The CAAC-OS is an oxide semiconductor that has a plurality of crystal regions each of which has c-axis alignment in a particular direction. Note that the particular direction refers to the thickness direction of a CAAC-OS film, the normal direction of the surface where the CAAC-OS film is formed, or the normal direction of the surface of the CAAC-OS film. The crystal region refers to a region having a periodic atomic arrangement. When an atomic arrangement is regarded as a lattice arrangement, the crystal region also refers to a region with a uniform lattice arrangement. The CAAC-OS has a region where a plurality of crystal regions are connected in the a-b plane direction, and the region has distortion in some cases. Note that distortion refers to a portion where the direction of a lattice arrangement changes between a region with a uniform lattice arrangement and another region with a uniform lattice arrangement in a region where a plurality of crystal regions are connected. That is, the CAAC-OS is an oxide semiconductor having c-axis alignment and having no clear alignment in the a-b plane direction.

Note that each of the plurality of crystal regions described above is formed of one or more fine crystals (crystals each of which has a maximum diameter of less than 10 nm). In the case where the crystal region is formed of one fine crystal, the maximum diameter of the crystal region is less than 10 nm. In the case where the crystal region is formed of a large number of fine crystals, the maximum diameter of the crystal region may be approximately several tens of nanometers.

In the case of an In-Ga-Zn oxide, the CAAC-OS tends to have a layered crystal structure (also referred to as a layered structure) in which a layer containing indium (In) and oxygen (hereinafter, an In layer) and a layer containing gallium (Ga), zinc (Zn), and oxygen (hereinafter, a (Ga,Zn) layer) are stacked. Indium and gallium can be replaced with each other. Therefore, indium may be contained in the (Ga,Zn) layer. In addition, gallium may be contained in the In layer. Note that zinc may be contained in the In layer. Such a layered structure is observed as a lattice image in a high-resolution TEM (Transmission Electron Microscope) image, for example.

When the CAAC-OS film is subjected to structural analysis by Out-of-plane XRD measurement with an XRD apparatus using *θ*/2*θ* scanning, for example, a peak indicating c-axis alignment is detected at 2*θ* of 31° or around 31°. Note that the position of the peak indicating c-axis alignment (the value of 2*θ*) may change depending on the kind, composition, or the like of the metal element contained in the CAAC-OS.

For example, a plurality of bright spots are observed in the electron diffraction pattern of the CAAC-OS film. Note that one spot and another spot are observed point-symmetrically with a spot of the incident electron beam passing through a sample (also referred to as a direct spot) as the symmetric center.

When the crystal region is observed from the particular direction described above, a lattice arrangement in the crystal region is basically a hexagonal lattice arrangement; however, a unit lattice is not always a regular hexagon and is a non-regular hexagon in some cases. A pentagonal lattice arrangement, a heptagonal lattice arrangement, and the like are included in the distortion in some cases. Note that a clear crystal grain boundary (grain boundary) cannot be observed even in the vicinity of the distortion in the CAAC-OS. That is, formation of a crystal grain boundary is inhibited by the distortion of lattice arrangement. This is probably because the CAAC-OS can tolerate distortion owing to a low density of arrangement of oxygen atoms in the a-b plane direction, an interatomic bond distance changed by substitution of a metal atom, and the like.

A crystal structure in which a clear crystal grain boundary is observed is what is called polycrystal. It is highly probable that the crystal grain boundary becomes a recombination center and captures carriers and thus decreases the on-state current and field-effect mobility of a transistor, for example. Thus, the CAAC-OS in which no clear crystal grain boundary is observed is one of crystalline oxides having a crystal structure suitable for a semiconductor layer of a transistor. Note that Zn is preferably contained to form the CAAC-OS. For example, In-Zn oxide and In-Ga-Zn oxide are suitable because they can inhibit generation of a crystal grain boundary as compared with In oxide.

The CAAC-OS is an oxide semiconductor with high crystallinity in which no clear crystal grain boundary is observed. Thus, in the CAAC-OS, a reduction in electron mobility due to the crystal grain boundary is unlikely to occur. Moreover, since the crystallinity of an oxide semiconductor might be decreased by entry of impurities, formation of defects, or the like, the CAAC-OS can be regarded as an oxide semiconductor that has small amounts of impurities and defects (e.g., oxygen vacancies). Thus, an oxide semiconductor including the CAAC-OS is physically stable. Therefore, the oxide semiconductor including the CAAC-OS is resistant to heat and has high reliability. In addition, the CAAC-OS is stable with respect to high temperature in the manufacturing process (what is called thermal budget). Accordingly, the use of the CAAC-OS for the transistor including a metal oxide in its channel formation region (referred to as an OS transistor in some cases) can extend the degree of freedom of the manufacturing process.

### <<nc-OS>>

In the nc-OS, a microscopic region (e.g., a region with a size greater than or equal to 1 nm and less than or equal to 10 nm, in particular, a region with a size greater than or equal to 1 nm and less than or equal to 3 nm) has a periodic atomic arrangement. In other words, the nc-OS includes a fine crystal. Note that the size of the fine crystal is, for example, greater than or equal to 1 nm and less than or equal to 10 nm, particularly greater than or equal to 1 nm and less than or equal to 3 nm; thus, the fine crystal is also referred to as a nanocrystal. Furthermore, there is no regularity of crystal orientation between different nanocrystals in the nc-OS. Thus, the orientation in the whole film is not observed. Accordingly, in some cases, the nc-OS cannot be distinguished from an a-like OS or an amorphous oxide semiconductor, depending on an analysis method. For example, when an nc-OS film is subjected to structural analysis by Out-of-plane XRD measurement with an XRD apparatus using *θ*/2*θ* scanning, a peak indicating crystallinity is not detected. Furthermore, a diffraction pattern like a halo pattern is observed when the nc-OS film is subjected to electron diffraction (also referred to as selected-area electron diffraction) using an electron beam with a probe diameter greater than the diameter of a nanocrystal (e.g., greater than or equal to 50 nm). Meanwhile, in some cases, a plurality of spots in a ring-like region with a direct spot as the center are observed in the obtained electron diffraction pattern when the nc-OS film is subjected to electron diffraction (also referred to as nanobeam electron diffraction) using an electron beam with a probe diameter nearly equal to or less than the diameter of a nanocrystal (e.g., greater than or equal to 1 nm and less than or equal to 30 nm).

### «a-like OS»

The a-like OS is an oxide semiconductor having a structure between those of the nc-OS and the amorphous oxide semiconductor. The a-like OS contains a void or a low-density region. That is, the a-like OS has lower crystallinity than the nc-OS and the CAAC-OS. Moreover, the a-like OS has higher hydrogen concentration in the film than the nc-OS and the CAAC-OS.

An oxide semiconductor has various structures with different properties. Two or more of the amorphous oxide semiconductor, the polycrystalline oxide semiconductor, the a-like OS, the nc-OS, and the CAAC-OS may be included in an oxide semiconductor of one embodiment of the present invention.

### <<Transistor including oxide semiconductor>>

Next, the case where the above oxide semiconductor is used for a transistor is described.

When the above oxide semiconductor is used for a transistor, a transistor with high field-effect mobility can be achieved. In addition, a transistor having high reliability can be achieved.

An oxide semiconductor having a low carrier concentration is preferably used in a transistor. For example, the carrier concentration of an oxide semiconductor is lower than or equal to 1 × 10¹⁷ cm⁻³, preferably lower than or equal to 1 × 10¹⁵ cm⁻³, further preferably lower than or equal to 1 × 10¹³ cm⁻³, still further preferably lower than or equal to 1 × 10¹¹ cm⁻³, yet further preferably lower than 1 × 10¹⁰ cm⁻³, and higher than or equal to 1 × 10⁻⁹ cm⁻³. In order to reduce the carrier concentration of an oxide semiconductor film, the impurity concentration in the oxide semiconductor film is reduced so that the density of defect states can be reduced. In this specification and the like, a state with a low impurity concentration and a low density of defect states is referred to as a highly purified intrinsic or substantially highly purified intrinsic state. Note that an oxide semiconductor having a low carrier concentration is sometimes referred to as a highly purified intrinsic or substantially highly purified intrinsic oxide semiconductor.

A highly purified intrinsic or substantially highly purified intrinsic oxide semiconductor film has a low density of defect states and thus also has a low density of trap states in some cases.

Charge trapped by the trap states in the oxide semiconductor takes a long time to disappear and might behave like fixed charge. Thus, a transistor whose channel formation region is formed in an oxide semiconductor with a high density of trap states has unstable electrical characteristics in some cases.

Accordingly, in order to obtain stable electrical characteristics of a transistor, reducing the impurity concentration in an oxide semiconductor is effective. In order to reduce the impurity concentration in the oxide semiconductor, it is preferable that the impurity concentration in an adjacent film be also reduced. Examples of impurities include hydrogen, nitrogen, an alkali metal, an alkaline earth metal, iron, nickel, and silicon. Note that an impurity in an oxide semiconductor refers to, for example, elements other than the main components of the oxide semiconductor. For example, an element with a concentration lower than 0.1 atomic% can be regarded as an impurity. The main component in the oxide semiconductor refers to an element contained at least 1atomic% or higher in the oxide semiconductor, for example.

### <<Impurity>>

Here, the influence of each impurity in the oxide semiconductor is described.

When silicon or carbon, which is one of Group 14 elements, is contained in the oxide semiconductor, defect states are formed in the oxide semiconductor. Thus, the concentration of silicon or carbon in the oxide semiconductor (the concentration obtained by Secondary Ion Mass Spectrometry (SIMS)) is set lower than or equal to 2 × 10¹⁸ atoms/cm³, preferably lower than or equal to 2 × 10¹⁷ atoms/cm³.

When the oxide semiconductor contains an alkali metal or an alkaline earth metal, defect states are formed and carriers are generated in some cases. Thus, a transistor using an oxide semiconductor that contains an alkali metal or an alkaline earth metal is likely to have normally-on characteristics. Thus, the concentration of an alkali metal or an alkaline earth metal in the oxide semiconductor, which is obtained by SIMS, is set lower than or equal to 1 × 10¹⁸ atoms/cm³, preferably lower than or equal to 2 × 10¹⁶ atoms/cm³.

Furthermore, when the oxide semiconductor contains nitrogen, the oxide semiconductor easily becomes n-type by generation of electrons serving as carriers and an increase in carrier concentration. As a result, a transistor using an oxide semiconductor containing nitrogen as a semiconductor is likely to have normally-on characteristics. When nitrogen is contained in the oxide semiconductor, a trap state is sometimes formed. This might make the electrical characteristics of the transistor unstable. Therefore, the concentration of nitrogen in the oxide semiconductor, which is obtained by SIMS, is set lower than 5 × 10¹⁹ atoms/cm³, preferably lower than or equal to 5 × 10¹⁸ atoms/cm³, further preferably lower than or equal to 1 × 10¹⁸ atoms/cm³, and still further preferably lower than or equal to 5 × 10¹⁷ atoms/cm³.

Hydrogen contained in the oxide semiconductor reacts with oxygen bonded to a metal atom to be water, and thus forms an oxygen vacancy in some cases. Entry of hydrogen into the oxygen vacancy sometimes generates an electron serving as a carrier. Furthermore, bonding of part of hydrogen to oxygen bonded to a metal atom sometimes causes generation of an electron serving as a carrier. Thus, a transistor using an oxide semiconductor containing hydrogen is likely to have normally-on characteristics. Accordingly, hydrogen in the oxide semiconductor is preferably reduced as much as possible. Specifically, the hydrogen concentration in the oxide semiconductor, which is obtained by SIMS, is set lower than 1 × 10²⁰ atoms/cm³, preferably lower than 1 × 10¹⁹ atoms/cm³, further preferably lower than 5 × 10¹⁸ atoms/cm³, still further preferably lower than 1 × 10¹⁸ atoms/cm³.

When an oxide semiconductor with sufficiently reduced impurities is used for the channel formation region of the transistor, stable electrical characteristics can be given.

### <Variation example of transistor 200>

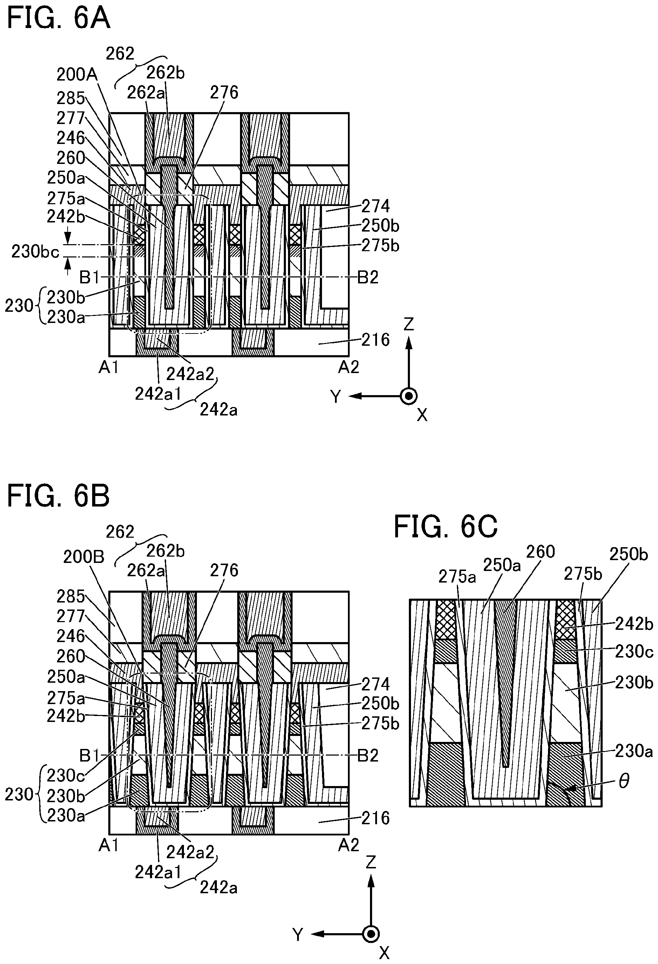

A structure example different from that of the above-described transistor 200 is described below with reference to FIG. 6A to FIG. 7B.

### [Transistor 200A]

FIG. 6A is a cross-sectional view of a semiconductor device including a transistor 200A. Note that the transistor 200A illustrated in FIG. 6A is a variation example of the transistor 200 illustrated in FIG. 5B.

The transistor 200A illustrated in FIG. 6A is different from the transistor 200 illustrated in FIG. 5B in that the oxide 230 has a stacked-layer structure of two layers of the oxide 230a and the oxide 230b.

The oxide 230a functions as one of a source region and a drain region. The oxide 230b includes a channel formation region and a region 230bc functioning as the other of the source region and the drain region.

When heat treatment is performed in the state where the conductor 242b and the oxide 230b are in contact with each other, the sheet resistance of the oxide 230b in the vicinity of conductor 242b is decreased in some cases. Furthermore, the carrier concentration is sometimes increased. Thus, the resistance of the oxide 230b in the vicinity of the conductor 242b is reduced in a self-aligned manner, so that the region 230bc can be formed.

### [Transistor 200B]

FIG. 6B is a cross-sectional view of a semiconductor device including a transistor 200B, and FIG. 6C is an enlarged view of a region including the oxide 230b included in the transistor 200B and its vicinity. The transistor 200B illustrated in FIG. 6B and FIG. 6C is a variation example of the transistor 200 illustrated in FIG. 5B.

The transistor 200B illustrated in FIG. 6B is different from the transistor 200 illustrated in FIG. 5B in the shapes of the oxide 230 and the conductor 242b. Specifically, the transistor 200B illustrated in FIG. 6B is different from the transistor 200 illustrated in FIG. 5B in that the side surfaces of the oxide 230 and the conductor 242b have a tapered shape.

In this specification and the like, a tapered shape indicates a shape in which at least part of the side surface of a structure is inclined to a substrate surface. For example, a tapered shape indicates a shape including a region where an angle between the inclined side surface and the substrate surface (such an angle is also referred to as a taper angle) is less than 90°. Note that the side surface of the component and the substrate surface are not necessarily completely flat and may be substantially flat with a slight curvature or substantially flat with slight unevenness.

As illustrated in FIG. 6C, in a cross-sectional view of the transistor 200B, the side surface of the oxide 230 on the opening side (on the insulator 275a side) may have a tapered shape with a taper angle *θ*. Here, the taper angle *θ* is an angle formed by the side surface of the oxide 230 on the opening side and the substrate surface. Note that one of two sides extending from the vertex of the taper angle *θ* is not limited to the substrate surface and may be the top surface of the insulator 216, the bottom surface of the oxide 230a, or the like. That is, the taper angle *θ* may be an angle formed by the side surface of the oxide 230 and the top surface of the insulator 216 or the bottom surface of the oxide 230a. At this time, the side surface of the oxide 230 on the insulator 275b side also has a tapered shape with the taper angle *θ*.

Note that the closer to 90° the taper angle *θ* is, the deeper portion of the opening in the oxide 230 the conductor 260 can be provided to reach. Thus, a region of the oxide 230 overlapping with the conductor 260 can be increased, so that the electrical characteristics of the transistor can be stable. Furthermore, the area occupied by the transistor 200B can be reduced. For example, the taper angle *θ* is greater than or equal to 80°, greater than or equal to 85°, or greater than or equal to 87° and less than 90°.

In the above structure, the top surface of the oxide 230 has a hollow circular shape. Accordingly, in the above structure, the oxide 230 has a hollow truncated cone shape. Specifically, in the oxide 230 with the truncated cone shape, the area of the upper base surface (the surface on the conductor 242b side) is smaller than the area of the lower base surface (the surface on the insulator 216 side).

When the side surface of the oxide 230 in the hollow portion has a tapered shape in a cross-sectional view of the transistor, the channel width of the transistor does not necessarily have the same value in all regions. In other words, the channel width of the transistor is not fixed to one value in some cases. Thus, in this specification and the like, the channel width is any one of the values, the maximum value, the minimum value, or the average value in a channel formation region.

Like the oxide 230, the conductor 242b has a tapered side surface on the opening side (on the insulator 275a side) and a tapered side surface on the outer side (on the insulator 275b side). Note that the angle formed between the substrate surface and the side surface of the opening in the conductor 242b and the angle formed between the substrate surface and the side surface on the outer side of the conductor 242b are equal or substantially equal to the taper angle *θ*. Depending on the combination of a material used for the oxide 230 and a material used for the conductor 242b, processing conditions of the oxide 230 and the conductor 242b, or the like, the angle formed between the substrate surface and the side surface of the opening in the conductor 242b and the angle formed between the substrate surface and the side surface on the outer side of the conductor 242b are not equal to the taper angle *θ*, in some cases.

In addition, the conductor 242b has a hollow truncated cone shape. Accordingly, in the conductor 242b with the truncated cone shape, the area of the upper base surface (the surface on the conductor 246 side) is smaller than the area of the lower base surface (the surface on the oxide 230 side).

### [Transistor 200C]

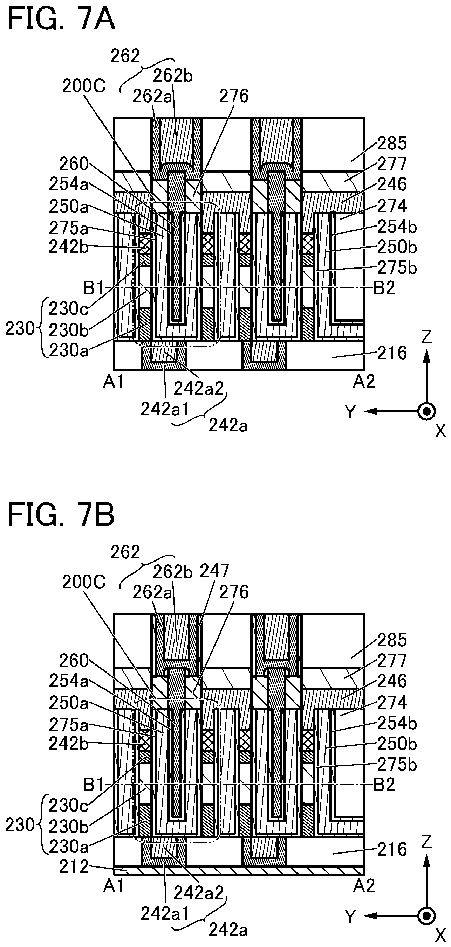

FIG. 7A is a cross-sectional view of a semiconductor device including a transistor 200C. The transistor 200C illustrated in FIG. 7A is a variation example of the transistor 200 illustrated in FIG. 5B.

The transistor 200C illustrated in FIG. 7A is different from the transistor 200 illustrated in FIG. 5B in including an insulator 254a and an insulator 254b.

The insulator 254a is placed between the insulator 250a and the conductor 260. Specifically, the insulator 254a is provided in the depressed portion of the insulator 250a. In addition, the insulator 254a is provided in contact with part of the side surface and the bottom surface of the conductor 260. In such a structure, the insulator 254a can also be regarded as having a depressed portion. The uppermost portion of the insulator 254a is level or substantially level with the uppermost portion of the insulator 275a and the uppermost portion of the insulator 250a.

The insulator 254a functions as part of a gate insulator. As the insulator 254a, a barrier insulating film against hydrogen is preferably used. This can prevent diffusion of impurities such as hydrogen contained in the conductor 260 into the oxide 230b. As the insulator 254a, an insulator that can be used as the insulator 277 described above may be used. For example, silicon nitride deposited by a PEALD method may be used as the insulator 254a. In this case, the insulator 254a is contains at least nitrogen and silicon.

Furthermore, the insulator 254a may have a barrier property against oxygen. Thus, diffusion of oxygen contained in the insulator 250a into the conductor 260 can be inhibited.

Furthermore, the insulator 254a needs to be provided in an opening formed in the oxide 230 and the like, together with the insulator 275a, the insulator 250a, and the conductor 260. The thickness of the insulator 254a is preferably thin for miniaturization of the transistor. The thickness of the insulator 254a is greater than or equal to 0.1 nm and less than or equal to 5.0 nm, preferably greater than or equal to 0.5 nm and less than or equal to 3.0 nm, further preferably greater than or equal to 1.0 nm and less than or equal to 3.0 nm. In this case, at least part of the insulator 254a preferably includes a region having the above-described thickness. The thickness of the insulator 254a is preferably smaller than that of the insulator 250a. In this case, at least part of the insulator 254a may include a region having a thickness that is smaller than that of the insulator 250a.

The insulator 254b is placed on the outer sides of the oxide 230 and the conductor 242b (on the insulator 275b side) in the top view. The insulator 254b is placed between the insulator 250b and the insulator 274. Specifically, the insulator 254b is provided in contact with the top surface of the insulator 250b. Furthermore, the insulator 254b is provided in contact with the side surface and the bottom surface of the insulator 274.

The insulator 254a and the insulator 254b are formed through the same step. Thus, the insulator 254a and the insulator 254b contain the same material. The thicknesses of the insulator 254a and the insulator 254b are equal to each other.

In the semiconductor device of one embodiment of the present invention, an insulator may be provided to be in contact with the side surface of the conductor 262. Moreover, an insulator may be provided below the conductor 242a and the insulator 216.

FIG. 7B is a cross-sectional view of a semiconductor device including the transistor 200C. The semiconductor device illustrated in FIG. 7B is different from the semiconductor device illustrated in FIG. 7A in including an insulator 247 and an insulator 212.

The insulator 247 is placed between the conductor 262 and the insulator 277, the insulator 278 (not illustrated in FIG. 7B), or the insulator 285. The insulator 247 is provided in contact with the side surface of the conductor 262.

The insulator 247 preferably functions as a barrier insulating film that inhibits impurities such as water and hydrogen from diffusing into the conductor 262. This can inhibit diffusion of impurities such as hydrogen contained in the insulator 285 into the oxide 230b through the conductor 262. As the insulator 247, an insulator that can be used as the insulator 277 described above may be used. For example, silicon nitride deposited by a PEALD method may be used as the insulator 247. In this case, the insulator 247 contains at least nitrogen and silicon.

Note that an insulator formed using the same material as the insulator 247 is sometimes formed to cover the side surface of the conductor 260 in a region exposed from the insulator 276.

The insulator 212 is provided over a substrate (not illustrated) and is provided below the insulator 216 and the conductor 242a.

The insulator 212 functions as an interlayer film. The insulator 212 preferably functions as a barrier insulating film that inhibits diffusion of impurities such as water and hydrogen into the transistor 200 from the substrate side. As the insulator 212, an insulator that can be used as the insulator 277 described above is preferably used. For example, the insulator 212 is preferably formed using a nitride containing silicon such as silicon nitride or silicon nitride oxide. Specifically, silicon nitride deposited by a sputtering method may be used for the insulator 212. When the insulator 212 is deposited by a sputtering method, high-density silicon nitride be formed. To obtain the insulator 212, silicon nitride deposited by a PEALD method or a CVD method may be stacked over silicon nitride deposited by a sputtering method.

The above is the description of the structure example of the semiconductor device and the structure example of the transistor included in the semiconductor device.

### <Manufacturing method of semiconductor device>

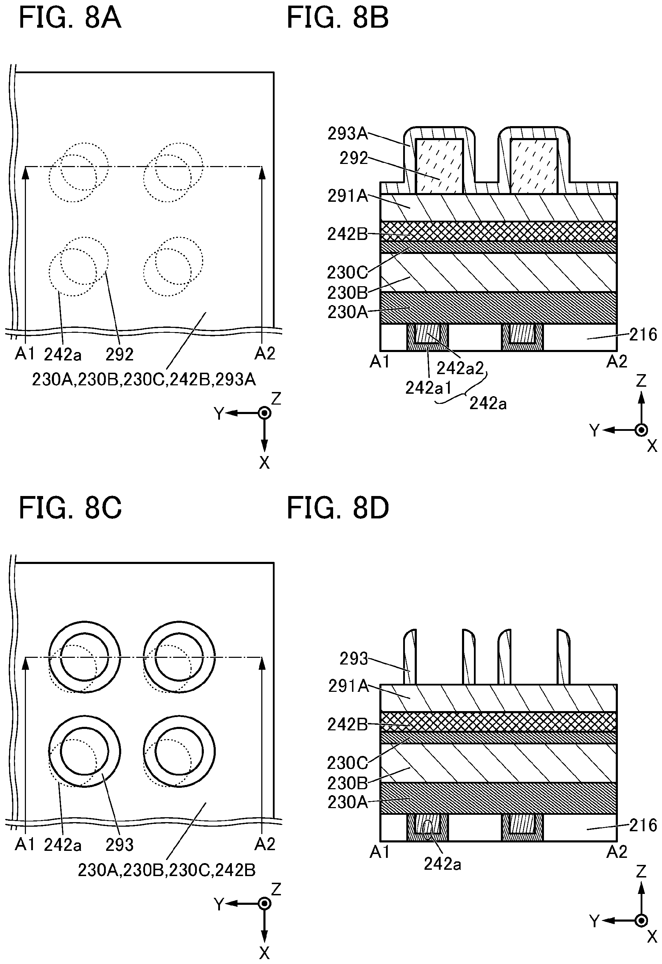

Next, a method for manufacturing the semiconductor device that is one embodiment of the present invention and is illustrated in FIG. 5A to FIG. 5C will be described with reference to FIG. 8A to FIG. 16B.

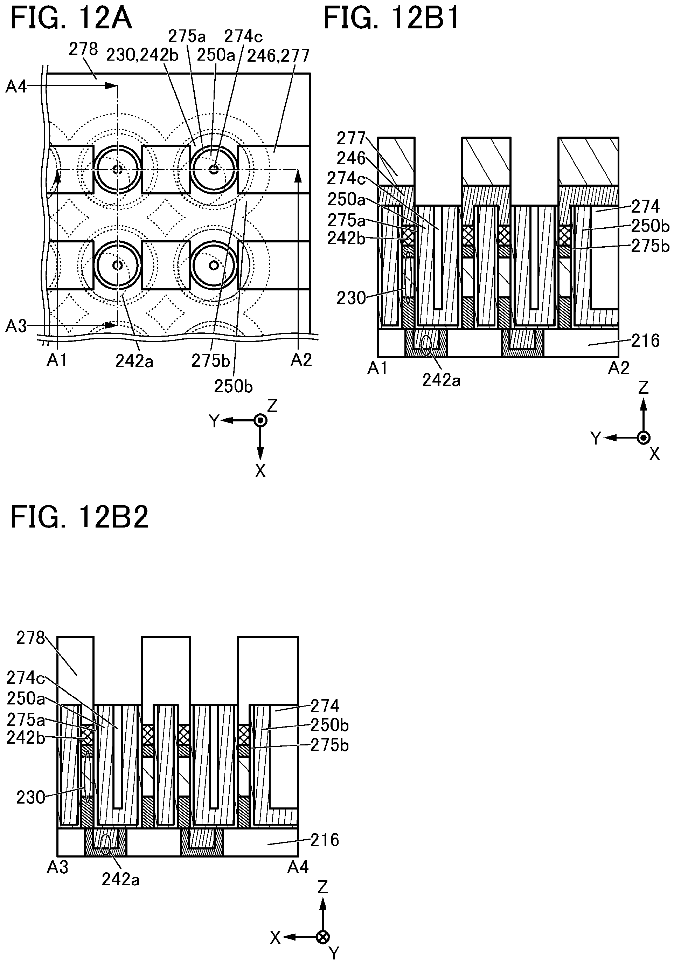

Note that A and C of each drawing are top views. Moreover, B of each drawing is a cross-sectional view corresponding to a portion indicated by dashed-dotted line A1-A2 in A of each drawing. FIG. 12B1 is a cross-sectional view corresponding to a portion indicated by the dashed-dotted line A1-A2 in FIG. 12A. FIG. 12B2 is a cross-sectional view corresponding to a portion indicated by the dashed-dotted line A3-A4 in FIG. 12A. Moreover, D of each drawing is a cross-sectional view corresponding to a portion indicated by dashed-dotted line A1-A2 in C of each drawing. Note that for clarity of the drawings, some components are not illustrated in the top view of A or C of each drawing.

Hereinafter, an insulating material for forming an insulator, a conductive material for forming a conductor, or a semiconductor material for forming a semiconductor can be deposited by a sputtering method, a CVD method, an MBE method, a PLD method, an ALD method, or the like as appropriate.

Examples of the sputtering method include an RF sputtering method in which a high-frequency power source is used as a sputtering power source, and a DC sputtering method in which a direct-current power source is used. Examples of the DC sputtering method include a pulsed An RF sputtering method is mainly used in the case where an insulating film is deposited, and a DC sputtering method is mainly used in the case where a metal conductive film is deposited. A pulsed DC sputtering method is mainly used in the case where a compound such as an oxide, a nitride, or a carbide is deposited by a reactive sputtering method.

Note that the CVD method can be classified into a plasma CVD (PECVD) method using plasma, a thermal CVD (TCVD) method using heat, a photo CVD method using light, and the like. Moreover, the CVD method can be classified into a metal CVD (MCVD) method and a metal organic CVD (MOCVD) method depending on a source gas to be used.

A high-quality film can be obtained at a relatively low temperature by a plasma CVD method. Furthermore, a thermal CVD method is a deposition method that does not use plasma and thus enables less plasma damage to an object to be processed. For example, a wiring, an electrode, an element (a transistor, a capacitor, or the like), or the like included in a semiconductor device might be charged up by receiving electric charge from plasma. In this case, accumulated electric charge might break the wiring, the electrode, the element, or the like included in the semiconductor device. In contrast, such plasma damage does not occur in the case of a thermal CVD method, which does not use plasma, and thus the yield of the semiconductor device can be increased. In addition, a thermal CVD method does not cause plasma damage during deposition, so that a film with few defects can be obtained.

As an ALD method, a thermal ALD method, in which a precursor and a reactant react with each other only by a thermal energy, a PEALD method, in which a reactant excited by plasma is used, and the like can be used.

A CVD method and an ALD method are different from a sputtering method in which particles ejected from a target or the like are deposited. Thus, a CVD method and an ALD method are deposition methods that enable favorable step coverage almost regardless of the shape of an object to be processed. In particular, an ALD method has excellent step coverage and excellent thickness uniformity and thus is suitable for covering a surface of an opening portion with a high aspect ratio, for example. On the other hand, an ALD method has a relatively low deposition rate, and thus is preferably used in combination with another deposition method with a high deposition rate, such as a CVD method, in some cases.

By a CVD method, a film with a certain composition can be deposited depending on the flow rate ratio of the source gases. For example, by a CVD method, by changing the flow rate ratio of the source gases during the deposition, a film in which the composition is continuously changed can be deposited. In the case where the film is deposited while the flow rate ratio of the source gases is changed, as compared to the case where the film is deposited using a plurality of deposition chambers, the time taken for the deposition can be shortened because the time taken for transfer or pressure adjustment is omitted. Thus, the productivity of the semiconductor device can be increased in some cases.

In an ALD method, a film with a freely selected composition can be deposited by concurrently introducing different kinds of precursors. In the case where different kinds of precursors are introduced, a film with a freely selected composition can be deposited by controlling the cycle number of each of the precursors.

First, a substrate (not shown) is prepared, and the insulator 216 is formed over the substrate. The insulator 216 is preferably deposited by a sputtering method. By using a sputtering method that does not need to use a molecule containing hydrogen as a deposition gas, the hydrogen concentration in the insulator 216 can be reduced. Without limitation to a sputtering method, the insulator 216 may be deposited by a CVD method, an MBE method, a PLD method, an ALD method, or the like as appropriate.

In this embodiment, for the insulator 216, silicon oxide is deposited by a pulsed DC sputtering method using a silicon target in an atmosphere containing an oxygen gas. The use of the pulsed DC sputtering method can achieve more uniform film thickness and improve the sputtering rate and film quality.

When the insulator 212 illustrated in FIG. 7B is provided, the insulator 212 and the insulator 216 are preferably successively deposited without exposure to the air. For example, a multi-chamber deposition apparatus is preferably used. As a result, the amounts of hydrogen in the deposited insulator 212 and insulator 216 can be reduced, and furthermore, entry of hydrogen into the films in intervals between deposition steps can be inhibited.

Then, openings are formed in the insulator 216. Examples of the opening include a groove and a slit. A region where an opening is formed is referred to as an opening portion in some cases. Wet etching can be used for the formation of the opening; however, dry etching is preferably used for microfabrication.

As a dry etching apparatus, a capacitively coupled plasma (CCP) etching apparatus including parallel plate electrodes can be used. The capacitively coupled plasma etching apparatus including parallel plate electrodes may have a structure where a high-frequency voltage is applied to one of the parallel plate electrodes. Alternatively, a structure may be employed in which different high-frequency voltages are applied to one of the parallel plate electrodes. Alternatively, a structure may be employed in which high-frequency voltages with the same frequency are applied to the parallel plate electrodes. Alternatively, a structure may be employed in which high-frequency voltages with different frequencies are applied to the parallel plate electrodes. Alternatively, a dry etching apparatus including a high-density plasma source can be used. As the dry etching apparatus including a high-density plasma source, an inductively coupled plasma (ICP) etching apparatus or the like can be used, for example.

Note that an insulator functioning as an etching stopper film in forming the opening by etching the insulator 216 is preferably provided in contact with the bottom surface of the insulator 216. For example, in the case where silicon oxide or silicon oxynitride is used for the insulator 216 in which the opening is to be formed, the insulator may be formed using silicon nitride, aluminum oxide, or hafnium oxide. For example, the insulator 212 illustrated in FIG. 7B may be provided as the insulator. In other words, the insulator 212 preferably has the function.

After the formation of the opening, a conductive film to be the conductor 242a1 is deposited. The conductive film desirably includes a conductor having a function of inhibiting passage of oxygen. For example, tantalum nitride, tungsten nitride, or titanium nitride can be used. Alternatively, a stacked-layer film of the conductor that has a function of inhibiting the passage of oxygen and tantalum, tungsten, titanium, molybdenum, aluminum, copper, or a molybdenum-tungsten alloy can be used. The conductive film can be deposited by a sputtering method, a CVD method, an MBE method, a PLD method, an ALD method, or the like.

In this embodiment, a titanium nitride film is formed as the conductive film to be the conductor 242a1. When such a metal nitride is used for a layer under the conductor 242a2, oxidation of the conductor 242a2 by the insulator 216 or the like can be inhibited. Furthermore, even when a metal that is likely to diffuse, such as copper, is used for the conductor 242a2, the metal can be prevented from diffusing to the outside through the conductor 242a1.

Next, a conductive film to be the conductor 242a2 is deposited. Tantalum, tungsten, titanium, molybdenum, aluminum, copper, a molybdenum-tungsten alloy, or the like can be used for the conductive film. The conductive film can be deposited by a plating method, a sputtering method, a CVD method, an MBE method, a PLD method, an ALD method, or the like. In this embodiment, a tungsten film is formed as the conductive film.

Next, by performing CMP treatment, the conductive film to be the conductor 242a1 and the conductive film to be the conductor 242a2 are partly removed to expose the insulator 216 (see FIG. 8A and FIG. 8B). As a result, the conductor 242a1 and the conductor 242a2 remains only in the opening portion formed in the insulator 216, so that the conductor 242a (the conductor 242a1 and the conductor 242a2) is formed. Note that the insulator 216 is partly removed by the CMP treatment in some cases.

Next, an oxide film 230A, an oxide film 230B, and an oxide film 230C are deposited in this order over the insulator 216 and the conductor 242a (see FIG. 8A and FIG. 8B). The oxide film 230A, the oxide film 230B, and the oxide film 230C are preferably deposited successively without being exposed to the air environment. Depositing these films without being exposed to the air environment can prevent impurities or moisture from the air environment from attaching onto the oxide film 230A, the oxide film 230B, and the oxide film 230C; this can keep clean the interface between the oxide film 230A and the oxide film 230B, the vicinity of the interface, the interface between the oxide film 230B and the oxide film 230C, and the vicinity of the interface.

The oxide film 230A, the oxide film 230B and the oxide film 230C can be deposited by a sputtering method, a CVD method, an MBE method, a PLD method, an ALD method, or the like.

For example, in the case where the oxide film 230A, the oxide film 230B, and the oxide film 230C are deposited by a sputtering method, oxygen or a mixed gas of oxygen and a noble gas is used as a sputtering gas. Increasing the proportion of oxygen contained in the sputtering gas can increase the amount of excess oxygen in the deposited oxide films. In the case where the above oxide films are deposited by a sputtering method, a target of the above-described In-M-Zn oxide or the like can be used.

In the case where a metal oxide film to which nitrogen is added is deposited as the oxide film 230A by a sputtering method, a metal oxide film to which nitrogen is added can be deposited even when a target does not contain nitrogen when a sputtering gas containing a nitrogen gas is used in the deposition. In the case where a metal oxide film is deposited by adding a nitrogen gas, the higher the nitrogen flow rate ratio is, the higher the carrier mobility of the metal oxide film can be.

The nitrogen flow rate ratio can be set as appropriate in a range of from 10 % to 100 % inclusive in accordance with characteristics required for the oxide 230a and the oxide 230c. At this time, for example, the sputtering gas can be a mixed gas of a nitrogen gas and an argon gas. The sputtering gas may be a mixed gas of a nitrogen gas and an oxygen gas or a mixed gas of a nitrogen gas, an oxygen gas, and an argon gas.

With use of a target containing nitrogen, a sputtering gas without nitrogen can be employed for depositing a metal oxide film to which nitrogen is added.

In the case where the sputtering gas for depositing the oxide film 230A contains an oxygen gas, part of oxygen contained in the sputtering gas is supplied to the insulator 216 in some cases. Thus, the proportion of oxygen contained in the sputtering gas is higher than or equal to 70 %, preferably higher than or equal to 80 %, further preferably 100 %.

It is preferable to highly purify the above sputtering gas. For example, as an oxygen gas, a nitrogen gas, or an argon gas used as the sputtering gas, a gas highly purified to have a dew point of -40 °C or lower, preferably -80 °C or lower, further preferably -100 °C or lower, still further preferably -120 °C or lower is used, whereby entry of moisture or the like into the metal oxide film can be prevented as much as possible.

In the case where the oxide film 230B is deposited by a sputtering method and the proportion of oxygen contained in the sputtering gas is higher than 30 % and lower than or equal to 100 %, preferably higher than or equal to 70 % and lower than or equal to 100 %, an oxygen-excess oxide semiconductor is formed. In a transistor including an oxygen-excess oxide semiconductor for its channel formation region, relatively high reliability can be obtained. Note that one embodiment of the present invention is not limited thereto. In the case where the oxide film 230B is deposited by a sputtering method and the proportion of oxygen contained in the sputtering gas for deposition is higher than or equal to 1 % and lower than or equal to 30 %, preferably higher than or equal to 5 % and lower than or equal to 20 %, an oxygen-deficient oxide semiconductor is formed. In a transistor including an oxygen-deficient oxide semiconductor for its channel formation region, relatively high field-effect mobility can be obtained. Furthermore, when the deposition is performed while the substrate is being heated, the crystallinity of the oxide film can be improved.

For the deposition method of the oxide film 230C, the deposition method of the oxide film 230A can be referred to.

Note that the insulating film 230A, the oxide film 230B, and the oxide film 230C are preferably deposited by a sputtering method without exposure to the air. For example, a multi-chamber deposition apparatus is used. As a result, entry of hydrogen into the insulating film 230A, the oxide film 230B, and the oxide film 230C in intervals between deposition steps can be inhibited.

In the case where a metal oxide film to which nitrogen is added is deposited as each of the oxide film 230A and the oxide film 230C by a sputtering method and a metal oxide film is deposited as the oxide film 230B by a sputtering method, switching a kind of gas introduced into the sputtering apparatus, i.e., stopping the introduction of nitrogen, after the deposition of the oxide film 230A enables the deposition of the oxide film 230B. Furthermore, after the deposition of the oxide film 230B, switching the kind of gas introduced into the sputtering apparatus, i.e., introducing nitrogen is performed so that the oxide film 230C is deposited. Thus, the oxide film 230A, the oxide film 230B, and the oxide film 230C can be successively deposited and has high mass productivity.

An ALD method may be employed for depositing the oxide film 230A, the oxide film 230B, and the oxide film 230C. A film with a uniform thickness can be formed by an ALD method. Employing a PEALD method is preferable because the oxide film 230A, the oxide film 230B, and the oxide film 230C can be formed at a lower temperature than that in the case of employing a thermal ALD method.

In this embodiment, as each of the oxide film 230A and the oxide film 230C, a metal oxide film to which nitrogen is added is deposited by a sputtering method. In addition, the oxide film 230B is deposited by a sputtering method using an oxide target with In:Ga:Zn = 4:2:4.1 [atomic ratio], an oxide target with In:Ga:Zn = 1:1:1 [atomic ratio], an oxide target with In:Ga:Zn = 1:1:1.2 [atomic ratio], or an oxide target with In:Ga:Zn = 1:1:2 [atomic ratio]. Note that each of the oxide films is preferably formed so as to have characteristics required for the oxide 230a, the oxide 230b and the oxide 230c by selecting the deposition conditions and the atomic ratios as appropriate.

Next, heat treatment is preferably performed. The heat treatment is performed in a temperature range where the oxide film 230A, the oxide film 230B, and the oxide film 230C do not become polycrystals, i.e., at a temperature higher than or equal to 250 °C and lower than or equal to 650 °C, preferably higher than or equal to 400 °C and lower than or equal to 600 °C. Note that the heat treatment is performed in a nitrogen gas or inert gas atmosphere, or an atmosphere containing an oxidizing gas at 10 ppm or more, 1 % or more, or 10 % or more. For example, in the case where the heat treatment is performed in a mixed atmosphere of a nitrogen gas and an oxygen gas, the proportion of the oxygen gas may be approximately 20 %. The heat treatment may be performed under reduced pressure. Alternatively, the heat treatment may be performed in an atmosphere containing an oxidizing gas at 10 ppm or more, 1 % or more, or 10 % or more in order to compensate for released oxygen, after heat treatment is performed in a nitrogen gas or an inert gas atmosphere.

The gas used in the above heat treatment is preferably highly purified. For example, the amount of moisture contained in the gas used in the above heat treatment is 1 ppb or less, preferably 0.1 ppb or less, further preferably 0.05 ppb or less. The heat treatment using a highly purified gas can prevent entry of moisture or the like into the oxide film 230A, the oxide film 230B, the oxide film 230C, and the like as much as possible.

In this embodiment, the heat treatment is performed at 400 °C for one hour with the flow rate ratio of nitrogen gas to oxygen gas being 4:1. By the heat treatment using the oxygen gas, impurities such as carbon, water, and hydrogen in the oxide film 230B can be reduced, for example. Furthermore, the reduction of impurities in the films improves the crystallinity of the oxide film 230B, thereby offering a dense structure with higher density. Accordingly, the crystal region in the oxide film 230B can be expanded, and in-plane variation in the oxide film 230B can be reduced. Accordingly, an in-plane variation of electrical characteristics of the transistor 200 can be reduced.

By performing the heat treatment, the hydrogen concentrations in the insulator 216 and the oxide film 230B can be reduced. In particular, the oxide film 230B functions as the channel formation region of the transistor 200. Thus, the transistor 200 preferably includes the oxide film 230B with reduced hydrogen concentration because favorable reliability can be obtained.

Next, a conductive film 242B is deposited over the oxide film 230C (see FIG. 8A and FIG. 8B). The conductive film 242B can be formed by a sputtering method, a CVD method, an MBE method, a PLD method, an ALD method, or the like. For example, as the conductive film 242B, a tantalum nitride film is deposited by a sputtering method. Note that heat treatment may be performed before the deposition of the conductive film 242B. This heat treatment may be performed under reduced pressure, and the conductive film 242B may be successively deposited without exposure to the air. The treatment can remove moisture and hydrogen adsorbed onto the surface of the oxide film 230C and the like, and further can reduce the moisture concentration and the hydrogen concentration in the oxide film 230A, the oxide film 230B, and the oxide film 230C. The heat treatment is preferably performed at a temperature higher than or equal to 100 °C and lower than or equal to 400 °C. In this embodiment, the heat treatment is performed at 200 °C.

Next, an insulating film 291A is deposited over the conductive film 242B (see FIG. 8A and FIG. 8B). The insulating film 291A can be formed by a sputtering method, a CVD method, an MBE method, a PLD method, an ALD method, or the like. As the insulating film 291A, an insulating film having a function of inhibiting passage of oxygen is preferably used. For example, as the insulating film 291A, an aluminum oxide film or a silicon nitride film may be deposited by a sputtering method.

Note that the conductive film 242B and the insulating film 291A are preferably formed by a sputtering method without exposure to the air. For example, a multi-chamber deposition apparatus is used. As a result, the amounts of hydrogen in the conductive film 242B and the insulating film 291A can be reduced, and furthermore, entry of hydrogen into the films in intervals between deposition steps can be inhibited. In the case where a hard mask is provided over the insulating film 291A, a film to be the hard mask is preferably successively deposited without exposure to the air.

Next, the oxide film 230A, the oxide film 230B, the oxide film 230C, the conductive film 242B, and the insulating film 291A are processed into hollow cylindrical shapes by a lithography method to form the oxide 230 (the oxide 230a, the oxide 230b, an oxide 230c), the conductor 242b, and an insulator 291. Here, the oxide 230a, the oxide 230b, the oxide 230c, the conductor 242b, and the insulator 291 are formed to at least partly overlap with the conductor 242a. A dry etching method or a wet etching method can be used for the processing.

Note that in the lithography method, first, a resist is exposed to light through a mask. Next, a region exposed to light is removed or left using a developing solution, so that a resist mask is formed. Then, etching process through the resist mask is conducted, whereby a conductor, a semiconductor, an insulator, or the like can be processed into a desired shape. The resist mask may be formed through, for example, exposure of the resist to KrF excimer laser light, ArF excimer laser light, EUV light, or the like. Alternatively, a liquid immersion technique may be employed in which a gap between a substrate and a projection lens is filled with liquid (e.g., water) in light exposure. Alternatively, an electron beam or an ion beam may be used instead of the light. Note that a mask is unnecessary in the case of using an electron beam or an ion beam. Note that the resist mask can be removed by a dry etching process such as ashing, a wet etching process, a wet etching process after a dry etching process, or a dry etching process after a wet etching process.

In addition, a hard mask formed of an insulator or a conductor may be used under the resist mask. In the case of using a hard mask, a hard mask with a desired shape can be formed in the following manner: an insulating film or a conductive film that is the material of the hard mask is formed over the conductive film 242B, a resist mask is formed thereover, and then the hard mask material is etched. The etching of the conductive film 242B and the like may be performed after removing the resist mask or with the resist mask remaining. In the latter case, the resist mask sometimes disappears during the etching. The hard mask may be removed by etching after the etching of the conductive film 242B and the like. Meanwhile, the hard mask is not necessarily removed when the hard mask material does not affect later steps or can be utilized in later steps. In this embodiment, the insulator 291 is used as a hard mask.

Described below is an example of a method for forming the oxide 230 (the oxide 230a, the oxide 230b, and the oxide 230c), the conductor 242b, and the insulator 291 each of which has a hollow cylindrical shape with a lithography method.

First, a resist mask 292 is formed over the insulating film 291A (see FIG. 8A and FIG. 8B). At least part of the resist mask 292 is provided in a region overlapping with the conductor 242a.

Although the top surface of the resist mask 292 has a circular shape, the present invention is not limited thereto; for example, the top surface may have an elliptical shape or a polygonal shape, e.g., a triangle or a quadrangle. When the top surface has a polygonal shape, the polygonal shape may have rounded corners.

The resist mask 292 can be formed in the following manner; for example, a resist is exposed to light through a mask and a region exposed to light is removed or left using a developing solution. The resist mask 292 may be shrunk by isotropic etching with oxygen plasma. The shrinkage of the resist mask is referred to resist slimming or resist trimming, in some cases. Shrinking the resist mask 292 enables the resist mask 292 to be miniaturized.

Alternatively, the resist mask 292 may be formed, for example, in the following manner: a resist is exposed to light through a mask capable of forming a line pattern, the resist is exposed to light again through the mask rotated by 90° around the z-axis, and the exposed region is removed or left using a developing solution. By this processing, the top surface of the resist mask 292 has a shape with rounded corners or a circular shape.

For the formation of the resist mask 292, it is preferable to use a multi-patterning technique including double patterning such as LELE and SADP, quadruple patterning such as SAQP, and octuple patterning. For example, the resist mask 292 may be formed in the following manner: a resist mask with a line pattern extending in the X direction is formed using a multi-patterning technique, and the resist mask with a line pattern extending in the X direction is processed with a multi-patterning technique for forming a resist mask with a line pattern extending in the Y direction. By this processing, the top surface of the resist mask 292 has a shape with rounded corners or a circular shape.

Next, an insulating film 293A is deposited over the resist mask 292 (see FIG. 8A and FIG. 8B). The insulating film 293A can be formed by a sputtering method, a CVD method, an MBE method, a PLD method, an ALD method, or the like. The thickness of the insulating film 293A corresponds to the width H1 illustrated in FIG. 5D. Thus, the thickness of the insulating film 293A may be set as appropriate in accordance with the design of the transistor 200.

Next, the insulating film 293A is subjected to anisotropic etching, so that an insulator 293 is formed (see FIG. 8C and FIG. 8D). For the anisotropic etching of the insulating film 293A, a dry etching method or the like is employed, for example. When the insulating film 293A is subjected to anisotropic etching, the insulator 293 is provided on the side surface of the resist mask 292. That is, the insulator 293 can be rephrased as a sidewall.

Next, the resist mask 292 is removed (see FIG. 8C and FIG. 8D). When the resist mask 292 is removed, the insulator 293 remains over the insulating film 291A. Note that the top surface shape of an opening in the insulator 293 corresponds to the top surface shape of the resist mask 292. For example, in the case where the top surface of the resist mask 292 has a circular shape, the top surface of the insulator 293 has a hollow cylindrical shape as illustrated in FIG. 8C. In the case where the top surface shape of the resist mask 292 has the above-described elliptical shape, the top surface of the insulator 293 has a hollow elliptical shape. In the case where the top surface shape of the resist mask 292 has a polygonal shape with rounded corners, the top surface of the insulator 293 has a hollow polygonal shape with rounded corners.

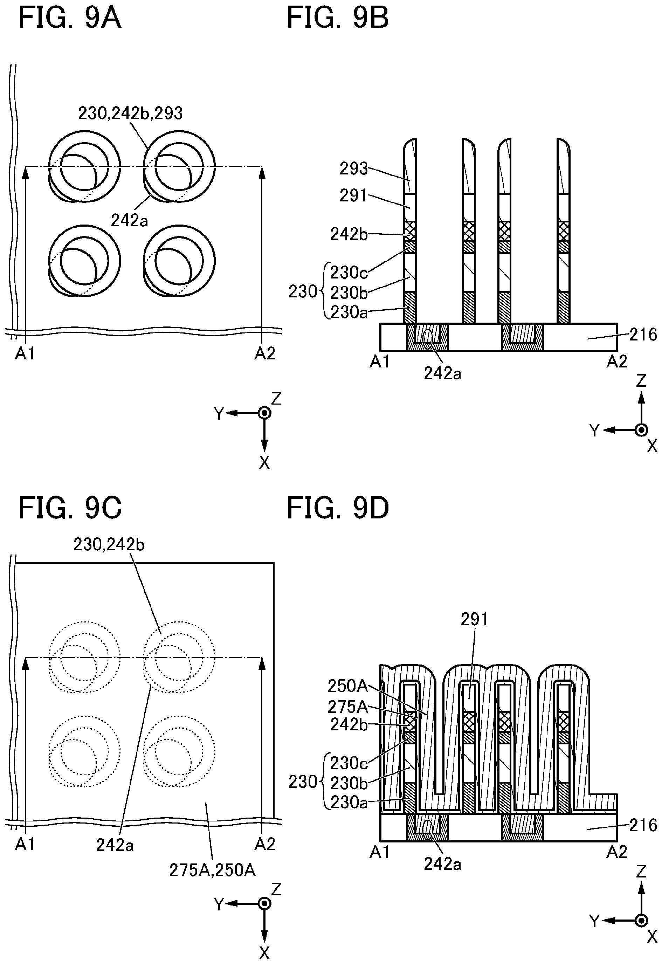

Next, the insulating film 291A, the conductive film 242B, the oxide film 230C, the oxide film 230B, and the oxide film 230A are partly processed with use of the insulator 293 as a hard mask until the top surfaces of the insulator 216 and the conductor 242a are exposed (see FIG. 9A and FIG. 9B). A dry etching method or a wet etching method can be used for the processing. A dry etching method is suitable for microfabrication. The insulating film 291A, the conductive film 242B, the oxide film 230C, the oxide film 230B, and the oxide film 230A may be processed under different conditions.

By the above processing, the insulator 291, the conductor 242b, the oxide 230c, the oxide 230b, and the oxide 230a whose top surface shapes are the same or substantially the same as the top surface shape of the insulator 293 are formed (see FIG. 9A and FIG. 9B). In other words, the end portions of the insulator 291, the conductor 242b, the oxide 230c, the oxide 230b, and the oxide 230a are aligned or substantially aligned with each other. Each of the oxide 230 (the oxide 230a, the oxide 230b, and the oxide 230c), the conductor 242b, and the insulator 291 has a hollow cylindrical shape. As described above, the top surface shapes of the insulator 291, the oxide 230, the conductor 242b, and the insulator 291 correspond to the top surface shape of the resist mask 292. Thus, the hollow cylindrical shape can be rephrased as appropriate in accordance with the top surface shape of the resist mask 292.

The above is an example of a method for forming the oxide 230 (the oxide 230a, the oxide 230b, and the oxide 230c), the conductor 242b, and the insulator 291 each of which has a hollow cylindrical shape with a lithography method.

Note that the side surfaces of the oxide 230 and the conductor 242b are preferably perpendicular to the top surface of the insulator 216. With such a structure, a plurality of the transistors 200 can be provided with high density in a small area.

Note that the cross sections of the oxide 230 and the conductor 242b may have the tapered shapes as illustrated in FIG. 6B and FIG. 6C, not being limited to the above structure. With such tapered shapes in the cross sections, the coverage with an insulating film to be the insulator 275a and the like can be improved in a later step, so that defects such as a void can be reduced.

Next, the insulator 293 is removed (see FIG. 9C and FIG. 9D).

Up to this step, attachment of impurities to the side surfaces of the oxide 230a, the oxide 230b, the oxide 230c, the conductor 242b, and the insulator 291 or diffusion of the impurities into them may be caused. A step of removing the impurities may be performed. Examples of the impurities include hafnium, aluminum, silicon, tantalum, fluorine, and chlorine.

In order to remove impurities and the like attached to the surface of the oxide 230b in the above etching step, cleaning treatment is performed. Examples of the cleaning method include wet cleaning using a cleaning solution (also can be referred to as wet etching process), plasma treatment using plasma, and cleaning by heat treatment, and any of these cleanings may be performed in combination as appropriate.

The wet cleaning may be performed using an aqueous solution in which ammonia water, oxalic acid, phosphoric acid, hydrofluoric acid, or the like is diluted with carbonated water or pure water; pure water; carbonated water; or the like. Alternatively, ultrasonic cleaning using such an aqueous solution, pure water, or carbonated water may be performed. Alternatively, such cleaning methods may be performed in combination as appropriate.

Note that in this specification and the like, in some cases, an aqueous solution in which hydrofluoric acid is diluted with pure water is referred to as diluted hydrofluoric acid, and an aqueous solution in which ammonia water is diluted with pure water is referred to as diluted ammonia water. The concentration, temperature, and the like of the aqueous solution may be adjusted as appropriate in accordance with an impurity to be removed, the structure of a semiconductor device to be cleaned, or the like. The concentration of ammonia in the diluted ammonia water is higher than or equal to 0.01 % and lower than or equal to 5 %, preferably higher than or equal to 0.1 % and lower than or equal to 0.5 %. The concentration of hydrogen fluoride in the diluted hydrofluoric acid is higher than or equal to 0.01 ppm and lower than or equal to 100 ppm, preferably higher than or equal to 0.1 ppm and lower than or equal to 10 ppm.

A frequency greater than or equal to 200 kHz, preferably greater than or equal to 900 kHz is preferably used for the ultrasonic cleaning. Damage to the oxide 230b and the like can be reduced with this frequency.

The cleaning treatment may be performed a plurality of times, and the cleaning solution may be changed in every cleaning treatment. For example, the first cleaning treatment may use diluted hydrofluoric acid or diluted ammonia water and the second cleaning treatment may use pure water or carbonated water.

After the etching or the cleaning treatment, heat treatment may be performed. The heat treatment is performed at higher than or equal to 100 °C and lower than or equal to 450 °C, preferably higher than or equal to 350 °C and lower than or equal to 400 °C. Note that the heat treatment is performed in a nitrogen gas or inert gas atmosphere, or an atmosphere containing an oxidizing gas at 10 ppm or more, 1 % or more, or 10 % or more. For example, the heat treatment is preferably performed in an oxygen atmosphere. Accordingly, oxygen can be supplied to the oxide 230a the oxide 230b, and the oxide 230c to reduce oxygen vacancies. In addition, the crystallinity of the oxide 230b can be improved by the heat treatment. The heat treatment may be performed under reduced pressure. Alternatively, heat treatment may be performed in an oxygen atmosphere, and then heat treatment may be successively performed in a nitrogen atmosphere without exposure to the air.

Note that the cleaning treatment and the heat treatment may be performed before the insulator 293 is removed.

Next, an insulating film 275A is formed over the insulator 216, the conductor 242a, and the insulator 291 (see FIG. 9C and FIG. 9D). In other words, the insulating film 275A is formed to cover the oxide 230a, the oxide 230b, the oxide 230c, the conductor 242b, and the insulator 291. The insulating film 275A can be formed by a sputtering method, a CVD method, an MBE method, a PLD method, an ALD method, or the like.

The insulating film 275A is preferably deposited by an ALD method. As described above, it is preferable to deposit the insulating film 275A to have a small thickness, and an unevenness of the thickness needs to be reduced. In contrast, an ALD method is a deposition method in which a precursor and a reactant (e.g., oxidizer) are alternately introduced, and the film thickness can be adjusted with the number of repetition times of the cycle; thus, accurate control of the film thickness is possible. As illustrated in FIG. 9C and FIG. 9D, the insulating film 275A needs to be deposited on the side surface of the opening portion formed in the oxide 230, the conductor 242b, and the insulator 291 and the top surfaces of the conductor 242a and the insulator 216 with good coverage. In particular, it is preferable that the insulating film 275A be deposited on the side surface of the oxide 230 and the side surface of the conductor 242b so as to have good coverage. The ALD method enables an atomic layer to be deposited one by one on the bottom surface and the side surface of the opening, whereby the insulating film 275A can be formed in the opening with good coverage.

When the insulating film 275A is deposited by an ALD method, ozone (O₃), oxygen (O₂), water (H₂O), or the like can be used as the oxidizer. When an oxidizer without containing hydrogen, such as ozone (O₃) or oxygen (O₂), is used, the amount of hydrogen diffusing into the oxide 230 can be reduced.

As the insulating film 275A, an insulating film having a function of inhibiting passage of oxygen is preferably used. For example, an aluminum oxide film can be deposited as the insulating film 275A by an ALD method. In this manner, the oxide 230 (oxide 230a, the oxide 230b, the oxide230c) and the conductor 242b can be covered with the insulating film 275A which has a function of inhibiting diffusion of oxygen. This structure enables inhabitation of diffusion of oxygen directly from the insulator 274 or the like into the oxide 230 and the conductor 242b in a later step.

Next, microwave treatment may be performed in an oxygen-containing atmosphere. Here, the microwave treatment refers to, for example, treatment using an apparatus including a power source that generates high-density plasma with use of a microwave. Note that in this specification and the like, a microwave refers to an electromagnetic wave having a frequency greater than or equal to 300 MHz and less than or equal to 300GHz.

The microwave treatment is preferably performed with a microwave treatment apparatus including a power source for generating high-density plasma using microwaves, for example. Here, the frequency of the microwave treatment apparatus is set to greater than or equal to 300 MHz and less than or equal to 300 GHz, preferably greater than or equal to 2.4 GHz and less than or equal to 2.5 GHz, for example, 2.45 GHz. Oxygen radicals at a high density can be generated with high-density plasma. The electric power of the power source that applies microwaves of the microwave treatment apparatus is set to higher than or equal to 1000 W and lower than or equal to 10000 W, preferably higher than or equal to 2000 W and lower than or equal to 5000 W. A power source may be provided to the microwave treatment apparatus to apply RF to the substrate side. Furthermore, application of RF to the substrate side allows oxygen ions generated by the high-density plasma to be introduced into the oxide 230b efficiently.

The microwave treatment is preferably performed under reduced pressure, and the pressure may be higher than or equal to 10 Pa and lower than or equal to 1000 Pa, preferably higher than or equal to 300 Pa and lower than or equal to 700 Pa. The treatment temperature may be lower than or equal to 750 °C, preferably lower than or equal to 500 °C, and is approximately 400 °C, for example. The oxygen plasma treatment can be followed successively by heat treatment without exposure to air. For example, the temperature may be higher than or equal to 100 °C and lower than or equal to 750 °C, preferably higher than or equal to 300 °C and lower than or equal to 500 °C.

Furthermore, the microwave treatment is performed using an oxygen gas and an argon gas, for example. The oxygen flow rate ratio (O₂/(O₂ + Ar)) is greater than 0 % and less than or equal to 100 %, preferably greater than 0 % and less than or equal to 50 %, further preferably greater than or equal to 10 % and less than or equal to 40 %, still further preferably greater than or equal to 10 % and less than or equal to 30 %. The carrier concentration in the oxide 230b can be reduced by thus performing the microwave treatment in an atmosphere containing oxygen. In addition, the carrier concentrations in the oxide 230a and the oxide 230b can be prevented from being excessively reduced by preventing an excess amount of oxygen from being introduced into the chamber in the microwave treatment.

The microwave treatment in an oxygen-containing atmosphere converts an oxygen gas into plasma using a high-frequency wave such as a microwave or RF and makes the oxygen plasma act on the oxide 230b. At this time, the region 230b can also be irradiated with the high-frequency wave such as the microwave or RF. In other words, the microwave, the high-frequency wave such as RF, the oxygen plasma, or the like can be applied to the oxide 230b. The effect of the plasma, the microwave, or the like enables VoH in the oxide 230b to be cut, and hydrogen to be removed from the oxide 230b. That is, VoH contained in the oxide 230b can be reduced. As a result, oxygen vacancies and VoH in the oxide 230b can be reduced to lower the carrier concentration. In addition, oxygen radicals generated by the oxygen plasma or oxygen contained in the insulator 275a can be supplied to oxygen vacancies formed in the oxide 230b, thereby further reducing oxygen vacancies and lowering the carrier concentration in the oxide 230b.

Furthermore, the insulating film 275A having a barrier property against oxygen is provided in contact with the side surfaces of the conductor 242b. Thus, formation of an oxide film on the side surface of the conductor 242b by the microwave treatment can be inhibited.

Furthermore, the film quality of the insulating film 275A can be improved, leading to higher reliability of the transistor 200.

Next, an insulating film 250A is formed over the insulating film 275A (see FIG. 9C and FIG. 9D). The insulating film 250A can be formed by a sputtering method, a CVD method, an MBE method, a PLD method, an ALD method, or the like. The insulating film 250A is preferably formed using an insulator having a function of inhibiting diffusion of oxygen. With such a structure, oxidation of the conductor 260 due to oxygen contained in the oxide 230 can be inhibited. As the insulating film 250A, for example, a hafnium oxide film may be formed by a thermal ALD method.

Note that for the insulating film 250A, a high dielectric constant (high-k) material may be used. In this case, the equivalent oxide thickness (EOT) of the insulator functioning as the gate insulator can be reduced. Therefore, the breakdown voltage of the gate insulator can be increased.

Note that it is preferable that the insulating film 275A and the insulating film 250A be formed successively without being exposed to the atmospheric environment. By the deposition without exposure to the air, impurities or moisture from the atmospheric environment can be prevented from being attached onto the insulating film 275A and the insulating film 250A, so that the vicinity of an interface between the insulating film 275A and the insulating film 250A can be kept clean.

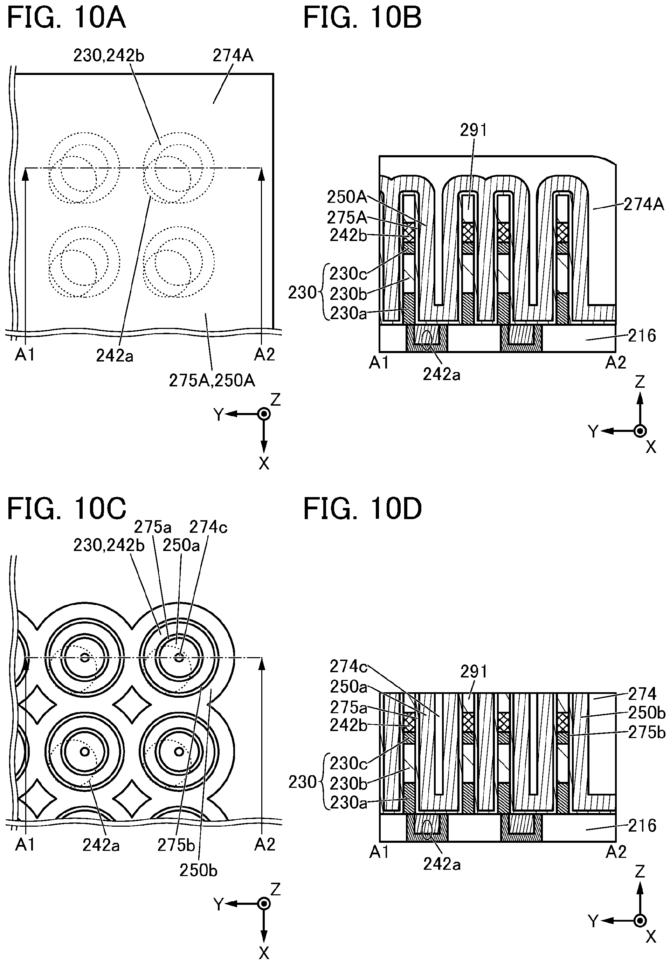

Next, an insulating film 274A is formed over the insulating film 250A (see FIG. 10A and FIG. 10B). The insulating film 274A can be formed by a sputtering method, a CVD method, an MBE method, a PLD method, an ALD method, or the like. A silicon oxide film may be deposited by a sputtering method as the insulating film 274A, for example. By using a sputtering method that does not need to use a molecule containing hydrogen as a deposition gas, the hydrogen concentration in the insulating film 274A can be reduced. Note that heat treatment may be performed before the insulating film 274A is deposited. In this embodiment, for the insulator film 274A, silicon oxide film is deposited by a CVD method.

Next, the insulating film 274A, the insulating film 250A, and the insulating film 275A are processed by CMP treatment until the insulator 291 is exposed. By the CMP treatment, the insulator 274 and an insulator 274c are formed from the insulating film 274A, the insulator 250a and the insulator 250b are formed from the insulating film 250A, and the insulator 275a and the insulator 275b are formed from the insulating film 275A (see FIG. 10C and FIG. 10D).

As described above, each of the oxide 230, the conductor 242b, and the insulator 291 has a hollow cylindrical shape. That is, the stack of the oxide 230, the conductor 242b, and the insulator 291 has a hollow cylindrical shape. The insulator 275a is provided to be in contact with the inner wall of the hollow portion of the stack, part of the top surface of the insulator 216, and at least part of the top surface of the conductor 242a. The insulator 250a is provided to be in contact with the inner wall of the depressed portion formed in the insulator 275a. The insulator 274c is provided to fill the depressed portion formed in the insulator 250a.

The insulator 275b is provided to be in contact with the side surface on the outer side of the above-described stack and part of the top surface of the insulator 216. Note that the insulator 275b includes a region in contact with the conductor 242a, in some cases. The insulator 250b is provided to be in contact with the top surface of the insulator 275b, and the insulator 274 is provided to be in contact with the top surface of the insulator 250b.

The top surface of the insulator 291 is partly removed by the CMP treatment in some cases.

The top surface of the insulator 274 is level or substantially level with the top surface of the insulator 291 and the top surface of the insulator 274c. The uppermost portions of the insulator 250a, the insulator 250b, the insulator 275a, and the insulator 275b are level or substantially level with each other.

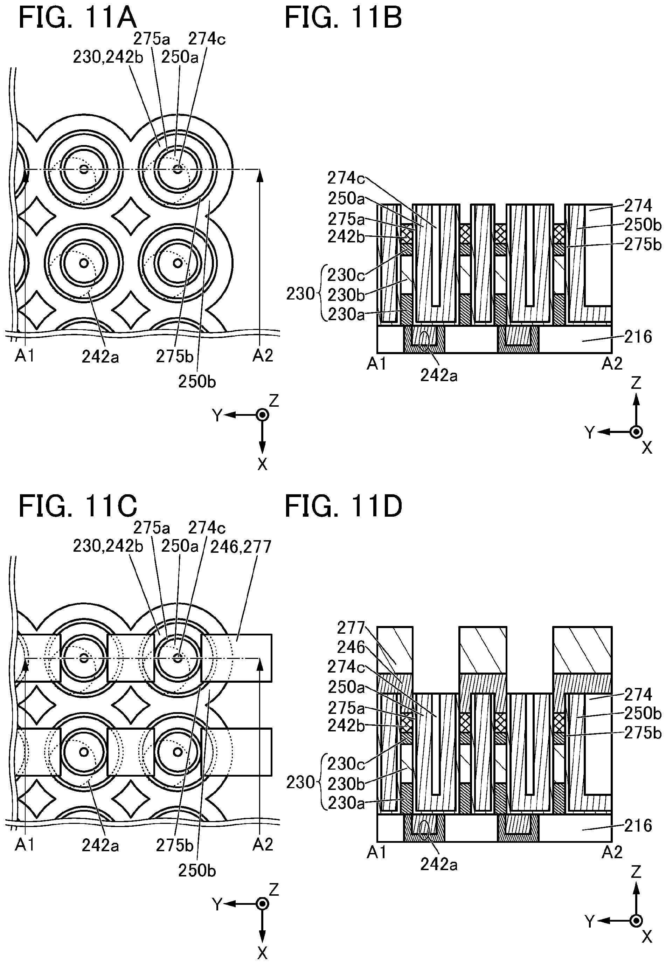

Next, the insulator 291 is removed to expose the top surface of the conductor 242b (see FIG. 11A and FIG. 11B). A dry etching method or a wet etching method is preferably used for the removal of the insulator 291.

By removing the insulator 291, the top surface of the conductor 242b can be exposed in a self-aligned manner. Thus, the conductor 246 formed later can be placed in contact with the conductor 242b surely without alignment. Note that in the case where the insulator 291 is removed by etching, an etching condition with a high selectivity is preferably employed so that the insulator 274c is not removed by the etching. Thus, after the insulator 291 is removed, the insulator 274c can remain.

Next, a conductive film to be the conductor 246 and an insulating film to be the insulator 277 are formed in this order. The conductive film and the insulating film can be deposited by a sputtering method, a CVD method, an MBE method, a PLD method, an ALD method, or the like.

Next, part of the conductive film to be the conductor 246 and part of the insulating film to be the insulator 277 are processed by a lithography method (see FIG. 11C and FIG. 11D). By the processing, the conductor 246 and the insulator 277 can be formed. The conductor 246 has a projecting portion in a region overlapping with the conductor 242b. Wet etching can be used for the processing; however, dry etching is preferably used for microfabrication.

Next, an insulating film to be the insulator 278 is formed over the insulator 277, the insulator 274, and the like. The insulating film can be deposited by a sputtering method, a CVD method, an MBE method, a PLD method, an ALD method, or the like. The insulating film may be deposited using the same material as the insulating film to be the insulator 277 or may be deposited using different materials.

Next, the insulating film to be the insulator 278 is processed by CMP treatment until the insulator 277 is exposed. By the CMP treatment, the insulator 278 having a flat top surface is formed.

The top surface of the insulator 277 is partly removed by the CMP treatment in some cases.

Next, openings are formed in regions of the insulator 278 that overlap with the insulator 274c, the insulator 250a, and the insulator 275a (see FIG. 12A to FIG. 12B2). Note that in the case where the resist mask 292 is formed using the above-described multi-patterning technique, the above-described multi-chamber technique is used also in the case where an opening is formed in the insulator 278.

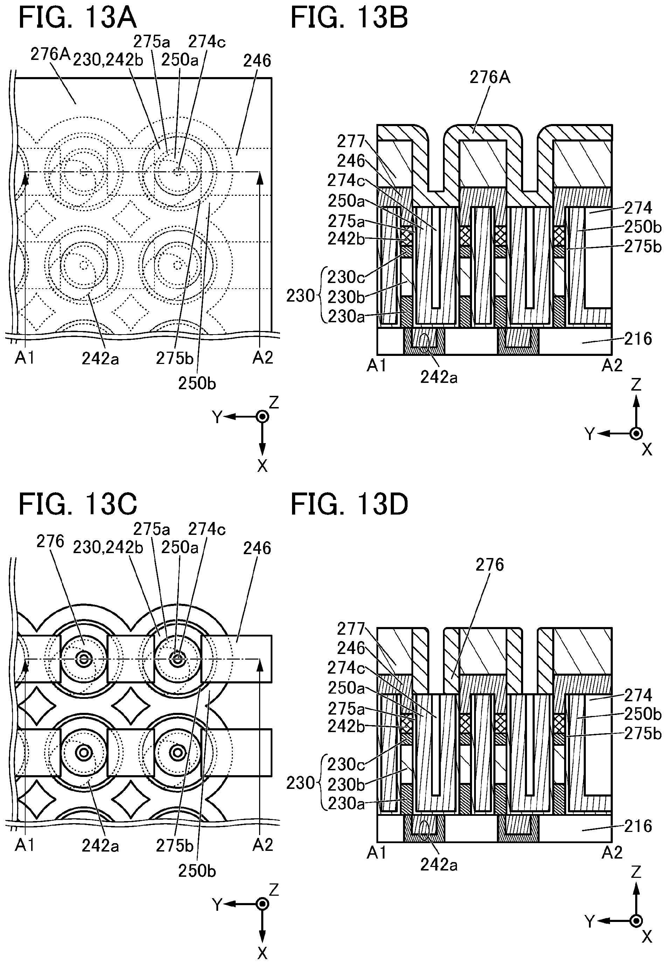

Next, an insulating film 276A is formed over the insulator 277 and the insulator 278 (see FIG. 13A and FIG. 13B). The insulating film 276A can be deposited by a sputtering method, a CVD method, an MBE method, a PLD method, an ALD method, or the like.

The insulating film 276A is preferably deposited by an ALD method. Furthermore, the insulating film 276A needs to be formed on the bottom and side surfaces of the opening formed in the insulator 278 and the like so as to have favorable coverage. An ALD method enables an atomic layer to be deposited one by one on the bottom surface and the side surface of the opening, whereby the insulating film 276A can be formed in the opening with good coverage. In this embodiment, a silicon nitride film is deposited as the insulating film 276A by a PEALD method.

Next, the insulating film 276A is subjected to anisotropic etching to form the insulator 276 (see FIG. 13C and FIG. 13D). By forming the insulator 276, part of the top surface of the insulator 250a and the top surface of the insulator 274c are exposed.

For the anisotropic etching, a dry etching method is preferably employed, for example. When the insulator 276 is provided on the side wall of the opening, the conductor 246 can physically keep a distance from the conductor 260 formed later. Thus, electrical continuity between the conductor 246 and the conductor 260 can be prevented. In other words, the conductor 246 and the conductor 260 can be prevented from being electrically connected to each other.

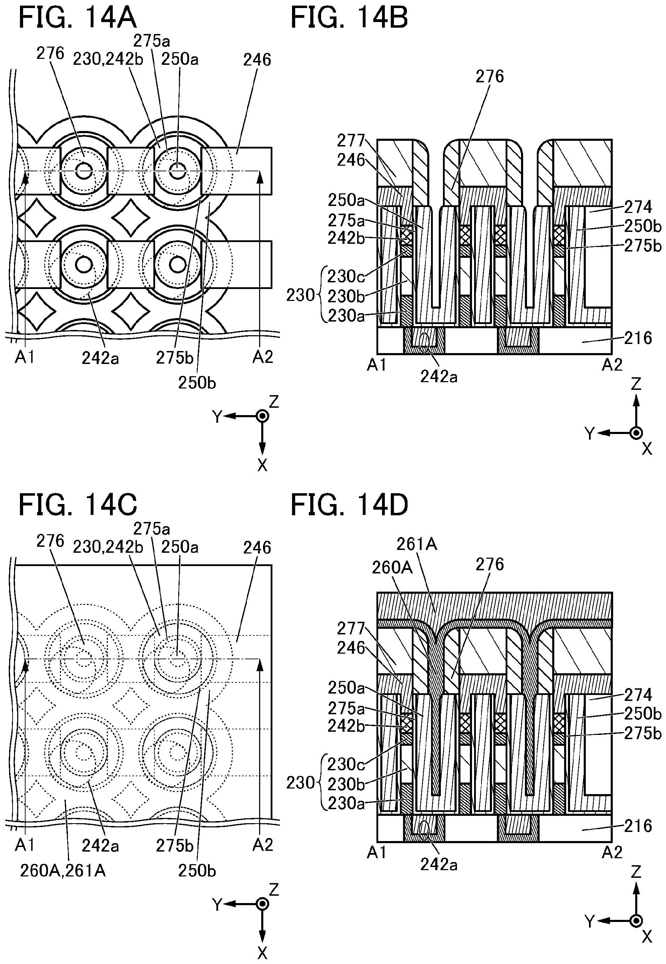

Next, the insulator 274c is removed (see FIG. 14A and FIG. 14B). A dry etching method or a wet etching method is preferably used for the removal of the insulator 274c.

Note that in the case where the insulator 274c is removed by etching, an etching condition with a high selectivity is preferably employed so that the insulator 250a and the insulator 276 are not removed by the etching. Thus, after the insulator 274c is removed, the insulator 250a and the insulator 276 can remain.

Next, a conductive film 260A and a conductive film 261A are formed in this order (see FIG. 14C and FIG. 14D). The conductive film 260A and the conductive film 261A can be deposited by a sputtering method, a CVD method, an MBE method, a PLD method, an ALD method, or the like. In this embodiment, a titanium nitride film is deposited by an ALD method for the conductive film 260A and a tungsten film is deposited by a CVD method for the conductive film 261A.

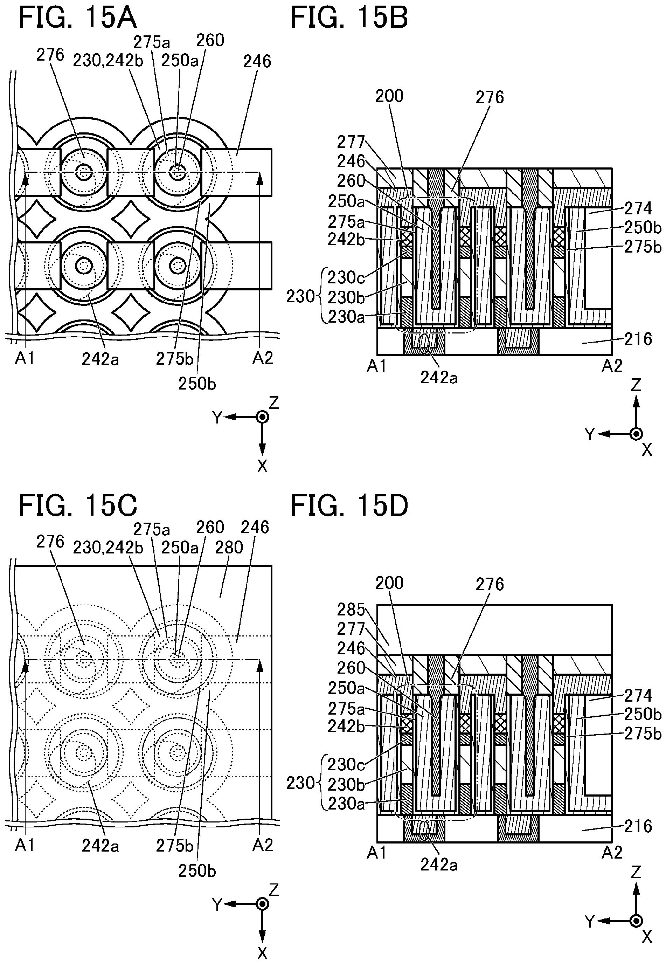

Next, the conductive film 260A and the conductive film 261A are processed by CMP treatment until the insulator 277 and the insulator 278 are exposed, whereby the conductor 260 is formed (see FIG. 15A and FIG. 15B). Accordingly, the conductor 260 is placed to fill the opening in the insulator 276 and the depressed portion of the insulator 250a. The conductor 260 is placed to fill the opening formed in the oxide 230 with the insulator 275a and the insulator 250a therebetween.

Note that although part of the conductive film 260A remains in the opening of the insulator 276 and the depressed portion of the insulator 250a in FIG. 15B, the conductor 260 is formed; however, the present invention is not limited thereto. Depending on the conditions of the CMP treatment, the size, depth, or the like of the opening of the insulator 276, or the like, part of the conductive film 260A and part of the conductive film 261A remain in the opening of the insulator 276 and the depressed portion of the insulator 250a in some cases. At this time, the conductor 260 has a stacked-layer structure of a conductor formed from the conductive film 260A and a conductor formed from the conductive film 261A. In the case where only the conductive film 260A remains in the opening of the insulator 276 and the depressed portion of the insulator 250a as illustrated in FIG. 15B, the conductive film 261A is not necessarily deposited.

By the above CMP treatment, part of the insulator 277 and part of the insulator 278 are removed in some cases. Part of the conductive film 261A remains in the opening in the insulator 276 in some cases.

Next, the insulator 285 is formed over the insulator 276, the insulator 277, the insulator 278, and the conductor 260 (see FIG. 15C and FIG. 15D). The insulator 285 can be deposited by a sputtering method, a CVD method, an MBE method, a PLD method, an ALD method, or the like. The insulator 285 is preferably deposited by a sputtering method. By using a sputtering method that does not need to use a molecule containing hydrogen as a deposition gas, the hydrogen concentration in the insulator 285 can be reduced.

In this embodiment, for the insulator 285, silicon oxide is deposited by a sputtering method.

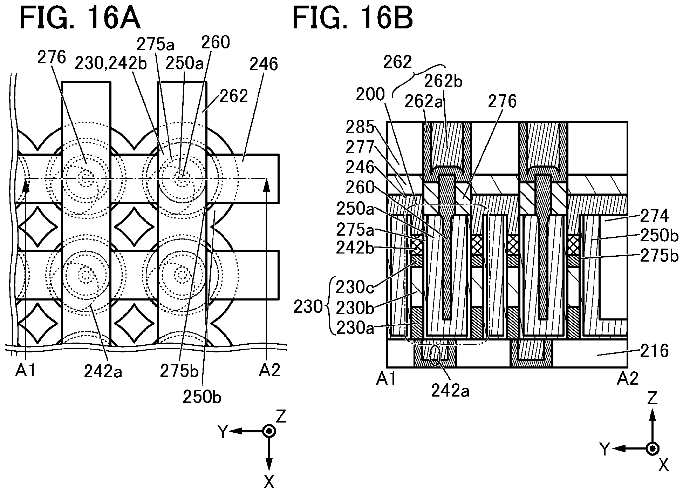

Next, an opening is formed in the insulator 285 (see FIG. 16A and FIG. 16B). By forming the opening, the top surface of the insulator 276 and the top surface of the conductor 260 are exposed. Wet etching can be used for the formation of the opening; however, dry etching is preferably used for microfabrication.

When an opening is formed in the insulator 285, part of the insulator 276 is removed as illustrated in FIG. 16B in some cases.

Next, a conductive film to be the conductor 262a and a conductive film to be the conductor 262b are formed in this order, and the conductive film to be the conductor 262a and the conductive film to be the conductor 262b are processed until the insulator 285 is exposed by CMP treatment. Thus, the conductor 262 (the conductor 262a and the conductor 262b) is formed (see FIG. 16A and FIG. 16B). The conductive film to be the conductor 262a and the conductive film to be the conductor 262b can be deposited by a sputtering method, a CVD method, an MBE method, a PLD method, an ALD method, or the like. In this embodiment, a titanium nitride film is deposited by an ALD method as the conductive film to be the conductor 262a, and a tungsten film is deposited by a CVD method as the conductive film to be the conductor 262b.

Note that in the case where the conductor 260 and the conductor 262a are formed using the same material, the boundaries between the conductor 260 and the conductor 262a are difficult to detect clearly in some cases.

Through the above process, the semiconductor device including the transistor 200 illustrated in FIG. 5A to FIG. 5C can be manufactured. As illustrated in FIG. 8A to FIG. 16B, with use of the method for manufacturing the semiconductor device described in this embodiment, the transistor 200 can be manufactured.

According to one embodiment of the present invention, a semiconductor device that can be miniaturized or highly integrated can be provided. Alternatively, a semiconductor device with a small variation in transistor electrical characteristics can be provided. Alternatively, a semiconductor device with high reliability can be provided. Alternatively, a semiconductor device having favorable electrical characteristics can be provided. A semiconductor device with a high on-state current can be provided.

This embodiment can be combined with the other embodiments as appropriate. In this specification, in the case where a plurality of structure examples are described in one embodiment, the structure examples can be combined as appropriate.

### (Embodiment 3)

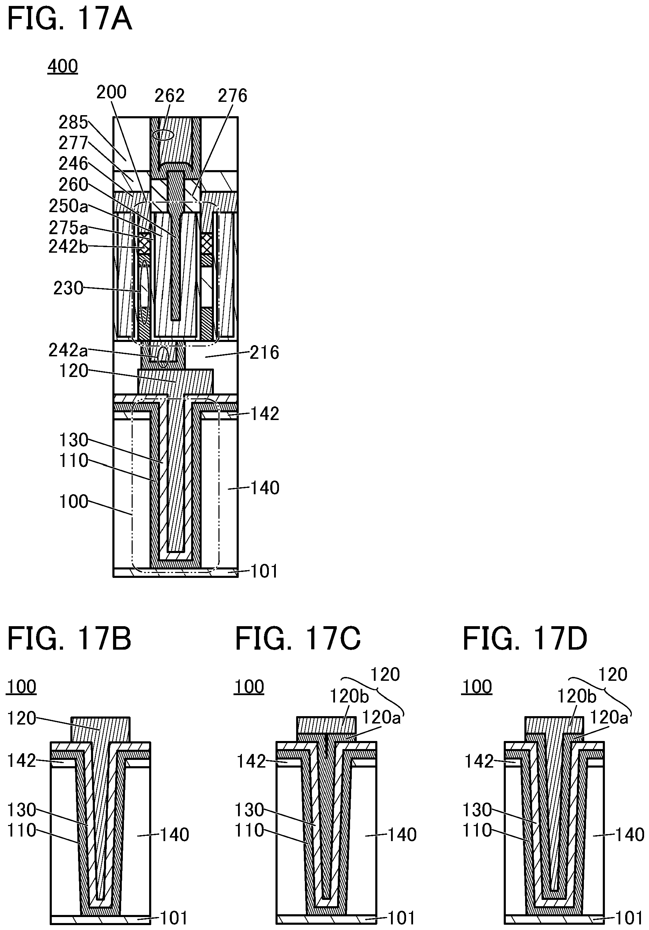

In this embodiment, a storage device that is one embodiment of the semiconductor device of the present invention will be described with reference to FIG. 17A to FIG. 18E.

FIG. 17A illustrates an example of a storage device of one embodiment of the semiconductor device of the present invention. A storage device 400 includes the transistor 200 and a capacitor 100. The transistor 200 is provided above the capacitor 100. Note that the transistor 20 described in Embodiment 1 or the transistor 200 described in Embodiment 2 can be used as the transistor 200.

Note that the storage device 400 illustrated in FIG. 17A includes the conductor 246 and the conductor 262 that are electrically connected to the transistor 200. Note that the conductor 246 corresponds to the conductor 46 described in Embodiment 1 or the conductor 246 described in Embodiment 2. The conductor 262 corresponds to the conductor 62 described in Embodiment 1 or the conductor 262 described in Embodiment 2. That is, the storage device 400 illustrated in FIG. 17A can also be regarded as including the semiconductor device described in Embodiment 1 or the semiconductor device described in Embodiment 2 and the capacitor 100. The semiconductor device is provided above the capacitor 100.

The transistor 200 is a transistor in which a channel is formed in a semiconductor layer including an oxide semiconductor. Since the transistor 200 has a low off-state current, a storage device that uses the transistor 200 can retain stored data for a long time. In other words, such a storage device does not require refresh operation or has extremely low frequency of the refresh operation, which leads to a sufficient reduction in power consumption of the storage device.

The storage device 400 illustrated in FIG. 17A includes one transistor 200 and one capacitor 100. A memory cell array can be formed when the storage devices 400 are arranged in a matrix.

In this specification and the like, a DRAM using a memory cell including one OS transistor and one capacitor is referred to as a DOSRAM (Dynamic Oxide Semiconductor Random Access Memory) in some cases.

The conductor 242a is electrically connected to the capacitor 100. As described in the above embodiment, the conductor 242a can be placed at a position off from the center of the hollow cylindrical shape of the oxide 230. With such a structure, a layout enabling miniaturization without a self-aligned contact can be obtained, whereby 4F² can be achieved.

When the transistor 200 is provided above the capacitor 100, the transistor 200 is not affected by thermal budget in fabricating the capacitor 100. Thus, in the transistor 200, degradation of the electrical characteristics such as variation in threshold voltage or an increase in parasitic resistance, and an increase in variation in electrical characteristics due to the degradation of the electrical characteristics can be inhibited.

The storage device 400 illustrated in FIG. 17A includes an insulator 140 over a substrate 101, an insulator 142 over the insulator 140, the capacitor 100 over the substrate 101, the insulator 140, and the insulator 142, the insulator 216 over the capacitor 100, and the transistor 200 over the insulator 216. An opening is formed in the insulator 140 and the insulator 142.

Note that the upper components of the transistor 200 illustrated in FIG. 17A (the conductor 246, the conductor 262, the insulator 276, the insulator 277, the insulator 285, and the like) are the same as those of the semiconductor device described in Embodiment 2. Thus, the description in Embodiment 2 is referred to for the upper components of the transistor 200 illustrated in FIG. 17A. The storage device 400 illustrated in FIG. 17A can be regarded as including the semiconductor device described in Embodiment 2 above the capacitor 100.

As the substrate 101, a substrate having at least heat resistance high enough to withstand the following heat treatment can be used. In the case where an insulating substrate is used as the substrate 101, a glass substrate, a quartz substrate, a sapphire substrate, a ceramic substrate, an organic resin substrate, or the like can be used. Alternatively, a single crystal semiconductor substrate or a polycrystalline semiconductor substrate using silicon, silicon carbide, or the like, a compound semiconductor substrate of silicon germanium or the like, a semiconductor substrate such as an SOI substrate, or the like can be used.

As the substrate 101, it is particularly preferable to use the above semiconductor substrate or the insulating substrate where a semiconductor circuit including a semiconductor element such as a transistor is formed. The semiconductor circuit preferably forms a pixel circuit, a gate line driver circuit (a gate driver), a source line driver circuit (a source driver), or the like. In addition to the above, an arithmetic circuit, a storage circuit, or the like may be formed.

### <Capacitor 100>

The capacitor 100 is provided below the transistor 200. The capacitor 100 illustrated in FIG. 17A has a cylindrical shape.

The capacitor 100 illustrated in FIG. 17A includes a conductor 110 in an opening formed in the insulator 140 and the insulator 142 and positioned over the substrate 101, an insulator 130 over the conductor 110, and a conductor 120 over the insulator 130. Here, at least parts of the conductor 110, the insulator 130, and the conductor 120 are positioned in the opening formed in the insulator 140 and the insulator 142.

The conductor 110 functions as the lower electrode of the capacitor 100, the conductor 120 functions as the upper electrode of the capacitor 100, and the insulator 130 functions as the dielectric of the capacitor 100. The capacitor 100 has a structure in which the upper electrode and the lower electrode face each other with the dielectric interposed therebetween on the side surface as well as the bottom surface of the opening in the insulator 140 and the insulator 142; thus, the capacitance per unit area can be increased. Thus, the deeper the opening is, the larger the capacitance of the capacitor 100 can be. Increasing the capacitance per unit area of the capacitor 100 in this manner can promote miniaturization or higher integration of the semiconductor device.

The insulator 142 preferably functions as an etching stopper at the time of forming the opening in the insulator 140 and is preferably formed using an insulator that can be used as the insulator 212 described in Embodiment 2.

The shape of the opening formed in the insulator 140 and the insulator 142 when seen from above may be a circular shape including an ellipse, a quadrangular shape, a polygonal shape other than a quadrangular shape, or a polygonal shape with rounded corners. Here, the area where the opening and the transistor 200 overlap with each other is preferably large in the top view. Such a structure can reduce the area occupied by the semiconductor device including the capacitor 100 and the transistor 200.

The conductor 110 is placed in contact with the opening formed in the insulator 142 and the insulator 140 and in contact with the top surface of the substrate 101. The conductor 110 is preferably deposited by an ALD method, a CVD method, or the like and is formed using a conductor that can be used for the conductor 242a described in Embodiment 2, for example. The conductor 110 may be provided to be shared by adjacent capacitors 100. Alternatively, the conductor 110 may be provided for each capacitor 100. That is, the conductor 110 may be isolated between adjacent capacitors 100.

The insulator 130 is placed to cover the conductor 110. The insulator 130 is preferably deposited by an ALD method or a CVD method, for example. The insulator 130 can be provided as stacked layers or a single layer using, for example, silicon oxide, silicon oxynitride, silicon nitride oxide, silicon nitride, zirconium oxide, aluminum oxide, aluminum oxynitride, aluminum nitride oxide, aluminum nitride, hafnium oxide, hafnium oxynitride, hafnium nitride oxide, or hafnium nitride. As the insulator 130, an insulating film in which zirconium oxide, aluminum oxide, and zirconium oxide are stacked in this order can be used, for example.

For the insulator 130, a material with high dielectric strength, such as silicon oxynitride, or a high dielectric constant (high-k) material is preferably used. Alternatively, a stacked-layer structure of a material with high dielectric strength and a high dielectric constant (high-k) material may be used.

Examples of a high dielectric constant (high-k) material include gallium oxide, hafnium oxide, zirconium oxide, an oxide containing aluminum and hafnium, an oxynitride containing aluminum and hafnium, an oxide containing silicon and hafnium, an oxynitride containing silicon and hafnium, and a nitride containing silicon and hafnium. The use of such a high-k material can ensure sufficient capacitance of the capacitor 100 even when the insulator 130 has a large thickness. When the insulator 130 has a large thickness, leakage current generated between the conductor 110 and the conductor 120 can be inhibited.

Examples of the material with high dielectric strength include silicon oxide, silicon oxynitride, silicon nitride oxide, silicon nitride, silicon oxide to which fluorine is added, silicon oxide to which carbon is added, silicon oxide to which carbon and nitrogen are added, porous silicon oxide, and a resin. For example, it is possible to use an insulating film in which silicon nitride deposited by a PEALD method, silicon oxide deposited by a PEALD method, and silicon nitride deposited by a PEALD method are stacked in this order. Alternatively, an insulating film in which zirconium oxide, silicon oxide deposited by an ALD method, and zirconium oxide are stacked in this order can be used. The use of such an insulator with high dielectric strength can increase the dielectric strength and inhibit electrostatic breakdown of the capacitor 100.

The conductor 120 is placed to fill the opening formed in the insulator 142 and the insulator 140. The conductor 120 is electrically connected to the conductor 242a. The conductor 120 is preferably deposited by an ALD method, a CVD method, or the like and is formed using a conductor that can be used for the conductor 242a described in Embodiment 2, for example.

Although FIG. 17A illustrates a structure in which the side surface of the opening formed in the insulator 140 and the insulator 142 is perpendicular to the substrate 101, the present invention is not limited thereto. For example, as illustrated in FIG. 17B, the side surface of the opening formed in the insulator 140 and the insulator 142 may have a tapered shape. With the opening whose side surface has such a tapered shape, the coverage with the conductor 110, the insulator 130, and the like can be improved in a later step, so that defects such as a void can be reduced.

Although FIG. 17A and FIG. 17B illustrate a single-layer structure of the conductor 120, the present invention is not limited to this structure, and the conductor 120 may have a stacked-layer structure of two or more layers. For example, as illustrated in FIG. 17C, the conductor 120 may have a stacked-layer structure of a conductor 120a and a conductor 120b over the conductor 120a.

For example, the conductor 120a may be formed using a conductor that can be used as the conductor 242a1 described in Embodiment 2. For example, the conductor 120b may be formed using a conductor that can be used for the conductor 242a2 described in Embodiment 2.

In FIG. 17C, the lowermost portion of the conductor 120b is positioned closer to the transistor 200 than the top surface of the insulator 140 or the insulator 142 is. However, as illustrated in FIG. 17D, the lowermost portion of the conductor 120b is positioned closer to the substrate than the top surface of the insulator 140 or the insulator 142 is, in some cases, depending on the diameter size of the opening, the taper angle of the side surface of the opening, and the thicknesses of the conductor 110, the insulator 130, and the conductor 120a.

### <Variation example of capacitor 100>

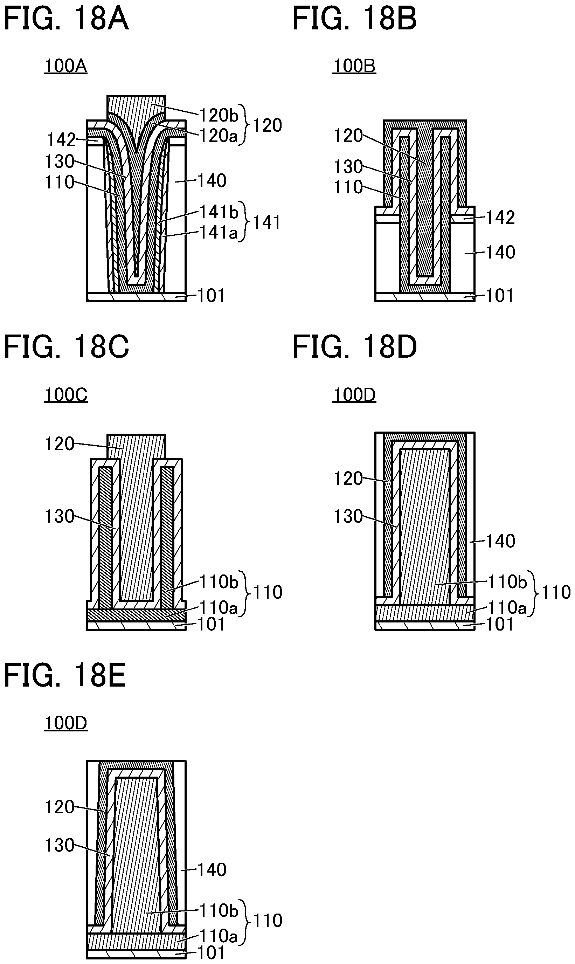

A structure example different from that of the above-described capacitor 100 is described below with reference to FIG. 18A to FIG. 18E.

### [Capacitor 100A]

FIG. 18A is a cross-sectional view of a capacitor 100A. The capacitor 100A illustrated in FIG. 18A is a variation example of the capacitor 100 illustrated in FIG. 17C.

The capacitor 100A illustrated in FIG. 18A is different from the capacitor 100 illustrated in FIG. 17C in including an insulator 141a and an insulator 141b.

The insulator 141a is provided in contact with an inner wall of an opening formed in the insulator 140 and the insulator 142, and the insulator 141b is provided in contact with the side surface of the insulator 141a. Hereinafter, the insulator 141a and the insulator 141b are collectively referred to as an insulator 141, in some cases.

The conductor 110 is provided in contact with the side surface of the insulator 141b and the top surface of the substrate 101. The insulator 130 is provided on the inner side of the conductor 110. The conductor 120 is provided on the inner side of the insulator 130 to fill the opening formed in the insulator 140 and the insulator 142.

For the insulator 141, for example, a barrier insulating film that can be used for the insulator 275a described in Embodiment 2 or the like may be used. For the insulator 141, for example, an insulator such as silicon nitride, aluminum oxide, or silicon nitride oxide can be used. Since the insulator 141 is provided in contact with the insulator 142, impurities such as water and hydrogen contained in the insulator 140 and the like can be inhibited from entering the oxide 230 through the conductor 110. In particular, silicon nitride is suitable because of its high blocking property against hydrogen. Moreover, oxygen contained in the insulator 140 can be prevented from being absorbed by the conductor 110.

In the case where the insulator 141 has a stacked-layer structure illustrated in FIG. 18A, the insulator 141a in contact with an inner wall of the opening in the insulator 140 and the like and the insulator 141b on the inner side of the insulator 141a are preferably formed using a combination of a barrier insulating film against oxygen and a barrier insulating film against hydrogen.

For example, aluminum oxide deposited by an ALD method may be used as the insulator 141a and silicon nitride deposited by a PEALD method may be used as the insulator 141b. With such a structure, oxidation of the conductor 110 can be inhibited, and hydrogen can be prevented from entering the conductor 110.

Although the capacitor 100A has a structure in which the insulator 141a and the insulator 141b are stacked, one embodiment of the present invention is not limited to this structure. For example, the insulator 141 may have a single-layer structure or a stacked-layer structure of three or more layers.

### [Capacitor 100B]

FIG. 18B is a cross-sectional view of a capacitor 100B. The capacitor 100B illustrated in FIG. 18B is a variation example of the capacitor 100 illustrated in FIG. 17A.

The capacitor 100B illustrated in FIG. 18B is different from the capacitor 100 illustrated in FIG. 17A in the shapes of the insulator 130 and the conductor 120.

The insulator 130 is in contact with the inner side of the depressed portion of the conductor 110 and the top surface of the conductor 110. Furthermore, the insulator 130 includes a region in contact with part of an outer side surface of the conductor 110. The insulator 130 includes a region in contact with the insulator 142.

The conductor 120 is provided to fill the opening in the conductor 110. Furthermore, the conductor 120 includes a region overlapping with the part of the outer side surface of the conductor 110 with the insulator 130 therebetween.

With the above structure, the capacitance per unit area can be further increased.

### [Capacitor 100C]

FIG. 18C is a cross-sectional view of a capacitor 100C. The capacitor 100C illustrated in FIG. 18C is a variation example of the capacitor 100 illustrated in FIG. 17A.

The capacitor 100C illustrated in FIG. 18C is different from the capacitor 100 illustrated in FIG. 17A in the shape of the conductor 110.

The conductor 110 includes a conductor 110a over the substrate 101 and a conductor 110b over the conductor 1 10a. The conductor 110b has a cylindrical shape with a hollow portion. The conductor 110b having a cylindrical shape with a hollow portion can be formed with reference to the method for forming the conductor 242b described in Embodiment 2.

The insulator 130 is provided to be in contact with the side surface and the top surface of the conductor 110b and the top surface of the conductor 110a.

The conductor 120 is provided to fill the hollow portion of the conductor 110b with the insulator 130 therebetween.

With this structure, the same mask can be used for the formation of the transistor 200 and the formation of the capacitor 100C, whereby the manufacturing cost of the memory device 400 can be reduced.

### [Capacitor 100D]

FIG. 18D is a cross-sectional view of a capacitor 100D. The capacitor 100D illustrated in FIG. 18D is a variation example of the capacitor 100 illustrated in FIG. 17A.

The capacitor 100D illustrated in FIG. 18D is different from the capacitor 100 illustrated in FIG. 17A in the shape of the conductor 110.

The conductor 110 includes the conductor 110a over the substrate 101 and the conductor 110b over the conductor 1 10a. The conductor 110b has a cylindrical shape.

The insulator 130 is provided to be in contact with the side surface and the top surface of the conductor 110b and the top surface of the conductor 110a.

The conductor 120 is preferably provided to cover the side surface and the top surface of the conductor 110b with the insulator 130 therebetween.

Although FIG. 18D illustrates a structure in which the side surface of the conductor 110b is perpendicular to the substrate 101, the present invention is not limited thereto. For example, as illustrated in FIG. 18E, the side surface of the conductor 110b may have a tapered shape. With the opening whose side surface has a tapered shape, the coverage with the insulator 130 and the conductor 120 can be improved in a later step, so that defects such as a void can be reduced.

The above is the description of the variation examples of the capacitor 100.

In the storage device of one embodiment of the present invention, a wiring layer provided with an interlayer film, a wiring, a plug, and the like may be provided in any one or more of a portion below a layer including the capacitor 100, a portion between a layer including the transistor 200 and the layer including the capacitor 100, and a portion above the layer including the transistor 200.

This embodiment can be combined with the other embodiments as appropriate. In this specification, in the case where a plurality of structure examples are described in one embodiment, the structure examples can be combined as appropriate.

### (Embodiment 4)

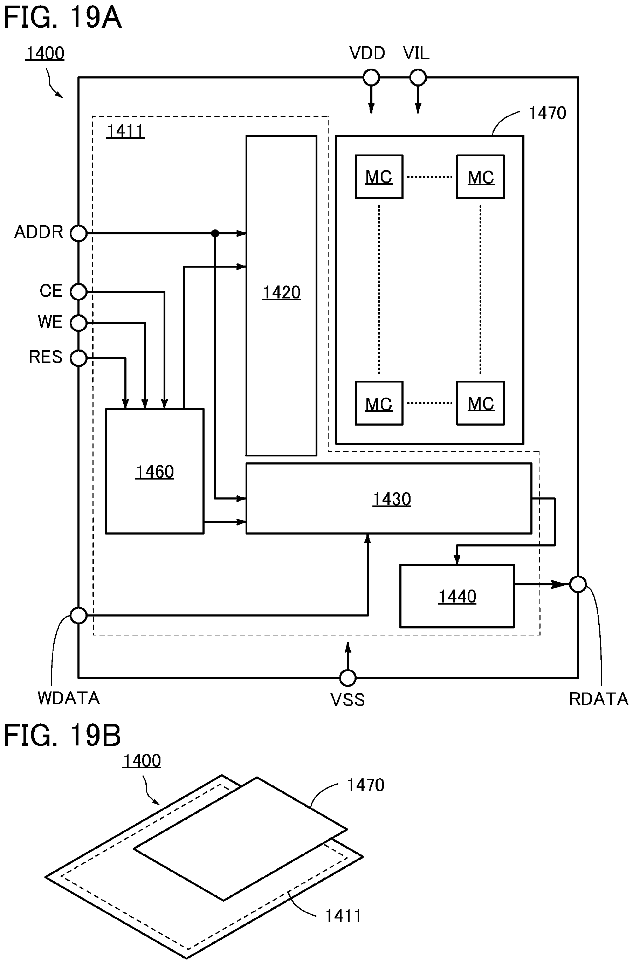

In this embodiment, a storage device of one embodiment of the present invention including a transistor in which an oxide is used as a semiconductor (hereinafter referred to as an OS transistor in some cases) and a capacitor (hereinafter the storage device is referred to as an OS memory device in some cases), will be described with reference to FIG. 19A to FIG. 21. The OS memory device is a storage device that includes at least a capacitor and an OS transistor that controls the charging and discharging of the capacitor. Since the OS transistor has an extremely low off-state current, the OS memory device has excellent retention characteristics and thus can function as a nonvolatile memory. Note that the transistor 20 described in Embodiment 1 or the transistor 200 described in Embodiment 2 can be used as the OS transistor.

### <Structure example of storage device>

FIG. 19A illustrates a structure example of the OS memory device. A storage device 1400 includes a peripheral circuit 1411 and a memory cell array 1470. The peripheral circuit 1411 includes a row circuit 1420, a column circuit 1430, an output circuit 1440, and a control logic circuit 1460.

The column circuit 1430 includes, for example, a column decoder, a precharge circuit, a sense amplifier, a write circuit, and the like. The precharge circuit has a function of precharging wirings. The sense amplifier has a function of amplifying a data signal read from a memory cell. Note that the wirings are connected to the memory cell included in the memory cell array 1470, and are described later in detail. The amplified data signal is output as a data signal RDATA to the outside of the storage device 1400 through the output circuit 1440. The row circuit 1420 includes, for example, a row decoder and a word line driver circuit, and can select a row to be accessed.

As power supply voltages from the outside, a low power supply voltage (VSS), a high power supply voltage (VDD) for the peripheral circuit 1411, and a high power supply voltage (VIL) for the memory cell array 1470 are supplied to the storage device 1400. Control signals (CE, WE, and RES), an address signal ADDR, and a data signal WDATA are also input to the storage device 1400 from the outside. The address signal ADDR is input to the row decoder and the column decoder, and the data signal WDATA is input to the write circuit.

The control logic circuit 1460 processes the control signals (CE, WE, and RES) input from the outside, and generates control signals for the row decoder and the column decoder. The control signal CE is a chip enable signal, the control signal WE is a write enable signal, and the control signal RES is a read enable signal. Signals processed by the control logic circuit 1460 are not limited thereto, and other control signals are input as necessary.

The memory cell array 1470 includes a plurality of memory cells MC arranged in a matrix and a plurality of wirings. Note that the number of wirings that connect the memory cell array 1470 to the row circuit 1420 depends on the structure of the memory cell MC, the number of memory cells MC in a column, and the like. The number of wirings that connect the memory cell array 1470 to the column circuit 1430 depends on the structure of the memory cell MC, the number of memory cells MC in a row, and the like.

Note that FIG. 19A illustrates an example in which the peripheral circuit 1411 and the memory cell array 1470 are formed on the same plane; however, this embodiment is not limited thereto. For example, as illustrated in FIG. 19B, the memory cell array 1470 may be provided to overlap with part of the peripheral circuit 1411. For example, the sense amplifier may be provided below the memory cell array 1470 so that they overlap with each other.

Furthermore, the memory cell array 1470 may have a stacked-layer structure. When a plurality of memory cell arrays 1470 are stacked, memory cells can be integrally positioned without increasing the area occupied by the memory cell arrays 1470. In other words, a 3D cell array can be formed. A high integration of memory cells is thus possible and a semiconductor device with high storage capacity can be provided.

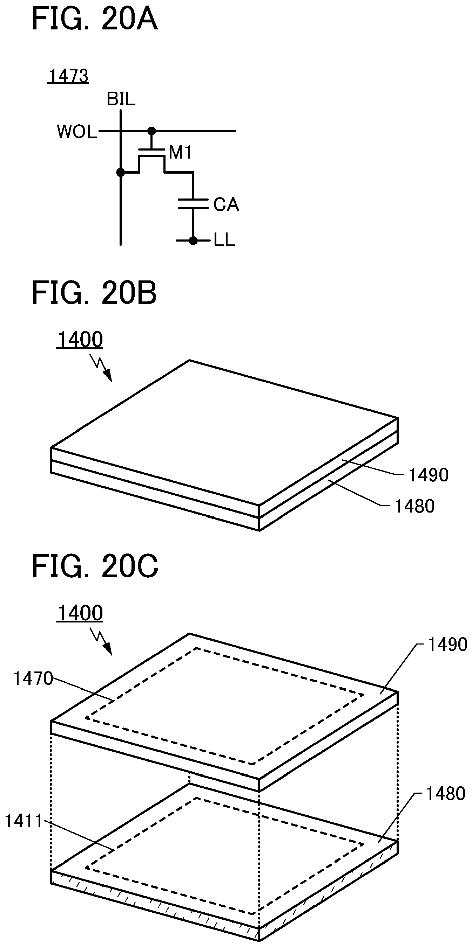

With FIG. 20A, a structure example of a memory cell applicable to the memory cell MC is described.

FIG. 20A illustrates a circuit configuration example of a memory cell of DOSRAM. A memory cell 1473 illustrated in FIG. 20A includes a transistor M1 and a capacitor CA. The transistor M1 is a single-gate transistor.

A first terminal of the transistor M1 is connected to a first terminal of the capacitor CA. A second terminal of the transistor M1 is connected to a wiring BIL. A gate of the transistor M1 is connected to a wiring WOL. A second terminal of the capacitor CA is connected to a wiring LL.

The wiring BIL functions as a bit line, and the wiring WOL functions as a word line. The wiring LL functions as a wiring for applying a predetermined potential to the second terminal of the capacitor CA. In the time of data writing and data reading, the wiring LL may be at a ground potential or a low-level potential.

Here, the memory cell 1473 illustrated in FIG. 20A corresponds to the storage device 400 illustrated in FIG. 17A. That is, the transistor M1 and the capacitor CA correspond to the transistor 200 and the capacitor 100, respectively. The wiring BIL corresponds to the conductor 246, and the wiring WOL corresponds to the conductor 262.

The circuit configuration of the memory cell MC is not limited to that of the memory cell 1473, and the circuit configuration can be changed.

In the case where the semiconductor device described in any of the above embodiments is used in the memory cell 1473 and the like, the transistor 200 can be used as the transistor M1, and the capacitor 100 can be used as the capacitor CA. When an OS transistor is used as the transistor M1, the off-state current of the transistor M1 can be extremely low. That is, with use of the transistor M1, written data can be retained for a long time, and thus the frequency of the refresh operation for the memory cell can be decreased. Alternatively, a refresh operation for the memory cell can be unnecessary. In addition, since the OS transistor has an extremely low leakage current, multi-level data or analog data can be retained in the memory cell 1473.

In the DOSRAM, when the sense amplifier is provided below the memory cell array 1470 so that they overlap with each other as described above, the bit line can be shortened. This reduces bit line capacitance, which can reduce the storage capacitance of the memory cell.

When an OS transistor is used as the transistor M1, the transistor M1 can be formed in a BEOL process for forming a wiring of the storage device. In the case where a Si transistor is used in the peripheral circuit 1411 that is below and overlaps with the memory cell array 1470, technology for forming an OS transistor directly above the Si transistor can be employed. With this technology, a 3D functional circuit can be constructed without a change in a design rule, and high functionality can be achieved with low power consumption and low cost.

FIG. 20B is a perspective view of the storage device 1400. The storage device 1400 includes a layer 1480 and a layer 1490. FIG. 20C is a perspective view for explaining the structure of the storage device 1400, illustrating the layer 1480 and the layer 1490 separately.

The layer 1480 includes a transistor, for example. A semiconductor layer including a channel formation region of the transistor may be formed using a semiconductor material such as a single crystal semiconductor, a polycrystalline semiconductor, a microcrystalline semiconductor, or an amorphous semiconductor alone or in combination. As the semiconductor material, silicon, germanium, or the like can be used. Alternatively, a compound semiconductor such as silicon germanium, silicon carbide, gallium arsenide, an oxide semiconductor, or a nitride semiconductor may be used. Alternatively, gallium arsenide, aluminum gallium arsenide, indium gallium arsenide, gallium nitride, indium phosphide, silicon germanium, or the like that can be used for a HEMT (High Electron Mobility Transistor) may be used.

The layer 1490 includes a transistor, for example. A semiconductor layer including a channel formation region of the transistor may be formed using a semiconductor material enabling formation of a thin film, such as an oxide semiconductor or silicon. With use of the BEOL-Tr technology, the layer 1490 can be provided over the layer 1480. Thus, miniaturization of the storage device 1400 can be achieved.

For example, the transistor included in the layer 1480 is a Si transistor. In this case, the peripheral circuit 1411 can be provided in the layer 1480. The transistor included in the layer 1490 is an OS transistor. In this case, the memory cell array 1470 can be provided in the layer 1480.

Accordingly, the storage device 1400 can be manufactured with use of the BEOL-Tr technology. Thus, the area occupied by the storage device 1400 can be reduced.

Note that the structures of the peripheral circuit 1411, the memory cell array 1470, and the like described in this embodiment are not limited to the above. The arrangement and functions of these circuits and the wirings, circuit components, and the like connected to the circuits can be changed, removed, or added as needed.

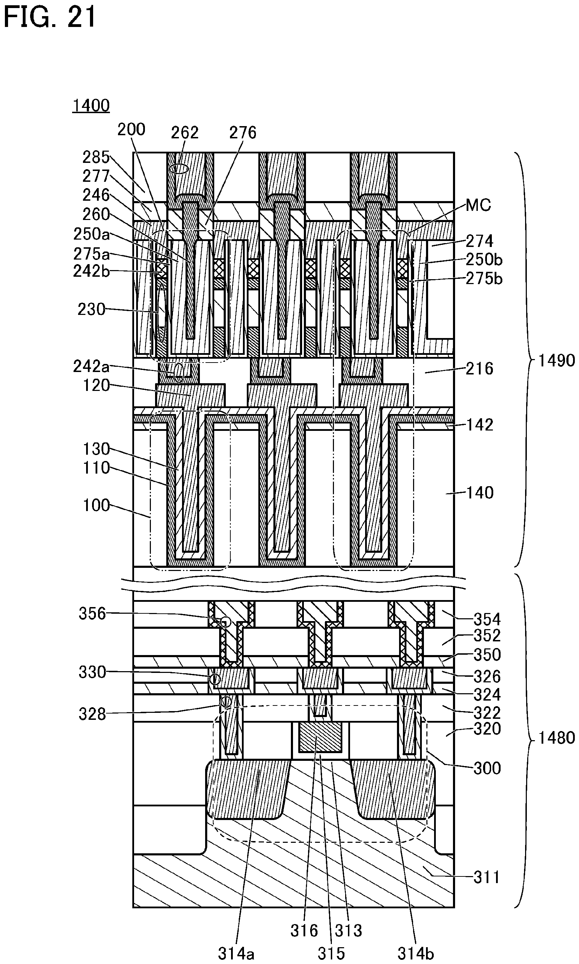

FIG. 21 illustrates a cross-sectional structure example of the storage device 1400 illustrated in FIG. 19A. In FIG. 21, part of the storage device 1400 illustrated in FIG. 19A is shown.

As illustrated in FIG. 21, the storage device 1400 includes the layer 1480 and the layer 1490 over the layer 1480. The peripheral circuit 1411 is provided in the layer 1480. In addition, the memory cell array 1470 is provided in the layer 1490.

FIG. 21 illustrates a transistor 300 included in the layer 1480. The transistor 300 functions as part of the above-described sense amplifier. In this case, the layer 1480 can be regarded as a substrate where a semiconductor circuit including a transistor is formed. That is, the layer 1480 corresponds to the substrate 101 described in Embodiment 3.

FIG. 21 illustrates part of the memory cell array 1470 provided in the layer 1490. Specifically, FIG. 21 illustrates three memory cells MC provided in the layer 1490. Note that the capacitor 100 included in the memory cell MC may be provided in the layer 1490 as illustrated in FIG. 21 or in the layer 1480.

The conductor 262 corresponds to the wiring WOL. The conductor 246 corresponds to the wiring BIL. The conductor 110 corresponds to the wiring LL. The conductor 110 also functions as the lower electrode of the capacitor 100.

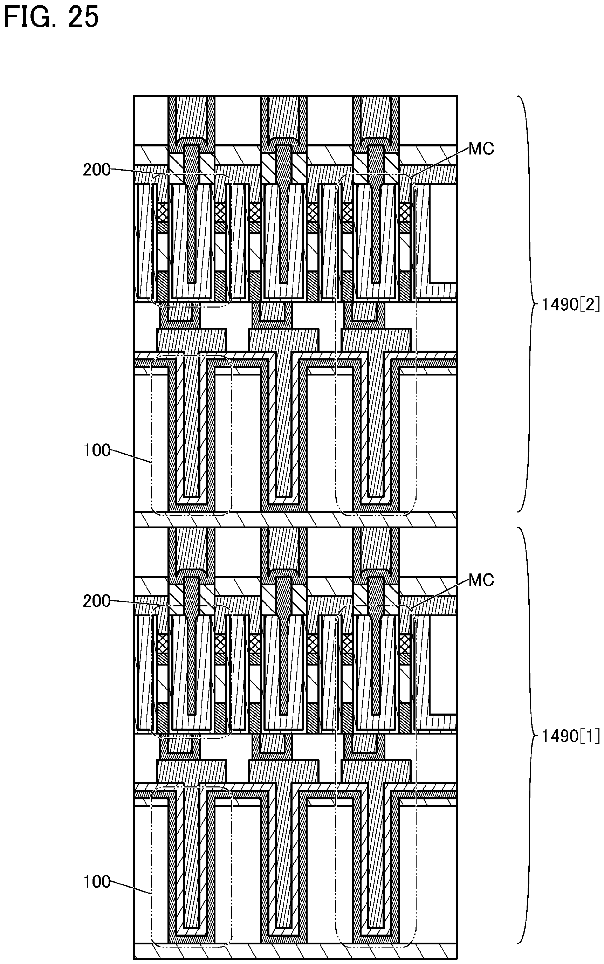

In the storage device 1400 illustrated in FIG. 21, one layer of the layer 1490 is provided. As described above, a plurality of memory cell arrays 1470 can be stacked. FIG. 25 illustrates an example of a storage device having a structure in which a plurality of memory cell arrays 1470 are stacked.

In the storage device 1400 illustrated in FIG. 25, n layers 1490 (a layer 1490[1] to a layer 1490[n]) are provided. Note that in FIG. 25, the layer 1490[1] and a layer 1490[2] are illustrated, but a layer 1490[3] to the layer 1490[n] and the layer 1480 are not illustrated.

Each of the layer 1490[1] to the layer 1490[n] includes the plurality of memory cells MC. The plurality of memory cells MC each include the transistor 200 and the capacitor 100. The memory cell array 1470 is formed in each of the layer 1490[1] to the layer 1490[n].

The layer 1490[1] to the layer 1490[n] are arranged in a direction perpendicular to the substrate surface, whereby the memory density of the memory cells can be increased. The layer 1490 can be formed by repeating the same formation process in the perpendicular direction. The formation cost of the memory cell array 1470 of the storage device 1400 illustrated in FIG. 25 can be reduced.

### <Transistor 300>

The transistor 300 is provided on a substrate 311 and includes a conductor 316 functioning as a gate, an insulator 315 functioning as a gate insulator, a semiconductor region 313 formed of part of the substrate 311, and a low-resistance region 314a and a low-resistance region 314b functioning as a source region and a drain region. The transistor 300 may be a p-channel transistor or an n-channel transistor.

Here, in the transistor 300 illustrated in FIG. 21, the semiconductor region 313 (part of the substrate 311) in which the channel is formed has a protruding shape. In addition, the conductor 316 is provided to cover the side surface and the top surface of the semiconductor region 313 with the insulator 315 therebetween. Note that a material adjusting the work function may be used for the conductor 316. Such a transistor 300 is also referred to as a FIN-type transistor because it utilizes a protruding portion of a semiconductor substrate. Note that an insulator functioning as a mask for forming the protruding portion may be included in contact with an upper portion of the protruding portion. Furthermore, although the case where the protruding portion is formed by processing part of the semiconductor substrate is described here, a semiconductor film having a protruding shape may be formed by processing an SOI substrate.

Note that the transistor 300 illustrated in FIG. 21 is an example and the structure is not limited thereto; an appropriate transistor is used in accordance with a circuit structure or a driving method.

### <Wiring layer>

Wiring layers provided with an interlayer film, a wiring, a plug, and the like may be provided between the components. A plurality of wiring layers can be provided in accordance with design. Here, a plurality of conductors functioning as plugs or wirings are collectively denoted by the same reference numeral in some cases. Furthermore, in this specification and the like, a wiring and a plug electrically connected to the wiring may be a single component. That is, there are cases where part of a conductor functions as a wiring and part of a conductor functions as a plug.

For example, an insulator 320, an insulator 322, an insulator 324, and an insulator 326 are sequentially stacked over the transistor 300 as interlayer films. A conductor 328, a conductor 330, and the like that are electrically connected to the capacitor 100 or the transistor 200 are embedded in the insulator 320, the insulator 322, the insulator 324, and the insulator 326. Note that the conductor 328 and the conductor 330 function as a plug or a wiring.

The insulators functioning as interlayer films may also function as planarization films that cover uneven shapes therebelow. For example, the top surface of the insulator 322 may be planarized by planarization treatment using a chemical mechanical polishing (CMP) method or the like to improve planarity.

A wiring layer may be provided over the insulator 326 and the conductor 330. For example, in FIG. 21, an insulator 350, an insulator 352, and an insulator 354 are stacked in this order. Furthermore, the conductor 356 is formed in the insulator 350, the insulator 352, and the insulator 354. The conductor 356 functions as a plug or a wiring.

Examples of an insulator that can be used as an interlayer film include an insulating oxide, an insulating nitride, an insulating oxynitride, an insulating nitride oxide, an insulating metal oxide, an insulating metal oxynitride, and an insulating metal nitride oxide.

For example, when a material having a low dielectric constant is used for the insulator functioning as an interlayer film, parasitic capacitance generated between wirings can be reduced. Thus, a material is preferably selected depending on the function of an insulator.

For example, as the insulator 322, the insulator 352, the insulator 354, and the like, an insulator having a low dielectric constant is preferably used. For example, the insulator preferably includes silicon oxide to which fluorine is added, silicon oxide to which carbon is added, silicon oxide to which carbon and nitrogen are added, porous silicon oxide, a resin, or the like. Alternatively, the insulator preferably has a stacked-layer structure of a resin and silicon oxide, silicon oxynitride, silicon nitride oxide, silicon nitride, silicon oxide to which fluorine is added, silicon oxide to which carbon is added, silicon oxide to which carbon and nitrogen are added, or porous silicon oxide. When silicon oxide or silicon oxynitride, which is thermally stable, is combined with a resin, the stacked-layer structure can have thermal stability and a low dielectric constant. Examples of the resin include polyester, polyolefin, polyamide (e.g., nylon and aramid), polyimide, polycarbonate, and acrylic.

When a transistor including an oxide semiconductor is surrounded by an insulator having a function of inhibiting passage of oxygen and impurities such as hydrogen, the electrical characteristics of the transistor can be stable. Thus, the insulator having a function of inhibiting the passage of oxygen and impurities such as hydrogen is used for the insulator 350 and the like.

As the insulator having a function of inhibiting passage of oxygen and impurities such as hydrogen, a single layer or stacked layers of an insulator containing, for example, boron, carbon, nitrogen, oxygen, fluorine, magnesium, aluminum, silicon, phosphorus, chlorine, argon, gallium, germanium, yttrium, zirconium, lanthanum, neodymium, hafnium, or tantalum may be used. Specifically, as the insulator having a function of inhibiting passage of oxygen and impurities such as hydrogen, a metal oxide such as aluminum oxide, magnesium oxide, gallium oxide, germanium oxide, yttrium oxide, zirconium oxide, lanthanum oxide, neodymium oxide, hafnium oxide, or tantalum oxide; silicon nitride oxide; silicon nitride; or the like can be used.

As the conductor that can be used for a wiring or a plug, a material containing one or more kinds of metal elements selected from aluminum, chromium, copper, silver, gold, platinum, tantalum, nickel, titanium, molybdenum, tungsten, hafnium, vanadium, niobium, manganese, magnesium, zirconium, beryllium, indium, ruthenium, and the like can be used. Alternatively, a semiconductor having high electrical conductivity, typified by polycrystalline silicon containing an impurity element such as phosphorus, or silicide such as nickel silicide may be used.

For example, for the conductor 328, the conductor 330, the conductor 356, and the like, a single-layer structure or a stacked-layer structure using a conductive material such as a metal material, an alloy material, a metal nitride material, or a metal oxide material that is formed using the above materials can be used. It is preferable to use a high-melting-point material that has both heat resistance and conductivity, such as tungsten or molybdenum, and it is preferable to use tungsten. Alternatively, it is preferable to use a low-resistance conductive material such as aluminum or copper. The use of a low-resistance conductive material can reduce wiring resistance.

This embodiment can be combined with the other embodiments as appropriate. In this specification, in the case where a plurality of structure examples are described in one embodiment, the structure examples can be combined as appropriate.

### (Embodiment 5)

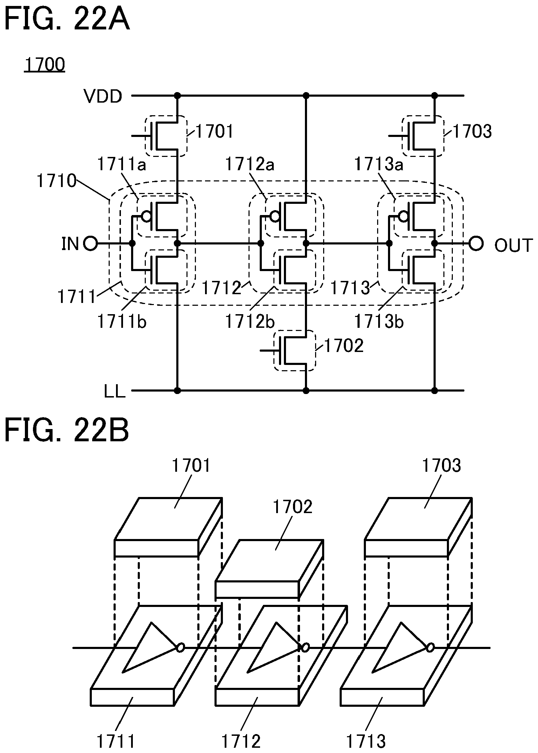

In this embodiment, a semiconductor device including an OS transistor of one embodiment of the present invention will be described with reference to FIG. 22A and FIG. 22B. The semiconductor device includes an OS transistor between a logic circuit and a power supply line. An OS transistor has an extremely low off-state current, and thus enables lower power consumption of the semiconductor device.

Examples of the logic circuit include a combination circuit such as an OR circuit, an AND circuit, a NAND circuit, and a NOR circuit; a sequential circuit such as a flip-flop circuit, a latch circuit, a counter circuit, a register circuit, and a shift register circuit; and a buffer circuit.

The buffer circuit is a circuit in which logic is fixed in a standby state (also referred to as a non-operating state or a non-selected state). Thus, in the case where a buffer circuit is used as a logic circuit included in the semiconductor device, the power consumption of the semiconductor device can be further reduced. Hereinafter, with use of a buffer circuit as a logic circuit, an example of the semiconductor device of one embodiment of the present invention is described. Note that the logic circuit included in the semiconductor device is not limited to a buffer circuit and any of the above-described logic circuits may be used.

FIG. 22A illustrates an example of a structure of a semiconductor device in which OS transistors are provided between a buffer circuit and a power supply line.

A semiconductor device 1700 illustrated in FIG. 22A includes a transistor 1701 to a transistor 1703, a buffer circuit 1710, a wiring VDD, a wiring LL, an input terminal IN, and an output terminal OUT.

In the semiconductor device 1700, the number of transistors electrically connected to the buffer circuit 1710 is the same as the number of inverter circuits included in the buffer circuit 1710. Since the buffer circuit 1710 illustrated in FIG. 22A is composed of three inverter circuits (an inverter circuit 1711 to an inverter circuit 1713), the semiconductor device 1700 illustrated in FIG. 22A includes three transistors (the transistor 1701 to the transistor 1703). Note that the number of inverter circuits included in the buffer circuit 1710 may be one, two, or four or more. In that case, the number of transistors electrically connected to the buffer circuit 1710 may be set as appropriate.

The inverter circuit 1711 to the inverter circuit 1713 illustrated in FIG. 22A are formed using CMOS. The inverter circuit 1711 to the inverter circuit 1713 can also be referred to as CMOS inverter circuits.

The inverter circuit 1711 includes a transistor 1711a and a transistor 1711b. The inverter circuit 1712 includes a transistor 1712a and a transistor 1712b. The inverter circuit 1713 includes a transistor 1713a and a transistor 1713b. Note that the transistor 1711a, the transistor 1712a, and the transistor 1713a are each a p-channel transistor. The transistor 1711b, the transistor 1712b, and the transistor 1713b are each an n-channel transistor.

A gate of the transistor 1711a is electrically connected to a gate of the transistor 1711b and the input terminal IN. One of a source and a drain of the transistor 1711a is electrically connected to one of a source and a drain of the transistor 1711b, a gate of the transistor 1712a, and a gate of the transistor 1712b. The other of the source and the drain of the transistor 1711a is electrically connected to one of a source and a drain of the transistor 1701.

The other of the source and the drain of the transistor 1711b is electrically connected to the wiring LL.

One of a source and a drain of the transistor 1712a is electrically connected to one of a source and a drain of the transistor 1712b, a gate of the transistor 1713a, and a gate of the transistor 1713b. The other of the source and the drain of the transistor 1712a is electrically connected to the wiring VDD.

The other of the source and the drain of the transistor 1712b is electrically connected to one of a source and a drain of the transistor 1702.

One of a source and a drain of the transistor 1713a is electrically connected to one of a source and a drain of the transistor 1712b and the output terminal OUT. The other of the source and the drain of the transistor 1713b is electrically connected to one of the source and the drain of the transistor 1703.

The other of the source and the drain of the transistor 1713b is electrically connected to the wiring LL.

The other of the source and the drain of the transistor 1701 and the other of the source and the drain of the transistor 1703 are each electrically connected to the wiring VDD. The other of the source and the drain of the transistor 1702 is electrically connected to the wiring LL.

A potential H is supplied to the wiring VDD. In addition, a potential L is supplied to the wiring LL. The potential H is preferably higher than the potential L. Note that in this specification and the like, the "potential H" is a potential that turns on an n-channel transistor when applied to a gate of the transistor and turns off a p-channel transistor when applied to a gate of the transistor. Furthermore, the "potential L" is a potential that turns off an n-channel transistor when applied to a gate of the transistor and turns on a p-channel transistor when applied to a gate of the transistor.

As each of the transistor 1701 to the transistor 1703, a transistor having a lower off-state current than the transistor included in the buffer circuit 1710 is used. With such a structure, the leakage current of the transistor 1711a, the transistor 1712b, and the transistor 1713a can be inhibited when the input terminal IN is at the potential H and a potential enabling the transistor 1701 to the transistor 1703 to be turned off is supplied to each gate of the transistor 1701 to the transistor 1703. Accordingly, power consumption of the semiconductor device 1700 in a non-operating state can be reduced.

When Si transistors are used as the transistors included in the buffer circuit 1710, OS transistors are preferably used as the transistor 1701 to the transistor 1703 because the OS transistor has extremely low off-state current. Note that as the OS transistor, the transistor 20 described in Embodiment 1 or the transistor 200 described in Embodiment 2 can be used.

To the semiconductor device 1700 including a Si transistor and an OS transistor, the BEOL-Tr technology can be applied.

FIG. 22B is a perspective view of the semiconductor device 1700. When Si transistors are used as transistors included in the buffer circuit and OS transistors are used as the transistor 1701 to the transistor 1703, the transistor 1701 can be formed above the inverter circuit 1711. Similarly, the transistor 1702 can be formed above the inverter circuit 1712. Similarly, the transistor 1703 can be formed above the inverter circuit 1713.

That is, the semiconductor device 1700 can have a structure in which a layer including the buffer circuit and a layer including the transistor 1701 to the transistor 1703 are stacked. Such a structure enables the area occupied by the semiconductor device 1700 to be small.

In the above structure, the layer including the buffer circuit can be regarded as a layer including a Si transistor. The layer including the transistor 1701 to the transistor 1703 can be regarded as a layer including an OS transistor.

Note that the semiconductor device 1700 may be used for the storage device 1400 described in Embodiment 4. For example, the structure of the semiconductor device 1700 may be employed for logic circuits included in the peripheral circuit included in the storage device 1400. In other words, a transistor provided between a logic circuit and a power supply line is provided in the layer 1490 described in Embodiment 4. Thus, a miniaturized storage device with low power consumption can be provided.

This embodiment can be combined with the other embodiments as appropriate. In this specification, in the case where a plurality of structure examples are described in one embodiment, the structure examples can be combined as appropriate.

### (Embodiment 6)

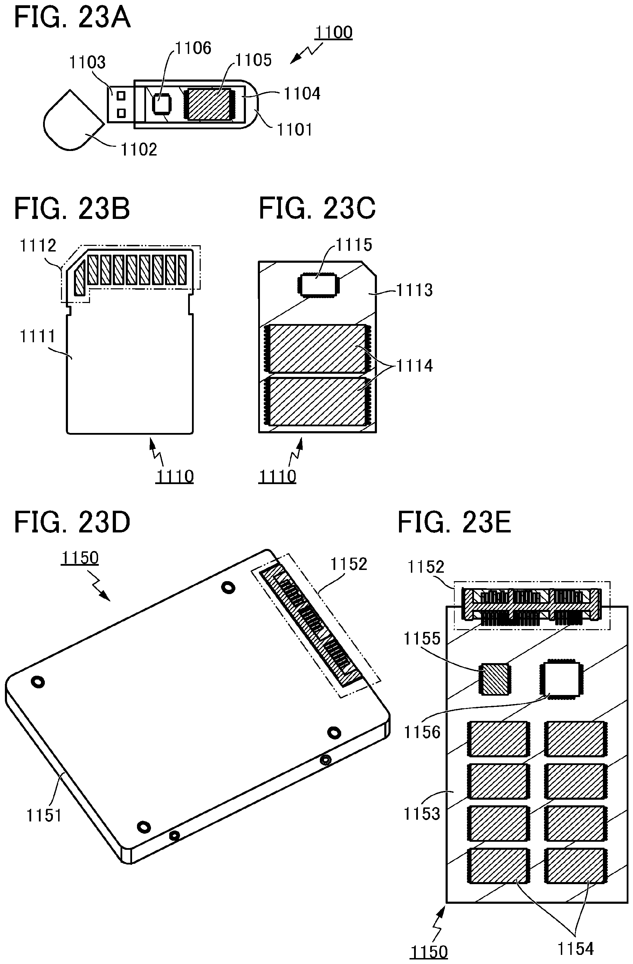

In this embodiment, application examples of the semiconductor device using the storage device described in the above embodiment will be described. The storage device described in the above embodiment can be applied to, for example, a variety of removable storage devices such as memory cards (e.g., SD cards), USB memories, and SSDs (solid state drives). FIG. 23A to FIG. 23E schematically illustrate some structure examples of removable storage devices. The semiconductor device described in the above embodiment is processed into a packaged memory chip and used in a variety of storage devices and removable memories, for example.

FIG. 23A is a schematic view of a USB memory. A USB memory 1100 includes a housing 1101, a cap 1102, a USB connector 1103, and a substrate 1104. The substrate 1104 is held in the housing 1101. The substrate 1104 is provided with a memory chip 1105 and a controller chip 1106, for example. The storage device or the semiconductor device described in the above embodiment can be incorporated in the memory chip 1105 or the like.

FIG. 23B is a schematic external view of an SD card, and FIG. 23C is a schematic view of the internal structure of the SD card. An SD card 1110 includes a housing 1111, a connector 1112, and a substrate 1113. The substrate 1113 is held in the housing 1111. The substrate 1113 is provided with a memory chip 1114 and a controller chip 1115, for example. When the memory chip 1114 is also provided on the back side of the substrate 1113, the capacity of the SD card 1110 can be increased. In addition, a wireless chip with a radio communication function may be provided on the substrate 1113. This enables data reading and writing of the memory chip 1114 by wireless communication between a host device and the SD card 1110. The storage device or the semiconductor device described in the above embodiment can be incorporated in the memory chip 1114 or the like.

FIG. 23D is a schematic external view of an SSD, and FIG. 23E is a schematic view of the internal structure of the SSD. An SSD 1150 includes a housing 1151, a connector 1152, and a substrate 1153. The substrate 1153 is held in the housing 1151. The substrate 1153 is provided with a memory chip 1154, a memory chip 1155, and a controller chip 1156, for example. The memory chip 1155 is a work memory of the controller chip 1156, and a DOSRAM chip can be used, for example. When the memory chip 1154 is also provided on the back side of the substrate 1153, the capacity of the SSD 1150 can be increased. The storage device or the semiconductor device described in the above embodiment can be incorporated in the memory chip 1154 or the like.

This embodiment can be implemented in an appropriate combination with the structures described in the other embodiments and the like.

### (Embodiment 7)

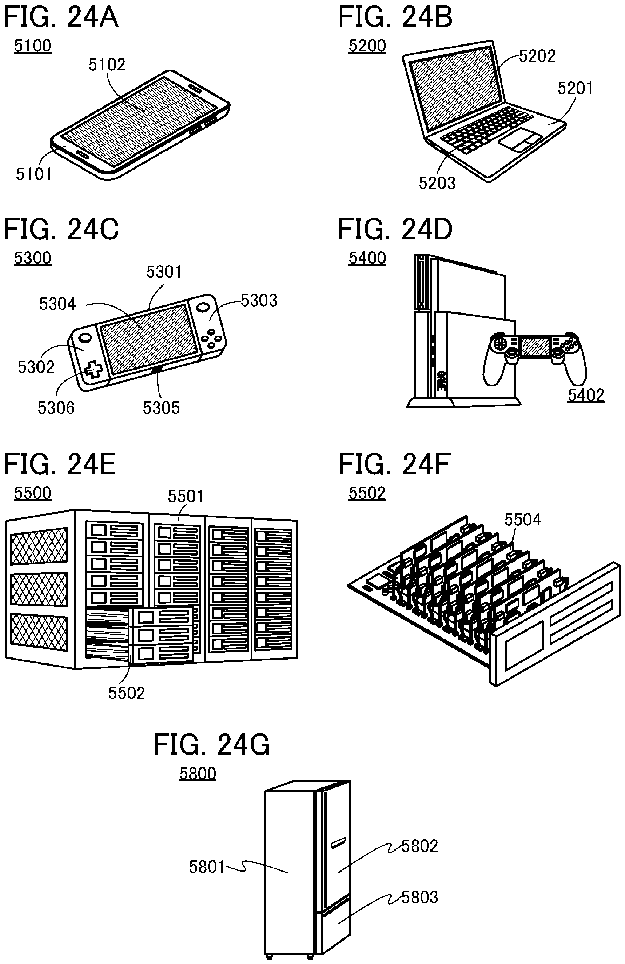

FIG. 24A to FIG. 24G illustrate specific examples of electronic devices each provided with the storage device or the semiconductor device of one embodiment of the present invention.

### <Electronic device and system>

The storage device or the semiconductor device of one embodiment of the present invention can be mounted on a variety of electronic devices. Examples of electronic devices include an information terminal, a computer, a smartphone, an e-book reader, a television device, digital signage, a large game machine such as a pachinko machine, a digital camera, a digital video camera, a digital photo frame, a mobile phone, a portable game machine, a video recording/reproducing device, a navigation system, and an audio reproducing device. Here, the computers refer not only to tablet computers, notebook computers, and desktop computers, but also to large computers such as server systems.

The electronic device of one embodiment of the present invention may include an antenna. With the antenna receiving a signal, the electronic device can display images, information, and the like on a display portion. When the electronic device includes the antenna and a secondary battery, the antenna may be used for contactless power transmission.

The electronic device of one embodiment of the present invention may include a sensor (a sensor having a function of measuring force, displacement, position, speed, acceleration, angular velocity, rotational frequency, distance, light, liquid, magnetism, temperature, a chemical substance, sound, time, hardness, an electric field, current, voltage, power, radioactive rays, flow rate, humidity, a gradient, oscillation, odor, or infrared rays).

The electronic device of one embodiment of the present invention can have a variety of functions. For example, the electronic device can have a function of displaying a variety of information (a still image, a moving image, a text image, and the like) on the display portion, a touch panel function, a function of displaying a calendar, date, time, and the like, a function of executing a variety of software (programs), a wireless communication function, and a function of reading out a program or data stored in a recording medium.

### [Information terminal]

With the storage device or the semiconductor device of one embodiment of the present invention, a storage device for storing a microcontroller program can be configured. Thus, according to one embodiment of the present invention, a microcontroller chip can be downsized.

FIG. 24A illustrates a mobile phone (smartphone), which is a type of information terminal. An information terminal 5100 includes a housing 5101 and a display portion 5102. As input interfaces, a touch panel is provided in the display portion 5102 and a button is provided in the housing 5101. The use of a downsized microcontroller of one embodiment of the present invention allows effective use of a limited space in the mobile phone. The storage device of one embodiment of the present invention may be used for storage of the mobile phone. This results in an increase in the storage capacity per unit area of the storage.

FIG. 24B illustrates a notebook information terminal 5200. The notebook information terminal 5200 includes a main body 5201 of the information terminal, a display portion 5202, and a keyboard 5203. The use of a downsized microcontroller of one embodiment of the present invention allows effective use of a limited space in the notebook information terminal. The storage device of one embodiment of the present invention may be used for storage of the notebook information terminal. This results in an increase in the storage capacity per unit area of the storage.

Note that although FIG. 24A and FIG. 24B illustrate a smartphone and a notebook information terminal, respectively, as examples of the electronic device in the above description, an information terminal other than a smartphone and a notebook information terminal can be used. Examples of information terminals other than a smartphone and a notebook information terminal include a PDA (Personal Digital Assistant), a desktop information terminal, and a workstation.

### [Game machine]

FIG. 24C illustrates a portable game machine 5300 as an example of a game machine. The portable game machine 5300 includes a housing 5301, a housing 5302, a housing 5303, a display portion 5304, a connection portion 5305, an operation key 5306, and the like. The housing 5302 and the housing 5303 can be detached from the housing 5301. When the connection portion 5305 provided in the housing 5301 is attached to another housing (not illustrated), an image to be output to the display portion 5304 can be output to another video device (not illustrated). In this case, the housing 5302 and the housing 5303 can each function as an operating unit. Thus, a plurality of players can play a game at the same time. The storage device, the semiconductor device, or the like of one embodiment of the present invention can be incorporated into a chip provided on a substrate in the housing 5301, the housing 5302, and the housing 5303, for example.

FIG. 24D illustrates a stationary game machine 5400 as an example of a game machine. A controller 5402 is wired or connected wirelessly to the stationary game machine 5400.

The use of a downsized microcontroller of one embodiment of the present invention for the game machine such as the portable game machine 5300 or the stationary game machine 5400 allows effective use of a limited space in the game machine. The storage device, the semiconductor device, or the like of one embodiment of the present invention may be used for storage of the portable game machine. This results in an increase in the storage capacity per unit area of the storage.

Although the portable game machine and the stationary game machine are illustrated as examples of game machines in FIG. 24C and FIG. 24D, the game machine using the microcontroller of one embodiment of the present invention is not limited thereto. Examples of game machines using the microcontroller of one embodiment of the present invention include an arcade game machine installed in entertainment facilities (a game center, an amusement park, or the like) and a throwing machine for batting practice installed in sports facilities.

### [Large computer]

The storage device, the semiconductor device, or the like of one embodiment of the present invention can be used in a large computer.

FIG. 24E illustrates a supercomputer 5500 as an example of a large computer. FIG. 24F illustrates a rack-mount computer 5502 included in the supercomputer 5500.

The supercomputer 5500 includes a rack 5501 and a plurality of rack-mount computers 5502. The plurality of computers 5502 are stored in the rack 5501. The computers 5502 are provided with a plurality of substrates 5504, and microcontrollers of one embodiment of the present invention can be mounted on the substrates. The use of a downsized microcontroller of one embodiment of the present invention allows effective use of a limited space in the large computer. The storage device, the semiconductor device, or the like of one embodiment of the present invention may be used for storage of the large computer. This results in an increase in the storage capacity per unit area of the storage.

Although the supercomputer is illustrated as an example of a large computer in FIG. 24E and FIG. 24F, a large computer using the microcontroller of one embodiment of the present invention is not limited thereto. Examples of a large computer using the microcontroller of one embodiment of the present invention include a computer that provides service (a server) and a large general-purpose computer (a mainframe).

### [Household appliance]

FIG. 24G illustrates an electric refrigerator-freezer 5800 as an example of a household appliance. The electric refrigerator-freezer 5800 includes a housing 5801, a refrigerator door 5802, a freezer door 5803, and the like.

The storage device, the semiconductor device, or the like of one embodiment of the present invention can also be used for the electric refrigerator-freezer 5800. For example, the use of a downsized microcontroller of one embodiment of the present invention for the electric refrigerator-freezer 5800 allows effective use of a limited space in the electric refrigerator-freezer.

Although the electric refrigerator-freezer is described as an example of a household appliance, examples of other household appliances include a vacuum cleaner, a microwave oven, an electric oven, a rice cooker, a water heater, an IH cooker, a water server, a heating-cooling combination appliance such as an air conditioner, a washing machine, a drying machine, and an audio visual appliance.

The electronic devices, the functions of the electronic devices, their effects, and the like described in this embodiment can be combined as appropriate with the description of another electronic device.

This embodiment can be implemented in an appropriate combination with the structures described in the other embodiments and the like.

### [Reference Numerals]

20A: transistor, 20B: transistor, 20C: transistor, 20D: transistor, 20E: transistor, 20: transistor, 30a: oxide, 30b: oxide, 30c: oxide, 30i: region, 30: oxide, 42a: conductor, 42b: conductor, 42: conductor, 46: conductor, 46a: projecting portion, 50: insulator, 60: conductor, 62: conductor, 64a: region, 64b: region, 100A: capacitor, 100B: capacitor, 100C: capacitor, 100D: capacitor, 100: capacitor, 101: substrate, 110a: conductor, 110b: conductor, 110: conductor, 120a: conductor, 120b: conductor, 120: conductor, 130: insulator, 140: insulator, 141a: insulator, 141b: insulator, 141: insulator, 142: insulator, 200A: transistor, 200B: transistor, 200C: transistor, 200: transistor, 212: insulator, 216: insulator, 230a: oxide, 230A: oxide film, 230b: oxide, 230B: oxide film, 230bc: region, 230c: oxide, 230C: oxide film, 230: oxide, 242a: conductor, 242b: conductor, 242B: conductive film, 246: conductor, 247: insulator, 250a: insulator, 250A: insulating film, 250b: insulator, 254a: insulator, 254b: insulator, 260A: conductive film, 260: conductor, 261A: conductive film, 262a: conductor, 262b: conductor, 262: conductor, 274A: insulating film, 274c: insulator, 274: insulator, 275a: insulator, 275A: insulating film, 275b: insulator, 276A: insulating film, 276: insulator, 277: insulator, 278: insulator, 285: insulator, 291A: insulating film, 291: insulator, 292: resist mask, 293A: insulating film, 293: insulator, 300: transistor, 311: substrate, 313: semiconductor region, 314a: low-resistance region, 314b: low-resistance region, 315: insulator, 316: conductor, 320: insulator, 322: insulator, 324: insulator, 326: insulator, 328: conductor, 330: conductor, 350: insulator, 352: insulator, 354: insulator, 356: conductor, 400: storage device, 1100: USB memory, 1101: housing, 1102: cap, 1103: USB connector, 1104: substrate, 1105: memory chip, 1106: controller chip, 1110: SD card, 1111: housing, 1112: connector, 1113: substrate, 1114: memory chip, 1115: controller chip, 1150: SSD, 1151: housing, 1152: connector, 1153: substrate, 1154: memory chip, 1155: memory chip, 1156: controller chip, 1400: storage device, 1411: peripheral circuit, 1420: row circuit, 1430: column circuit, 1440: output circuit, 1460: control logic circuit, 1470: memory cell array, 1473: memory cell, 1480: layer, 1490: layer, 1700: semiconductor device, 1701: transistor, 1702: transistor, 1703: transistor, 1710: buffer circuit, 1711a: transistor, 1711b: transistor, 1711: inverter circuit, 1712a: transistor, 1712b: transistor, 1712: inverter circuit, 1713a: transistor, 1713b: transistor, 1713: inverter circuit, 5100: information terminal, 5101: housing, 5102: display portion, 5200: notebook information terminal, 5201: main body, 5202: display portion, 5203: keyboard, 5300: game machine, 5301: housing, 5302: housing, 5303: housing, 5304: display portion, 5305: connection portion, 5306: operation key, 5400: stationary game machine, 5402: controller, 5500: supercomputer, 5501: rack, 5502: computer, 5504: substrate, 5800: electric refrigerator-freezer, 5801: housing, 5802: refrigerator door, 5803: freezer door

## Claims

1. A semiconductor device comprising:
a first conductor;
a metal oxide over the first conductor;
a second conductor over the metal oxide;
a first insulator;
a second insulator over the first insulator; and
a third conductor over the second insulator,
wherein the first conductor comprises a region overlapping with the metal oxide,
wherein the metal oxide comprises a first opening;
wherein the second conductor comprises a second opening;
wherein the first opening and the second opening overlap with each other,
wherein the first insulator is placed on an inner side of each of the first opening and the second opening,
wherein the second insulator is placed in a depressed portion of the first insulator, and
wherein the third conductor is placed in a depressed portion of the second insulator.

2. The semiconductor device according to claim 1,
wherein the metal oxide and the second conductor each have a hollow cylindrical shape.

3. The semiconductor device according to claim 2,
wherein a center of the first conductor is not aligned with a center of the hollow cylindrical shape of the metal oxide in a top view.

4. The semiconductor device according to any one of claim 1 to claim 3,
wherein a side surface on the first opening side and a side surface on the second opening side each have a tapered shape in a cross-sectional view.

5. The semiconductor device according to any one of claim 1 to claim 4,
wherein an uppermost portion of the second insulator is level or substantially level with an uppermost portion of the first insulator.

6. The semiconductor device according to any one of claim 1 to claim 5,
wherein the first insulator comprises a region having a smaller thickness than the second insulator.

7. A storage device comprising the semiconductor device according to any one of claim 1 to claim 6, and a capacitor,
wherein the semiconductor device is provided above the capacitor.

8. A semiconductor device comprising:
a first insulator;
a first conductor placed to be embedded in the first insulator;
a metal oxide over the first conductor;
a second conductor over the metal oxide;
a third conductor over the second conductor;
a second insulator;
a third insulator over the second insulator;
a fourth conductor over the third insulator; and
a fifth conductor over the fourth conductor,
wherein the first conductor comprises a region overlapping with the metal oxide,
wherein the metal oxide comprises a first opening;
wherein the second conductor comprises a second opening;
wherein the first opening and the second opening overlap with each other,
wherein the second insulator is placed on an inner side of each of the first opening and the second opening,
wherein the third insulator is placed in a depressed portion of the second insulator,
wherein the fourth conductor is placed in a depressed portion of the third insulator,
wherein the third conductor is placed to be in contact with at least part of a top surface of the second conductor,
wherein the fifth conductor is placed to be in contact with a top surface of the fourth conductor, and
wherein the third conductor and the fifth conductor do not overlap with each other in a top view.

9. The semiconductor device according to claim 8,
wherein a fourth insulator is between the second insulator and the third insulator and the fifth conductor,
wherein the fourth insulator comprises a region in contact with a bottom surface of the fifth conductor, and
wherein a top surface of the third conductor is between a bottom surface and a top surface of the fourth insulator.

10. The semiconductor device according to claim 8 or claim 9,
wherein the metal oxide and the second conductor each have a hollow cylindrical shape.

11. The semiconductor device according to claim 10,
wherein a center of the first conductor is not aligned with a center of the hollow cylindrical shape of the metal oxide in a top view.

12. The semiconductor device according to any one of claim 8 to claim 11,
wherein a side surface on the first opening side and a side surface on the second opening side each have a tapered shape in a cross-sectional view.

13. The semiconductor device according to any one of claim 8 to claim 12,
wherein an uppermost portion of the third insulator is level or substantially level with an uppermost portion of the second insulator.

14. The semiconductor device according to any one of claim 8 to claim 13,
wherein the second insulator comprises a region having a smaller thickness than the third insulator.

15. The semiconductor device according to any one of claim 8 to claim 14,
wherein a direction in which the fifth conductor extends is orthogonal to a direction in which the third conductor extends.

16. A storage device comprising the semiconductor device according to any one of claim 8 to claim 15, and a capacitor,
wherein the semiconductor device is provided above the capacitor.
